# EUROPÄISCHE PATENTSCHRIFT

(11) **EP 3 422 396 B1**
(45) Veröffentlichungstag und Bekanntmachung des Hinweises auf die Patenterteilung: **04.08.2021**
(21) Anmeldenummer: 17178276.6
(22) Anmeldetag: 28.06.2017
(51) Int. Cl.: H01L 21/673, H01L 21/687, H01L 21/67, C23C 16/509, C23C 16/458, H01J 37/32, H01L 21/677, C23C 16/455

(54) **VORRICHTUNG ZUM TRANSPORT EINES SUBSTRATS, BEHANDLUNGSVORRICHTUNG MIT EINER AN EINEN SUBSTRATTRÄGER EINER SOLCHEN VORRICHTUNG ANGEPASSTEN AUFNAHMEPLATTE UND VERFAHREN ZUM PROZESSIEREN EINES SUBSTRATES UNTER NUTZUNG EINER SOLCHEN VORRICHTUNG ZUM TRANSPORT EINES SUBSTRATS SOWIE BEHANDLUNGSANLAGE**
DEVICE FOR TRANSPORT OF A SUBSTRATE, TREATMENT DEVICE WITH A HOLDER PLATE ADAPTED TO A SUBSTRATE HOLDER OF SUCH A DEVICE AND A METHOD FOR PROCESSING A SUBSTRATE USING SUCH A DEVICE FOR TRANSPORTING A SUBSTRATE AND TREATMENT PLANT
PROCÉDÉ DE TRANSPORT D'UN SUBSTRAT, DISPOSITIF DE TRAITEMENT COMPRENANT UNE PLAQUE DE RÉCEPTION ADAPTÉE À UN SUPPORT DE SUBSTRAT D'UN TEL DISPOSITIF ET PROCÉDÉ DE TRAITEMENT D'UN SUBSTRAT À L AIDE D'UN TEL DISPOSITIF DE TRANSPORT D'UN SUBSTRAT ET INSTALLATION DE TRAITEMENT

(43) Veröffentlichungstag der Anmeldung: 02.01.2019
(73) Patentinhaber: Meyer Burger (Germany) GmbH, 09337 Hohenstein-Ernstthal (DE)
(72) Erfinder: Schlemm, Hermann, 07751 Milda (DE); Kehr, Mirko, 09439 Amtsberg (DE); Ansorge, Erik, 09127 Chemnitz (DE); Raschke, Sebastian, 09380 Thalheim (DE)
(74) Vertreter: Kailuweit & Uhlemann Patentanwälte Partnerschaft mbB

(56) Entgegenhaltungen:
- EP-A1- 2 915 901
- JP-A- H11 163 102
- JP-A- 2005 223 142
- US-A- 5 718 574
- US-A- 5 893 760
- US-A1- 2003 170 583
- US-A1- 2012 216 743
- US-B2- 6 799 940

## Beschreibung

Die Erfindung betrifft eine Vorrichtung zum Transport eines Substrates, mit der ein flächiges Substrat oder ein laterale Anordnung mehrerer flächiger Substrate in eine Behandlungsvorrichtung ein- bzw. ausgefahren werden kann und auf der das oder die Substrate während der Behandlung in horizontaler Position gelagert sind, und eine Behandlungsvorrichtung, die eine Aufnahmeplatte aufweist, welche geeignet ist, einen Substratträger der Vorrichtung zum Transport eines Substrates aufzunehmen und diesen sowie das oder die auf dem Substratträger angeordneten Substrate während einer Behandlung des Substrates zu haltern. Dabei ist die Aufnahmeplatte so ausgestaltet, dass die Aufnahmeplatte und der Substratträger während einer Behandlung des Substrats in der Behandlungsvorrichtung zusammenwirken. Weiterhin betrifft die Erfindung ein Verfahren zum Prozessieren eines oder mehrerer Substrate unter Nutzung eine solchen Vorrichtung zum Transport eines Substrates und eine entsprechende Behandlungsanlage.

In der Solarzellenherstellung, der Mikroelektronik oder bei der Veredlung von Substratoberflächen (z. B. Glas) werden verschiedene Prozesse zur Abscheidung oder Entfernung von Schichten oder Partikeln, zur Dotierung von Schichten oder zum Reinigen oder Aktivieren der Oberfläche eines Substrates genutzt. Im Folgenden werden alle diese Prozesse als Behandlung eines Substrats bezeichnet. Oftmals werden auch mehrere derartige Prozesse direkt nacheinander, mit oder ohne Unterbrechung des Vakuums ausgeführt, wobei meist jeweils eine separate Behandlungsvorrichtung für jeden der Prozesse genutzt wird. Die Gesamtheit aller für eine Behandlung eines Substrates notwendigen Schritte, wie beispielsweise das Einbringen eines Substrates in die Behandlungsvorrichtung, die eigentliche Behandlung des Substrates und das Ausführen des Substrates aus der Behandlungsvorrichtung sowie ggf. der Transfer des Substrates zwischen mehreren Behandlungsvorrichtungen, wird im Folgenden als Prozessieren eines Substrates bezeichnet.

Meist werden flächige Substrate behandelt, welche eine große Fläche in einer Ebene und eine demgegenüber nur geringe Dicke oder Höhe in einer Richtung senkrecht zu dieser Ebene aufweisen. So weisen beispielsweise Solarzellensubstrate eine Fläche von (156 x 156) mm² bei einer Substratdicke zwischen 140 µm und 200 µm auf.

Für eine Substratbehandlung, bei der nur eine der flächigen Oberflächen des Substrates behandelt wird, im Folgenden Substratoberseite genannt, wird ein Substrat oftmals mit der anderen der beiden flächigen Oberflächen, im Folgenden Substratrückseite genannt, horizontal auf eine Aufnahmeplatte innerhalb einer Behandlungsvorrichtung aufgelegt. Diese Aufnahmeplatte kann temperiert werden, um bspw. für eine Gasphasenabscheidung, insbesondere eine chemische Gasphasenabscheidung (CVD), optimale Bedingungen zu schaffen. Alternativ oder zusätzlich kann die Aufnahmeplatte mit einer elektrischen Spannung beaufschlagt werden, so dass die Aufnahmeplatte als eine Elektrode eines Plattenkondensators in einem Parallelplattenreaktor, zwischen dessen Elektroden ein Plasma erzeugt wird, dient. In beiden Fällen ist eine gleichmäßige, flächige Auflage der Substratrückseite auf der Aufnahmeplatte von besonderer Bedeutung für die Homogenität der Substratbehandlung.

In der US 5 893 760 A ist eine Aufnahmeplatte beschrieben, die eine horizontale Halterung eiens Substrates während einer Behandlung ermöglicht, wobei das Substrat nur durch sein Gewicht auf der Aufnahmeplatte gehalten wird. Dabei weist die Aufnahmeplatte im Zustand ohne aufliegendes Substrat eine nach oben gerichtete, konvexe Wölbung auf. Wird ein Substrat aufgelegt, so wird die Aufnahmeplatte durch das Gewicht des Substrates flach gedrückt, so dass das Substrat horizontal auf der Aufnahmeplatte aufliegend gehalten wird.

Zum Auflegen bzw. Aufnehmen des Substrates auf die bzw. von der Aufnahmeplatte sind verschiedene Verfahren und Vorrichtungen, im Folgenden Handlingsystem genannt, bekannt. Zum einen kann das Substrat von der Substratvorderseite her von einem Handlingsystem aufgenommen werden. Dazu wird oftmals der Bernoulli-Effekt genutzt, mit dem prinzipiell eine berührungslose Halterung des Substrates möglich ist. Auch magnetische Effekte können bei entsprechenden Substraten oder zusätzlichen Substrathalterungen genutzt werden. Jedoch weisen insbesondere Bernoulli-Greifer eine große Bauhöhe auf, die den Einsatz in Behandlungsvorrichtungen mit kleinem vertikalen Abstand der Aufnahmeplatte zu anderen, darüber angeordneten Bauteilen erschwert, oder sie führen bei einer großen Fläche des Substrats zu einer ungleichmäßigen Belastung des Substrats, was in einem Bruch des Substrats resultieren kann. Darüber hinaus weisen die meisten derartigen "berührungslosen" Greifer Kontaktelemente auf, die einen Abstand der Substratoberseite zu dem Greifer gewährleisten sollen und die Substratoberseite berühren. Dadurch sind Beschädigungen der Substratoberseite möglich. Derartige Greifer sind bspw. in der DE 10 2010 026 209 A1 beschrieben.

Eine andere Möglichkeit zum Auflegen bzw. Aufnehmen des Substrates besteht in der Nutzung eines Seitengreifers, der an mehreren Stellen am Rand des Substrates angreift. Solche Greifer sind bspw. in der EP 0 189 279 A2 und der DE 100 47 983 A1 beschrieben. Auch hier kann es, insbesondere bei großflächigen, dünnen Substraten, zu einem Bruch des Substrates kommen.

Weiterhin gibt es die Möglichkeit, das Substrat auf einem Substratträger, der das Substrat auf der Substratunterseite angreift, zu handeln, d.h. zu bewegen, auf- oder abzulegen bzw. zu transferieren. Derartige Substratträger weisen einen oder mehrere Tragarme, die gabelförmig angeordnet sind, auf, worauf das Substrat mit seiner Unterseite während des Handelns aufliegt. Um ein solches Substrat von einer Aufnahmeplatte aufzunehmen, oder es darauf abzulegen weist die Aufnahmeplatte bspw. Aussparungen auf, in die der eine oder die mehreren Tragarme eingeführt werden. Dies ist in der DE 32 14 256 C2 beschrieben. Eine andere Variante ist das Vorhandensein eines zusätzlichen Hebemechanismuses, der bspw. aus durch die Aufnahmeplatte hindurchgreifenden Stiften besteht. Dieser hebt das Substrat von dem oder den Tragarmen bzw. der Aufnahmeplatte ab und ermöglicht das Verfahren des oder der Tragarme unterhalb der Substratunterseite, so dass das Substrat von der Aufnahmeplatte abgehoben und auf dem oder den Tragarmen abgelegt oder von dem oder den Tragarmen abgehoben und auf der Aufnahmeplatte abgelegt werden kann. Solch ein Hebemechanismus ist bspw. in der EP 0 843 340 A2 beschrieben. In beiden Fällen befindet sich der Substratträger während der Substratbehandlung vollständig außerhalb der Behandlungsvorrichtung. Diese Systeme haben den Nachteil, dass die Aufnahmeplatte während der Behandlung des Substrates in einem Substratauflagebereich unterbrochen ist und damit bspw. eine Temperierung des Substrates oder eine Beaufschlagung der Aufnahmeplatte mit einer Spannung nicht gleichmäßig realisiert werden kann, was sich negativ auf die Homogenität der Substratbehandlung auswirkt.

Ein ähnliches System zur Ablage und Halterung von Substraten offenbart auch die JP 2005-223142 A. Dabei ist der Hebemechanismus, der einen Teil einer Aufnahmeplatte bildet, so ausgebildet, dass er das Substrat auf der Aufnahmeplatte positioniert und während der Behandlung des Substrates hält. Der Hebemechanismus weist eine sich horizontal erstreckende Haltefläche auf, die auf einer dem Substrat zugewandten ersten Oberfläche eben und gleichförmig ausgebildet ist, deren Form im Wesentlichen der Form des Substrates entspricht und deren Fläche im Wesentlichen gleich der Fläche des Substrates ist. Das Substrat wird nur durch die Gewichtskraft mit seiner Rückseite auf der Haltefläche des Hebemechanismuses gehalten.

Bei allen beschriebenen Verfahren und Handlingsystemen wird das Substrat auf der Aufnahmeplatte mit Hilfe des Handlingsystems abgelegt und nach der Behandlung wieder davon aufgenommen, während sich das Handlingsystem während der Substratbehandlung selbst außerhalb der Behandlungsvorrichtung befindet. Darüber hinaus ist es nicht möglich oder zumindest sehr schwierig zu gewährleisten, Substrate, die während der Behandlung gebrochen sind, vollständig von der Aufnahmeplatte zu entfernen. Da es bei dünnen Substraten und bei Substraten, die eine multikristalline Struktur aufweisen, relativ häufig zu einem derartigen Bruch kommt (zwischen einem und hundert Bruchwafern in einer Behandlungsvorrichtung pro Tag), ist dies ein großer Nachteil bekannter Handlingsysteme. Darüber hinaus weisen stationäre Handlingsysteme, wie bspw. ein zwischen einer Ladestation und einer Behandlungskammer angeordneter Roboterarm, nur eine begrenzte Reichweite der Substratbewegung, insbesondere eine begrenzte Anzahl der mit dem Handlingsystem erreichbaren Behandlungsvorrichtungen, auf.

Um den Durchsatz von Substraten bei einer Behandlung zu erhöhen, werden batch-Systeme, in denen mehrere Substrate gleichzeitig behandelt werden, verwendet. Dabei können die Substrate mit der zu prozessierenden Oberfläche neben- oder übereinander auf einer oder mehreren Aufnahmeplatten angeordnet sein. Beispielsweise können die Substrate auf in vertikaler Richtung übereinander angeordneten und jeweils waagerecht verlaufenden Aufnahmeplatten, die als Elektroden eines Parallelplattenreaktors dienen, angeordnet werden.

Dabei können die Substrate mit den oben beschriebenen Handlingsystemen einzeln nacheinander oder mit Hilfe mehrerer der oben beschriebenen Handlingsysteme gleichzeitig in die Behandlungsvorrichtung eingeführt und auf den jeweiligen Aufnahmeplatten abgelegt werden. Dies wird beispielsweise in der WO 2013/115957 A1 offenbart. Jedoch ergeben sich daraus mehrere Nachteile oder Herausforderungen. So benötigt bspw. das einzelne Be- oder Entladen der Substrate sehr viel Zeit, in der die Behandlungsvorrichtung nicht für eine Behandlung zur Verfügung steht, während kombinierte Handlingsysteme für eine große Anzahl von gleichzeitig zu transferierenden Substraten sehr aufwändig werden.

Daher werden die Substrate in batch-Systemen häufig außerhalb einer Behandlungskammer, in der die Behandlungsvorrichtung angeordnet ist und unter atmosphärischen Bedingungen, d.h. an Luft, in eine Substrathaltevorrichtung, bspw. ein Wafer- oder Prozessboot, geladen und mit dieser Substrathaltevorrichtung in die Behandlungskammer eingeführt. Dies wird insbesondere bei Plasmaprozessen, in denen jedes Substrat eine als Elektrode eines Parallelplattenreaktors wirkenden Aufnahmeplatte elektrisch kontaktiert, angewandt. Dazu wird ein großer Teil der Behandlungsvorrichtung, nämlich eine die Elektroden aufweisende Elektrodeneinheit, außerhalb der Behandlungskammer mit den Substraten bestückt und anschließend zur Substratbehandlung in die Behandlungskammer eingeführt. Dies ist bspw. in der der DE 10 2008 019 023 A1 und der DE 10 2010 026 209 A1 beschrieben.

Nachteilig an dieser Art von batch-Systemen ist, dass die Substrathaltevorrichtung im Ganzen aufgeheizt bzw. abgekühlt werden muss, um eine für die Substratbehandlung notwendige, meist hohe Temperatur (200°C bis 450°C für Plasmaprozesse und bis zu 1000°C für CVD-Prozesse) der Substrate bzw. die für den Weitertransport der Substrate in eine nächste Behandlungsanlage oder eine Lagerungsanlage gegebenenfalls notwendige niedrige Temperatur der Substrate zu erreichen. Insbesondere für große Substrate, bei denen die Substrathaltevorrichtung selbst ebenfalls großformatig ist und zur Gewährleistung der mechanischen Stabilität auch die Dicke der einzelnen Elemente der Substrathaltevorrichtung entsprechend groß ist, stellt die Substrathaltevorrichtung damit eine große thermische Masse dar, die aufgrund der langen Aufheiz- und Abkühlzeit zu einer Verlängerung der Prozessdauer und zu einer großen thermischen Belastung (thermal budget) der Substrate, welche insbesondere bei Vorliegen dotierter Schichten oder Bereiche ungünstig ist, und insgesamt zu einem hohen Energieverbrauch des Prozesses führt.

Wird eine Substrathaltevorrichtung mit den darin geladenen Substraten für verschiedene, nacheinander folgende Substratbehandlungen in unterschiedlichen Behandlungsvorrichtungen genutzt, so wird die Substrathaltevorrichtung im Ganzen von einer ersten Behandlungsvorrichtung in die in der Prozesslinie danach folgende zweite Behandlungsvorrichtung transportiert. Damit wird zwar ein Umladevorgang der Substrate in eine weitere Substrathaltevorrichtung mit dem notwendigen Abkühlen der Substrate und dem Aufheizen der Substrate und der weiteren Substrathaltevorrichtung vermieden. Jedoch werden gleichzeitig parasitäre Schichten, die sich auf der Substrathaltevorrichtung in der ersten Behandlungsvorrichtung gebildet haben, ebenfalls in die zweite Behandlungsvorrichtung eingebracht, wodurch Crosskontaminationen (Querverunreinigungen) zwischen den beiden Behandlungsvorrichtungen mit unerwünschten Effekten auf die Substratbehandlung auftreten können. Insbesondere bei einer Prozessfolge mit einem Dotierungsprozess, bspw. von Halbleiterschichten, und einem nachfolgenden andersartigen Dotierungsprozess oder einem nachfolgenden Prozess zum Abscheiden einer undotierten Schicht ergeben sich negative Effekte. Aber auch eine Unterbrechung des Vakuums, bei dem die Substrathaltevorrichtung in normaler Umgebungsluft transportiert wird, kann zum Einbringen unerwünschter Partikel und zur Absorption von verunreinigenden Gasen aus der Luft in die zweite Behandlungsvorrichtung und damit zu einem erhöhten Aufwand zur Beseitigung dieser Partikel und Gase führen. Diese Crosskontaminationseffekte steigen mit der Größe der freiliegenden Flächen der Substrathaltevorrichtung.

Es ist daher Aufgabe der Erfindung, eine Vorrichtung zum Transport eines Substrates, mit der ein flächiges Substrat in eine Behandlungsvorrichtung einer Behandlungsanlage ein- bzw. ausgefahren und auf einer Aufnahmeplatte in der Behandlungsvorrichtung horizontal positioniert werden kann, eine Behandlungsvorrichtung mit einer Aufnahmeplatte, die geeignet ist, das Substrat aufzunehmen und während der Substratbehandlung zu halten, und ein Verfahren zum Prozessieren eines Substrates in einer Behandlungsvorrichtung sowie eine Behandlungsanlage zur Verfügung zu stellen, bei denen die Nachteile des Standes der Technik vermieden oder verringert werden.

Die Aufgabe wird gelöst durch eine Vorrichtung zum Transport eines Substrates gemäß Anspruch 1, durch eine Behandlungsvorrichtung gemäß Anspruch 12, durch ein Verfahren gemäß Anspruch 21 und eine Behandlungsanlage gemäß Anspruch 25. Bevorzugte Ausführungsformen finden sich in den Unteransprüchen.

Die erfindungsgemäße Vorrichtung zum Transport eines Substrates dient zum einen dem Transport des Substrates in eine Behandlungsvorrichtung hinein oder aus dieser heraus, wobei die Behandlungsvorrichtung eine sich horizontal erstreckende Aufnahmeplatte aufweist, und zum anderen der Positionierung und Halterung des Substrates auf einer ersten Oberfläche der Aufnahmeplatte. Dabei ist die Vorrichtung geeignet, das Substrat auf der Aufnahmeplatte während der Behandlung des Substrates in der Behandlungsvorrichtung zu halten. Dazu weist die Vorrichtung einen Substratträger auf, der eine Haltefläche und einen oder mehrere Greifarme enthält.

Die Haltefläche erstreckt sich horizontal und ist auf einer dem Substrat zugewandten ersten Oberfläche eben und gleichförmig ausgebildet. Dies bedeutet, dass die Haltefläche zumindest an der ersten Oberfläche, auf der das Substrat aufliegt, aus ein und demselben Material besteht, keine Vertiefungen oder Löcher, auch keine mit einem Material gefüllte Löcher, und keine Erhöhungen aufweist. Mit anderen Worten: Die Haltefläche ist zumindest an der ersten Oberfläche ein monolithisches Gebilde mit einer ebenen Oberfläche. Dabei hat die Haltefläche eine Form und eine Fläche, die im Wesentlichen der Form und der Fläche des Substrates entsprechen. "Im Wesentlichen" bedeutet, dass geringfügige Abweichungen von der Form und Flächengröße des Substrates noch eine entsprechende Form und Fläche darstellen. So ist die Fläche der Haltefläche bspw. maximal 5% kleiner oder größer als die des Substrates. Ebenfalls "im Wesentlichen" gleich große Flächen ergeben sich bei einem lateralen Abstand eines Randes der Haltefläche vom Rand des Substrates, der kleiner oder gleich 4 mm ist. Vorzugsweise ist die Fläche der Haltefläche in den angegebenen Bereichen kleiner als oder maximal gleich groß wie die Fläche des Substrates. Das Substrat wird nur durch seine Gewichtskraft mit seiner Rückseite, welche die nicht zu behandelnde, flächige Oberfläche des Substrates ist, auf der Haltefläche gehalten. Es werden keine weiteren Kräfte, bspw. durch Ansaugen, Klemmen oder ähnliches, aktiv auf das Substrat ausgeübt.

Der oder die Greifarme sind mit der Haltefläche verbunden und erstrecken sich über diese in horizontaler Richtung hinaus. Der oder die Greifarme können am Rand der Haltefläche oder auf der Rückseite der Haltefläche, die der ersten Oberfläche der Haltefläche gegenüberliegt, mit der Haltefläche verbunden sein. Dabei können sie bspw. geklebt, geschweißt oder anderweitig lösbar oder nicht lösbar mit der Haltefläche verbunden sein. Auch eine einstückige Ausbildung der Greifarme und der Haltefläche ist möglich, wobei die Haltefläche und die Greifarme bspw. durch spanende Verfahren oder Ätzen aus einem gemeinsamen Materialstück herausgearbeitet oder in einem gemeinsamen Herstellungsverfahren, bspw. durch Gießen, erzeugt werden. Der oder die Greifarme dienen der Verbindung der Haltefläche mit einem Manipulator zum Bewegen des Substratträgers. Jeder Greifarm weist eine Breite und eine Länge auf, wobei die Länge entlang einer horizontalen Verbindunglinie der Haltefläche mit dem Manipulator und die Breite orthogonal zur Länge, aber in derselben horizontalen Ebene gemessen werden. Die Abmessungen der Greifarme sowie ihre Anzahl sind so bemessen, dass eine stabile, sichere Halterung und Bewegung der Haltefläche mit einem aufliegenden Substrat gewährleistet ist, und sind damit abhängig von der Form und Fläche sowie dem Gewicht der Haltefläche mit einem darauf aufliegenden Substrat. In Bereichen, in denen die Greifarme in Kontakt mit der Aufnahmeplatte der Behandlungsvorrichtung stehen und während einer Substratbehandlung nicht durch ein aufliegendes Substrat abgedeckt sind, sind die Greifarme somit einer ähnlichen Behandlung wie das Substrat ausgesetzt. Zumindest in diesen Bereichen ist die Breite der Greifarme soweit minimiert, wie die Gewährleistung der mechanischen Stabilität und die Erfüllung der Funktion des Substratträgers dies erlaubt. Damit ist die Summe der Breiten aller Greifarme wesentlich kleiner als die maximale Ausdehnung der Haltefläche in der horizontalen Ebene. Vorzugsweise ist die Summe der Breiten aller Greifarme um ein Vielfaches, z.B. um den Faktor 10, kleiner als die maximale Ausdehnung der Haltefläche.

Der Substratträger der erfindungsgemäßen Vorrichtung ermöglicht mehrere Vorteile bei der Prozessierung eines Substrates: Die Ausführung der Haltefläche als gleichförmige, ebene Fläche mit im Wesentlichen der gleichen Form und Größe wie das Substrat, auf der das Substrat lediglich durch seine eigene Gewichtskraft gehalten wird, vermeidet jeden ungleichmäßigen oder zusätzlichen Angriff von Kräften auf das Substrat, so dass die Bruchgefahr gesenkt wirkt, und ermöglicht eine Verbesserung der Homogenität der Behandlung des Substrates. Darüber hinaus kann ein Substrat, das während der Behandlung beschädigt wurde und bspw. zerbrochen ist, ohne Schwierigkeiten aus der Behandlungsvorrichtung entfernt und transportiert werden. Da weiterhin das Substrat während der Behandlung auf dem Substratträger verbleibt und nicht vor der Behandlung vom Substratträger abgenommen und nach erfolgter Behandlung wieder auf den Substratträger aufgelegt werden muss, entfallen zwei kritische Schritte, wodurch die Gefahr einer Beschädigung des Substrates gesenkt und Zeit gespart wird. Da die Haltefläche im Wesentlichen die gleiche Form und Fläche wie das Substrat aufweist und die Abmessungen der Greifarme in einem Behandlungsbereich, also dort, wo kein Substrat die Greifarme überdeckt und die Greifarme mit der Aufnahmeplatte in Kontakt stehen, so klein wie möglich sind, sind die Bereiche des Substratträgers, die eine Behandlung ähnlich wie das Substrat erfahren, auf ein Minimum begrenzt. Damit wird eine Crosskontamination zwischen verschiedenen Behandlungsvorrichtungen, in denen das Substrat auf demselben Substratträger gehaltert ist, reduziert bzw. eine Umlagerung auf einen anderen Substratträger für den Transport in eine andere Behandlungsvorrichtung überflüssig und die damit verbundene mögliche Beschädigung des Substrates vermieden.

Vorzugsweise enthält der Substratträger mindestens zwei Haltevorrichtungen, die sich vom Rand und/oder von der ersten Oberfläche der Haltefläche aus mindestens in vertikale Richtung erstrecken, mit dieser lösbar oder unlösbar verbunden und die geeignet sind, das Substrat gegen ein laterales Verschieben, z.B. ein Verrutschen oder Verdrehen, auf der Haltefläche, insbesondere bei schnellen Bewegungen des Substratträgers in einer horizontalen Richtung, zu sichern. Die Haltevorrichtungen erstrecken sich dabei bis zu einer Höhe über die erste Oberfläche der Haltefläche, die vorzugsweise größer Null und kleiner als oder gleich der Höhe des Substrates ist. Dabei wird die Höhe der Haltevorrichtungen von der ersten Oberfläche der Haltefläche gemessen. Die Haltevorrichtungen haben vorzugsweise eine Länge und Breite, die gegenüber der Länge und Breite des Substrates wesentlich kleiner sind. Damit wird die Behandlung des Substrates nur wenig durch die Haltevorrichtungen beeinflusst. Da die Haltevorrichtungen bzw. deren Bereiche, die eine Behandlung ähnlich wie das Substrat erfahren, nur sehr kleine Abmessungen aufweisen, haben diese ebenfalls kaum Einfluss auf eine durch die Vorrichtung zum Transport eines Substrates verursachte Crosskontamination.

In einer besonderen Ausführungsform ist der Substratträger zum Transport mehrerer Substrate geeignet. Dazu weist er mehrere Halteflächen auf, die in einer gemeinsamen horizontalen Ebene nebeneinander in einer lateralen Anordnung angeordnet und untereinander physisch verbunden sind. Die physische Verbindung führt zu einer starren mechanischen Verbindung zwischen den verschiedenen Halteflächen. Die physische Verbindung der Halteflächen in ihrer Gesamtheit ist wiederum mit einem oder mehreren Greifarmen verbunden, so dass alle Halteflächen gleichzeitig mit Hilfe des an dem oder den Greifarmen angreifenden Manipulators bewegt werden können. Vorzugsweise weist der Substratträger dabei einen geschlossenen Grundkörper auf, wobei jede Haltefläche als Grundfläche einer Vertiefung, die in einer horizontalen Oberfläche des Grundkörpers ausgebildet ist, realisiert ist. Um die Substrate, von denen jedes auf einer der Halteflächen aufliegt, gegen ein laterales Verschieben, z.B. ein Verrutschen oder Verdrehen, auf der jeweiligen Haltefläche zu sichern, sind Haltevorrichtungen vorgesehen, die z.B. als seitlicher Rahmen oder als Steg zwischen den Halteflächen ausgebildet sind.

Vorzugsweise bestehen die Bestandteile des Substratträgers zumindest in den Bereichen, die während der Substratbehandlung mit dem Substrat und/oder der Aufnahmeplatte in Kontakt stehen, aus demselben Material wie die erste Oberfläche der Aufnahmeplatte. In einer besonders bevorzugten Ausführungsform bestehen die Bestandteile des Substratträgers in den Bereichen, die während der Substratbehandlung mit dem Substrat und/oder der Aufnahmeplatte in Kontakt stehen, aus einem elektrisch leitenden Material, während der oder die Greifarme in Bereichen, die während der Substratbehandlung nicht mit der Aufnahmeplatte in Kontakt stehen, aus einem dielektrischen Material bestehen. Dies hat den Vorteil, dass ein mit den Greifarmen verbundener Manipulator auf einem Potential, bspw. Masse, unabhängig von dem Potential der Aufnahmeplatte liegen kann und bspw. parasitäre Plasmen in dem Bereich der Greifarme weitgehend vermieden werden.

Vorzugsweise weisen die Bereiche des Substratträgers, die während der Substratbehandlung mit dem oder den Substraten und/oder der Aufnahmeplatte in Wärmekontakt stehen, eine möglichst kleine Wärmekapazität auf, die möglichst klein im Verhältnis zur Wärmekapazität der Aufnahmeplatte ist, um einen schnellen Temperaturangleich an die Temperatur der geheizten Aufnahmeplatte zu ermöglichen. Dabei wird die Wärmekapazität dieser Bereiche des Substratträgers durch eine entsprechende Auswahl des Materials des Substratträgers und der Abmessungen der Bereiche, d.h. insbesondere der Höhe der Haltefläche und der Greifarme, minimiert. Dies hat den Vorteil, dass diese Bereiche des Substratträgers und das auf der Haltefläche aufliegende Substrat schnell aufgeheizt oder abgekühlt werden können, wodurch das Substrat schnell die für die Behandlung in der Behandlungsvorrichtung notwendige oder gewünschte Temperatur annimmt und nach erfolgter Behandlung schnell wieder auf eine für die weitere Prozessierung vorteilhafte Temperatur eingestellt werden kann.

Vorzugsweise weist die Vorrichtung eine Trägeranordnung auf, an der der Substratträger mit dem einen oder mehreren Greifarmen befestigt ist. Die Trägeranordnung kann mit einem Manipulator zum Bewegen des Substratträgers verbunden werden.

In einer Ausführungsform enthält die Vorrichtung mehrere Substratträger, die vertikal übereinander angeordnet und mit der Trägeranordnung verbunden sind und eine Einheit bilden. Dabei sind vorzugsweise alle Substratträger gleichartig ausgebildet. Die Trägeranordnung ist bspw. eine vertikal verlaufende Platte oder Stange, an der die Greifarme der einzelnen Substratträger befestigt sind. Damit ist mit Hilfe der Trägeranordnung ein gemeinsames, gleichzeitiges und gleichartiges Bewegen aller Substratträger gewährleistet, so dass mehrere Substrate gleichzeitig in eine oder aus einer Behandlungsvorrichtung, die mehrere, vertikal übereinander angeordnete Aufnahmeplatten aufweist, hinein- oder herausbewegt, auf den Aufnahmeplatten positioniert und während der Behandlung der Substrate gehalten werden können. Dabei entspricht der vertikale Abstand der einzelnen Substratträger zueinander dem vertikalen Abstand der einzelnen Aufnahmeplatten der Behandlungsvorrichtung zueinander.

Vorzugsweise weist die Vorrichtung mehrere Einheiten von vertikal übereinander angeordneten Substratträgern auf, wobei die Einheiten in horizontaler Richtung nebeneinander angeordnet und mit derselben Trägeranordnung verbunden sind. Damit ist das gleichzeitige Bewegen mehrerer Substrateinheiten, wobei die Substrate einer bestimmten Substrateinheit auf den Halteflächen einer bestimmten Einheit von Substratträgern aufliegen, in oder aus mehreren, in horizontaler Richtung nebeneinander angeordneten Behandlungsvorrichtungen möglich, wobei die mehreren Behandlungsvorrichtungen gleichartig oder verschieden sein können. Selbstverständlich kann eine Behandlungsvorrichtung auch mehrere horizontal nebeneinander angeordnete Einheiten von vertikal übereinander angeordneten Aufnahmeplatten enthalten.

Selbstverständlich kann die Vorrichtung auch mehrere Substratträger, die in horizontaler Richtung nebeneinander, aber nicht übereinander angeordnet und mit der Trägeranordnung verbunden sind, aufweisen.

Die erfindungsgemäße Behandlungsvorrichtung zur Behandlung eines Substrates weist eine Aufnahmeplatte, auf der das Substrat während der Behandlung gehaltert wird, auf. Diese Aufnahmeplatte weist in einer ersten Oberfläche, die dem Substrat während der Substratbehandlung zugewandt ist, eine Vertiefung auf, die geeignet ist, einen Substratträger der erfindungsgemäßen Vorrichtung zum Transport eines Substrates während der Behandlung des Substrates aufzunehmen. Dazu sind die Abmessungen und die Form der Vertiefung entsprechend den Abmessungen und der Form des Substratträgers ausgelegt. Das heißt, die Abmessungen und Form der Haltefläche, die Abmessungen, Form und Anordnung der Greifarme sowie ggf. die Abmessungen, Form und Anordnung der Haltevorrichtungen sowie ggf. die Anordnung mehrere Halteflächen sind bei der Gestaltung der Vertiefung in der Aufnahmeplatte berücksichtigt. Mit anderen Worten: Eine Aufnahmeplatte der erfindungsgemäßen Behandlungsvorrichtung ist so ausgebildet, dass ein Substratträger einer bestimmten erfindungsgemäßen Vorrichtung zum Transport eines Substrates formschlüssig in die Vertiefung der Aufnahmeplatte "passt". Die Vertiefung der Aufnahmeplatte bildet somit ein Negativ der der Aufnahmeplatte zugewandten Oberfläche des Substratträgers. Dabei ist die Vertiefung so ausgelegt, dass der Substratträger auch dann zumindest in der horizontalen Draufsicht vollständig in der Vertiefung aufgenommen ist, also in die Vertiefung "passt", wenn der Substratträger auf eine Temperatur der Aufnahmeplatte während der Substratbehandlung, die gegenüber Normaltemperatur oft eine höhere Temperatur ist, erwärmt ist. Unter "Normaltemperatur" wird hier die Temperatur verstanden, bei der die Abmessungen des Substratträgers gewöhnlich gemessen werden, bspw. Raumtemperatur, d.h. ca. 20°C. Mit anderen Worten: Die thermische Ausdehnung des Substratträgers und der Aufnahmeplatte und die Temperatur der Aufnahmeplatte während der Substratbehandlung ist bei der Auslegung und Erzeugung der Vertiefung in der Aufnahmeplatte zu berücksichtigen.

Eine derartige Ausführung der Aufnahmeplatte der Behandlungsvorrichtung zusammen mit einem Substratträger mit minimaler zu beschichtender Fläche ermöglicht eine weitere Reduzierung der Crosskontamination zwischen verschiedenen Behandlungsvorrichtungen, in denen das Substrat auf demselben, erfindungsgemäßen Substratträger gehaltert ist, da die Abscheidung von Schichten, die eine Crosskontamination bewirken würden, nur noch auf einem Minimum an Fläche stattfinden kann. Da im Wesentlichen nur die Haltevorrichtungen des Substratträgers zu einer Crosskontamination beitragen, und deren Fläche z.B. nur 0,1 bis 1% der gesamten Fläche der Aufnahmeplatte betragen kann, kann die Crosskontamination von zwei hintereinander abfolgenden Beschichtungsprozessen bspw. um 3 bis 4 Größenordnungen gesenkt werden. Damit wird z.B. die Abscheidung von dotierten und undotierten (intrinsischen) Halbleiterschichten in einer Anlage mit einem umlaufenden Substratträger, d.h. einem für mindestens die beiden Beschichtungsprozesse gemeinsam genutzten Substratträger und/oder einem Substratträger, der für mehrere Durchläufe durch die Anlage ohne zwischengelagerte Reinigung des Substratträgers genutzt wird, ermöglicht. Darüber hinaus bietet diese Ausgestaltung der Aufnahmeplatte die Möglichkeit, den Substratträger mit seiner Rückseite vollflächig elektrisch und/oder thermisch über die Aufnahmeplatte zu kontaktieren und damit eine homogene Potentialverteilung und/oder eine homogene Temperierung der Haltefläche zu erreichen.

Vorzugsweise weist die Vertiefung in der ersten Oberfläche der Aufnahmeplatte eine Tiefe gemessen von der ersten Oberfläche der Aufnahmeplatte aus auf, die so bemessen ist, dass die erste Oberfläche der Haltefläche des Substratträgers und die erste Oberfläche der Aufnahmeplatte während der Substratbehandlung eine ebene Oberfläche bilden. Damit bilden die Aufnahmeplatte und die Haltefläche des Substratträgers eine ebene Fläche, auf der das Substrat während seiner Behandlung vollständig eben aufliegt, so dass die Homogenität der Substratbehandlung weiter erhöht wird.

In einer Ausführungsform ist die Behandlungsvorrichtung eine Plasmabehandlungsvorrichtung und weist weiterhin eine Vorrichtung zum Anlegen einer ersten Spannung an die Aufnahmeplatte und einer zweiten Spannung an eine erste Elektrode, die in vertikaler Richtung über der Aufnahmeplatte und parallel zu dieser angeordnet und von der Aufnahmeplatte elektrisch isoliert ist, auf. Die Aufnahmeplatte ist damit eine zweite Elektrode in einem aus der ersten Elektrode und der Aufnahmeplatte bestehenden Parallelplattenreaktor. Die erste und die zweite Spannung sind dabei voneinander verschieden. Somit kann zwischen der ersten Elektrode und der Aufnahmeplatte ein Plasma gezündet und das Substrat mit einem durch das Plasma unterstützten Prozess behandelt werden. Sind in der Behandlungsvorrichtung mehrere Aufnahmeplatten vertikal übereinander angeordnet, so wird vorzugsweise jede der Aufnahmeplatten alternierend von der Vorrichtung zum Anlegen einer Spannung mit der ersten oder der zweiten Spannung versorgt. Somit bildet jede Aufnahmeplatte, die in vertikaler Richtung oberhalb einer anderen Aufnahmeplatte angeordnet ist, die erste Elektrode innerhalb eines Plattenkondensators, der aus dieser Aufnahmeplatte und der direkt darunter angeordneten Aufnahmeplatte besteht. Lediglich oberhalb der obersten Aufnahmeplatte der Behandlungsvorrichtung ist eine zusätzliche erste Elektrode notwendig, wenn ein auf der obersten Aufnahmeplatte angeordnetes Substrat ebenfalls behandelt werden soll.

Vorzugsweise besteht die Aufnahmeplatte der Plasmabehandlungsvorrichtung vollständig aus einem elektrisch leitfähigen Material, so dass ein ohmscher Kontakt zu dem Substratträger, und bei einem Substratträger aus elektrisch leitfähigem Material zu dem Substrat, möglich ist.

In einer anderen bevorzugten Ausführungsform besteht die Aufnahmeplatte der Plasmabehandlungsvorrichtung zumindest in einem Bereich, der an die erste Oberfläche angrenzt, aus einem Schichtaufbau aus einem elektrisch leitfähigen Material und einem dielektrischen Material, wobei das dielektrische Material an die erste Oberfläche der Aufnahmeplatte angrenzt. Damit kann ein kapazitiver Kontakt zu dem Substratträger und dem Substrat hergestellt werden.

Vorzugsweise enthält die Aufnahmeplatte eine Einrichtung zum Temperieren der Aufnahmeplatte, die zum Einstellen einer, bspw. für die Substratbehandlung, gewünschten Temperatur dient. Diese Einrichtung ist vorzugsweise eine Heizeinrichtung, kann aber auch eine Kühleinrichtung sein. Dabei kann die Einrichtung zum Temperieren bspw. als resistives Heizelement oder als fluiddurchströmtes Rohrsystem oder in Form anderer, aus dem Stand der Technik bekannter Einrichtungen ausgeführt sein.

Darüber hinaus kann die Aufnahmeplatte auch weitere Einrichtungen enthalten, wie bspw. eine Einrichtung zum Zuführen eines oder mehrerer Prozessgase in einen Behandlungsraum eines Substrates. Sind in der Behandlungsvorrichtung mehrere Aufnahmeplatten vertikal übereinander angeordnet, so enthält bspw. jede Aufnahmeplatte, die in vertikaler Richtung oberhalb einer anderen Aufnahmeplatte angeordnet ist, vorzugsweise einen Gasverteiler, der geeignet ist, ein oder mehrere Gase von der Rückseite der Aufnahmeplatte aus einem Raum oberhalb einer unter dieser Aufnahmeplatte angeordneten Aufnahmeplatte zuzuführen. Somit bildet jede Aufnahmeplatte gleichzeitig die Gaszuführung für eine Behandlung eines Substrates, das auf der direkt darunter angeordneten Aufnahmeplatte aufliegt.

Vorzugsweise ist die Behandlungsvorrichtung eine CVD-Beschichtungsanlage, Dabei enthält die Aufnahmeplatte in einem in vertikaler Richtung oberen Bereich einen Flächenheizer, der geeignet ist, den oberen Bereich auf eine erste Temperatur aufzuheizen, und in einem in vertikaler Richtung unteren Bereich einen Gasverteiler, der Mittel zur Temperierung des unteren Bereiches auf eine zweite Temperatur aufweist, wobei die zweite Temperatur kleiner als die erste Temperatur ist. Zwischen dem oberen und dem unteren Bereich ist eine Anordnung zur Wärmeisolation angeordnet, die geeignet ist, einen Wärmefluss von dem oberen Bereich zum unteren Bereich zu verringern oder zu verhindern.

Vorzugsweise weist die Vertiefung in der ersten Oberfläche der Aufnahmeplatte eine Form auf, die eine Selbstjustage des Substratträgers in der Vertiefung, insbesondere während des Ablegens des Substratträgers auf der Aufnahmeplatte, ermöglicht. So kann bspw. die Vertiefung einen schrägen Verlauf ihrer nach unten verlaufenden Kanten aufweisen.

Vorzugsweise weist die Behandlungsvorrichtung mehrere, übereinander angeordnete Aufnahmeplatten auf, von denen jede geeignet ist, einen Substratträger der erfindungsgemäßen Vorrichtung zum Transport eines Substrates, welche eine Einheit von vertikal übereinander angeordneten Substratträgern enthält, aufzunehmen. Dabei sind die vertikalen Abstände der Aufnahmeplatten und die vertikalen Abstände der Substratträger aneinander angepasst.

Das erfindungsgemäße Verfahren zum Prozessieren eines Substrates in einer Behandlungsanlage, die eine Behandlungsvorrichtung mit einer Aufnahmeplatte, auf der das Substrat während der Behandlung gehaltert wird, enthält, weist die folgenden Schritte in der angegebenen Reihenfolge auf: Auflegen des Substrates auf einen Substratträger einer erfindungsgemäßen Vorrichtung zum Transport eines Substrates, Bewegen des Substratträgers in mindestens einer horizontalen Richtung, bis der Substratträger in vertikaler Richtung oberhalb einer Aufnahmeplatte der Behandlungsvorrichtung angeordnet ist, Ablegen des Substratträgers auf der Aufnahmeplatte, Behandeln des Substrates in der Behandlungsvorrichtung, Abheben des Substratträgers von der Aufnahmeplatte in vertikaler Richtung, Bewegen des Substratträgers in mindestens einer horizontalen Richtung aus der Behandlungsvorrichtung heraus und Entnehmen des Substrates von dem Substratträger. Das Auflegen des Substrates auf den Substratträger und das Entnehmen des Substrates von dem Substratträger erfolgt mit Mitteln, die aus dem Stand der Technik bekannt sind. Die Bewegung des Substratträgers in horizontaler Richtung und in vertikaler Richtung zum Ablegen des Substratträgers auf der Aufnahmeplatte und zum Abheben des Substratträgers von der Aufnahmeplatte erfolgen mit Hilfe eines Manipulators, der aus dem Stand der Technik bekannte Mittel aufweist. Vorzugsweise sind die horizontalen und vertikalen Bewegungen des Substratträgers zeitlich klar voneinander getrennt. Bei entsprechendem Platzangebot innerhalb der Behandlungsvorrichtung können die horizontale Bewegung und die vertikale Bewegung auch zumindest teilweise miteinander kombiniert werden. Dabei kann beispielsweise auch eine Schraubenbewegung des Substratträgers zum Einsatz kommen.

Vorzugsweise weist die Behandlungsanlage mehrere Behandlungsvorrichtungen auf und die Schritte zum Bewegen des Substratträgers in mindestens einer horizontalen Richtung, bis der Substratträger in vertikaler Richtung oberhalb einer Aufnahmeplatte der Behandlungsvorrichtung angeordnet ist, zum Ablegen des Substratträgers auf der Aufnahmeplatte, zum Behandeln des Substrates in der Behandlungsvorrichtung, zum Abheben des Substratträgers von der Aufnahmeplatte in vertikaler Richtung und zum Bewegen des Substratträgers in mindestens einer horizontalen Richtung aus der Behandlungsvorrichtung heraus werden als Einheit mehrmals hintereinander ausgeführt, wobei das Substrat nacheinander in verschiedene Behandlungsvorrichtungen ein- und ausgebracht und in diesen behandelt wird. Damit liegt das Substrat während der gesamten Prozessierung in der Behandlungsanlage auf demselben Substratträger und wird mit diesem von einer Behandlungsvorrichtung zur nächsten Behandlungsvorrichtung transportiert und in jeder Behandlungsvorrichtung auf der jeweiligen Aufnahmeplatte abgelegt und behandelt. Somit wird ein Umladen des Substrates zwischen verschiedenen Behandlungsvorrichtungen vermieden, während die Probleme der Crosskontamination und einer ggf. notwendigen, zeitaufwendigen Temperierung des Substrates zwischen verschiedenen Behandlungsvorgängen erheblich reduziert werden.

Vorzugsweise werden die Substratbehandlungen in den verschiedenen Behandlungsvorrichtungen sowie die Transportvorgänge des Substrates zwischen den verschiedenen Behandlungsvorrichtungen ohne Unterbrechung eines Vakuums in der Behandlungsanlage ausgeführt. Damit wird das Einbringen von Partikeln in die Behandlungsvorrichtungen reduziert, wodurch Zeit und Kosten gespart werden.

In einer besonders bevorzugten Ausführungsform ist die Behandlungsvorrichtung eine erfindungsgemäße Behandlungsvorrichtung, wie sie oben beschrieben wurde. Das heißt, die Aufnahmeplatte weist eine dem Substratträger entsprechende Vertiefung auf. In diesem Fall, wird der Substratträger in der Vertiefung der Aufnahmeplatte abgelegt.

Jedoch kann eine erfindungsgemäße Vorrichtung zum Transport eines Substrates auch mit einer Behandlungsvorrichtung, deren Aufnahmeplatte keine solche Vertiefung aufweist, zum Prozessieren eines Substrates kombiniert werden. Dabei sind die Greifarme des Substratträgers vorzugsweise nur an den Seitenflächen bzw. dem Rand der Haltefläche angeordnet, d.h. ausgebildet oder befestigt, so dass die Rückseite des Substratträgers, welche auf der Aufnahmeplatte der Behandlungsvorrichtung aufgelegt wird, eben ist und keine vorspringenden Teile oder Vertiefungen aufweist. Damit liegt die Haltefläche des Substratträgers plan auf der planaren Oberfläche der Aufnahmeplatte während der Substratbehandlung auf. Auch in dieser Ausführungsform ist bereits eine Reduzierung der Crosskontamination sowie eine vollflächige elektrische und/oder thermische Kontaktierung des Substratträgers mit seiner Rückseite über die Aufnahmeplatte und damit eine homogene Potentialverteilung und/oder eine homogene Temperierung der Haltefläche erreichbar.

Die erfindungsgemäße Behandlungsanlage zum Prozessieren eines Substrates weist eine Beladekammer, mindestens eine Behandlungskammer mit mindestens einer Behandlungsvorrichtung und eine Entladekammer sowie eine Bewegungsanordnung auf. Die Behandlungsvorrichtung weist eine Aufnahmeplatte auf, auf der das Substrat während der Behandlung gehaltert wird. Die Bewegungsanordnung ist geeignet, eine erfindungsgemäße Vorrichtung zum Transport eines Substrates aufzunehmen und in die mindestens eine Behandlungskammer hinein und aus dieser heraus sowie einen Substratträger der Vorrichtung zum Transport eines Substrates in der Behandlungskammer in mindestens eine horizontal verlaufende Richtung und in vertikale Richtung zu bewegen. Damit dient die Bewegungsanordnung dem Bewegen des Substratträgers mit dem darauf angeordneten Substrat in die mindestens eine Behandlungsvorrichtung hinein und aus dieser heraus sowie dem Ablegen und Abheben des Substratträgers auf die bzw. von der Aufnahmeplatte der Behandlungsvorrichtung. Die Beladekammer ist für das Auflegen des Substrates auf den Substratträger der erfindungsgemäßen Vorrichtung zum Transport des Substrates geeignet, während die Entladekammerfür das Entnehmen des Substrates von dem Substratträger geeignet ist. Diese Kammern sind vorzugsweise geschlossene Kammern, die auf allen Seiten von Kammerwänden umgeben sind, können jedoch auch offene Kammern im Sinne einer zur Umgebung offenen Belade- oder Entladestation sein. Die Belade- und Entladekammer können mit einem aus dem Stand der Technik bekannten Handlingsystem versehen oder verbunden sein, welches das Auflegen bzw. Entnehmen des Substrates auf bzw. von dem Substratträger realisiert. Darüber hinaus können die Belade- und die Entladekammer auch als eine einzige Kammer ausgeführt sein, die sowohl für das Auflegen des Substrates auf einen Substratträger, als auch für das Entnehmen des Substrates von dem Substratträger geeignet ist.

Vorzugsweise ist mindestens eine Behandlungsvorrichtung eine erfindungsgemäße Behandlungsvorrichtung, wie sie oben beschrieben wurde. Das heißt, die Aufnahmeplatte weist eine dem Substratträger entsprechende Vertiefung auf.

Die mindestens eine Behandlungskammer ist vorzugsweise eine geschlossene Kammer, in der definierte Prozessbedingungen für die Behandlung des Substrates eingestellt werden können. Sind mehrere Behandlungskammern vorhanden, so können verschiedene Behandlungskammern verschieden ausgestaltet sein.

Die verschiedenen Kammern können beliebig angeordnet sein, sofern ihre Funktionalität und die Bewegung der Vorrichtung zum Transport eines Substrates gewährleistet sind. Vorzugsweise sind die einzelnen Kammern linear hintereinander angeordnet, wobei in einer besonders bevorzugten Ausführung die Anlage als Durchlaufanlage ausgeführt ist. Jedoch ist es auch möglich, mehrere Behandlungskammern in einer nichtlinearen Weise um eine zentrale Kammer herum anzuordnen, wobei die zentrale Kammer eine kombinierte Be- und Entladekammer oder eine separate Handlingkammer sein kann.

Vorzugsweise ist eine der mindestens einen Behandlungskammern eine Vakuumkammer, die von einer angrenzenden Kammer durch ein gasdichtes Schiebeventil getrennt ist, wobei das Schiebeventil einen Querschnitt aufweist, der ausreichend groß ist, um die Vorrichtung zum Transport eines Substrates hindurchzufahren. Die an diese Vakuumkammer angrenzenden Kammern können dabei Kammern sein, in denen ebenfalls ein Vakuum erzeugt werden kann, so dass diese angrenzenden Kammern als Einschleuskammer, in der aus einer Umgebung mit Normaldruck eine Vakuumatmosphäre erzeugt wird, oder als Ausschleuskammer, in der aus einer Vakuumatmosphäre eine Umgebung mit Normaldruck erzeugt wird, genutzt werden können. Auch die Be- und Entladekammern können als derartige Einschleus- und Ausschleuskammern genutzt werden.

In einer bevorzugten Ausführungsform weist die Behandlungsanlage mehrere Behandlungskammern auf, die jeweils Vakuumkammern sind und die untereinander mittels gasdichter Schiebeventile verbunden sind. Dabei ist die Bewegungsanordnung geeignet, die Vorrichtung zum Transport eines Substrates durch alle Behandlungskammern ohne Unterbrechung des Vakuums zu bewegen. Somit werden Abpump- und Belüftungsvorgänge zwischen einzelnen Behandlungsschritten in den verschiedenen Behandlungskammern und die damit verbundenen Nachteile vermieden.

Vorzugsweise ist mindestens die mindestens eine Behandlungskammer eine Kammer mit einer geraden, vertikalen Seitenwand, die senkrecht zu einer Wand oder einem Schieberventil, welche oder welcher an eine angrenzende Kammer, bspw. die Beladekammer und/oder die Entladekammer, angrenzt, verläuft. Die Bewegungsanordnung enthält in dieser Ausführungsform eine Trägereinheit, mindestens ein, in horizontaler oder vertikaler Richtung sich erstreckendes Führungssystem und eine Mehrzahl von Führungselementen. Das Führungssystem ist an der Trägereinheit auf der der Seitenwand zugewandten Seite angeordnet, während die Führungselemente an der vertikalen Seitenwand der Behandlungskammer angeordnet und geeignet sind, mit dem Führungssystem so zusammenzuwirken, dass die Trägereinheit über die Führungselemente in horizontaler oder vertikaler Richtung entlang der Seitenwand geführt und gehalten wird. Die Trägereinheit ist auf der der Seitenwand der Behandlungskammer abgewandten Seite der Trägereinheit mechanisch mit der Vorrichtung zum Transport eines Substrates, insbesondere mit dem oder den Greifarmen eines Substratträgers oder mit einer Trägeranordnung, verbunden. Sie ist geeignet, den Substratträger der Vorrichtung zum Transport eines Substrates mindestens in eine Richtung orthogonal zur Richtung, in die sich das Führungssystem erstreckt, zu bewegen. Dazu weist sie elektrisch, pneumatisch, hydraulisch oder anderweitig angetriebene und gesteuerte Bewegungseinrichtungen, wie bspw. Schiebestangen, auf, die aus dem Stand der Technik bekannt sind.

Vorzugsweise ist die Trägereinheit geeignet, den Substratträger entlang einer horizontalen Richtung, die orthogonal zu der Seite der Trägereinheit, die der Vorrichtung zum Transport eines Substrates zugewandt ist, verläuft, zu bewegen.

In einer Ausführungsform erstrecken sich das Führungssystem vertikal entlang der Trägereinheit und die Führungselemente vertikal entlang der Seitenwand der Behandlungskammer. Die angrenzenden Kammern sind in vertikaler Richtung ober oder unterhalb der Behandlungskammer angeordnet. In diesem Fall wird eine vertikale Bewegung der Vorrichtung zum Transport des Substrates durch das Führungssystem in Zusammenwirkung mit den Führungselementen realisiert, während eine horizontale Bewegung der Vorrichtung zum Transport des Substrates durch die Trägereinheit realisiert wird.

In einer anderen Ausführungsform erstrecken sich das Führungssystem horizontal entlang der Trägereinheit und die Führungselemente horizontal entlang der Seitenwand der Behandlungskammer. Die angrenzenden Kammern sind in horizontaler Richtung neben der Behandlungskammer angeordnet. In diesem Fall wird eine Bewegung der Vorrichtung zum Transport des Substrates in eine horizontale Richtung, die entlang der vertikalen Seitenwand der Behandlungsanlage verläuft, durch das Führungssystem in Zusammenwirkung mit den Führungselementen realisiert, während eine vertikale Bewegung der Vorrichtung zum Transport des Substrates sowie ggf. eine Bewegung der Vorrichtung zum Transport des Substrates entlang einer horizontalen Richtung, die orthogonal zu der Seite der Trägereinheit, die der Vorrichtung zum Transport eines Substrates zugewandt ist, verläuft, durch die Trägereinheit realisiert wird. In dieser Ausführungsform enthält das Führungssystem vorzugsweise eine Schiene, die in horizontaler Richtung an der Trägereinheit angeordnet ist, während die Führungselemente vorzugsweise Rollen enthalten, die drehbar und in horizontaler Richtung hintereinander an der Seitenwand angeordnet sind. Dabei sind die Rollen jeweils mit einem Abstand zueinander angeordnet, der so klein ist, dass die Schiene an jedem Ort innerhalb der Behandlungsanlage mit mindestens zwei Rollen in Kontakt steht und von diesen gehalten wird. Die Abmessung der gasdichten Schiebeventile in Fahrtrichtung der Trägereinheit muss damit auch kleiner als der Rollenabstand sein.

Vorzugsweise ist die erfindungsgemäße Vorrichtung zum Transport eines Substrates integraler Bestandteil der Behandlungsanlage. Das heißt, die Vorrichtung wird nur in der Behandlungsanlage und nicht in anderen Behandlungsanlagen eingesetzt und ist an die spezifischen Merkmale der Behandlungsanlage angepasst.

In einer Ausführungsform der Behandlungsanlage sind die Beladekammer, die mindestens eine Behandlungskammer und die Entladekammer in einer linearen Abfolge angeordnet. Dies bedeutet, dass die Kammern in der aufgeführten Reihenfolge hintereinander entlang einer Linie angeordnet sind. Die Bewegungsanordnung ist dabei geeignet, die Vorrichtung zum Transport eines Substrates unidirektional von der Beladekammer durch die mindestens eine Behandlungskammer in die Entladekammer zu bewegen. Damit wird ein Substrat entlang der Linie durch die verschiedenen Kammern bewegt und prozessiert. Eine solche Behandlungsanlage ist somit eine Durchlaufanlage, bei der Be- und Entladekammer separate Kammern sind, die oftmals in einem großen räumlichen Abstand zueinander angeordnet sind. Die Bewegungsanordnung enthält weiterhin ein Rückführsystem, welches zum Transport der Vorrichtung zum Transport eines Substrates von der Entladekammer zur Beladekammer außerhalb der mindestens einen Behandlungskammer geeignet ist. Damit kann eine leere Vorrichtung zum Transport eines Substrates, d.h. eine Vorrichtung, bei der kein Substrat mehr auf dem Substratträger aufliegt, von der Entladekammer wieder zur Beladekammer zurückgeführt werden, so dass sie erneut für das Prozessieren eines Substrates in der Behandlungsanlage zur Verfügung steht.

Nachfolgend wird die Erfindung anhand der Figuren näher erläutert. Dabei sind die Abmessungen der einzelnen Elemente sowie deren Relation zueinander nicht maßstäblich, sondern nur schematisch widergegeben. Gleiche Bezugszeichen bezeichnen entsprechende gleichartige Bauteile. Es zeigen:
- Fig. 1A: eine schematische Draufsicht auf eine erste Ausführungsform der erfindungsgemäßen Vorrichtung zum Transport eines Substrates mit einer ersten Ausführungsform des Substratträgers,
- Fig. 1B: einen schematischen Querschnitt durch die erste Ausführungsform entlang der Linie A-A' aus Fig. 1A,
- Fig. 1C: eine schematische Draufsicht auf den Substratträger der Fig. 1A mit einem darauf aufliegenden Substrat,
- Fig. 1D: einen schematischen Querschnitt durch den Substratträger der Fig. 1C mit darauf aufliegendem Substrat entlang der Linie B-B' aus Fig. 1C,
- Fig. 2A: eine schematische Draufsicht auf eine zweite Ausführungsform des Substratträgers,
- Fig. 2B: eine schematische Draufsicht auf eine dritte Ausführungsform des Substratträgers,
- Fig. 3A: eine schematische Draufsicht auf eine vierte Ausführungsform des Substratträgers mit darauf aufliegenden Substraten,
- Fig. 3B: einen schematischen Querschnitt durch die vierte Ausführungsform entlang der Linie C-C' aus Fig. 3A,
- Fig. 3C: den in Fig. 3B dargestellten Querschnitt ohne die aufliegenden Substrate,
- Fig. 4A: eine Seitenansicht einer zweiten Ausführungsform der Vorrichtung zum Transport eines Substrates, die eine Einheit von mehreren übereinander angeordneten Substratträgern aufweist,
- Fig. 4B: eine Vorderansicht einer dritten Ausführungsform der Vorrichtung zum Transport eines Substrates, die zwei nebeneinander angeordnete Einheiten von mehreren übereinander angeordneten Substratträgern aufweist,
- Fig. 5A: eine perspektivische Darstellung einer ersten Ausführungsform der Aufnahmeplatte einer erfindungsgemäßen Behandlungsvorrichtung,
- Fig. 5B: einen schematischen Querschnitt durch die erste Ausführungsform der Aufnahmeplatte entlang der Linie D-D'-D" aus Fig. 5A,
- Fig. 5C: einen schematischen Querschnitt durch die erste Ausführungsform der Aufnahmeplatte entlang der Linie D-D'-D" aus Fig. 5A mit aufliegendem Substratträger und Substrat,
- Fig. 5D: einen schematischen Querschnitt durch die erste Ausführungsform der Aufnahmeplatte entlang der Linie E-E' aus Fig. 5A mit aufliegendem Substratträger und Substrat,
- Fig. 6: einen schematischen Querschnitt durch eine Ausführungsform der Aufnahmeplatte einer erfindungsgemäßen Behandlungsvorrichtung und eine Ausführungsform des erfindungsgemäßen Substratträgers, bei denen eine kapazitive Kopplung zwischen der Aufnahmeplatte bzw. dem Substratträger und dem Substrat realisiert wird,
- Fig. 7A: einen schematischen Querschnitt durch eine zweite Ausführungsform der Aufnahmeplatte einer erfindungsgemäßen Behandlungsvorrichtung, wobei die Vertiefung in der Aufnahmeplatte nur vereinfacht dargestellt ist,
- Fig. 7B: einen schematischen Querschnitt durch eine dritte Ausführungsform der Aufnahmeplatte einer erfindungsgemäßen Behandlungsvorrichtung, wobei die Vertiefung in der Aufnahmeplatte nur vereinfacht dargestellt ist,
- Fig. 8A: eine schematische Darstellung einer erfindungsgemäßen Behandlungsvorrichtung mit mehreren als Plasmaelektroden ausgebildeten Aufnahmeplatten,
- Fig. 8B: eine schematische Darstellung einer erfindungsgemäßen Behandlungsvorrichtung mit mehreren Aufnahmeplatten, die als Kombination aus Gasverteiler und Substratheizer für CVD-Anwendungen ausgebildet sind,
- Fig. 9: eine schematische Darstellung einer Ausführungsform des erfindungsgemäßen Verfahrens zum Prozessieren eines Substrates in einer Behandlungsanlage unter Nutzung einer erfindungsgemäßen Vorrichtung zum Transport eines Substrates,
- Fig. 10A: eine schematische Darstellung einer ersten Ausführungsform des Ablaufs der Bewegungen entsprechend des erfindungsgemäßen Verfahrens zum Prozessieren eines Substrates,
- Fig. 10B: eine schematische Darstellung einer zweiten Ausführungsform des Ablaufs der Bewegungen entsprechend des erfindungsgemäßen Verfahrens zum Prozessieren eines Substrates,
- Fig. 10C: eine schematische Darstellung einer dritten Ausführungsform des Ablaufs der Bewegungen entsprechend des erfindungsgemäßen Verfahrens zum Prozessieren eines Substrates,
- Fig. 11: eine schematische Draufsicht auf eine Ausführungsform der erfindungsgemäßen Behandlungsanlage,
- Fig. 12A: eine schematische Draufsicht auf eine Behandlungskammer mit einer Behandlungsvorrichtung und einer Vorrichtung zum Transport eines Substrates mit mehreren Einheiten von Substratträgern,
- Fig. 12B: eine schematische Draufsicht auf eine Behandlungskammer mit drei Behandlungsvorrichtungen und einer Vorrichtung zum Transport eines Substrates mit mehreren Einheiten von Substratträgern und
- Fig. 13: einen schematischen Querschnitt durch eine erfindungsgemäße Vorrichtung zum Transport eines Substrates und einer Bewegungsvorrichtung zum Bewegen der erfindungsgemäßen Vorrichtung zum Transport eines Substrates entlang der Linie F-F' aus Fig. 11.

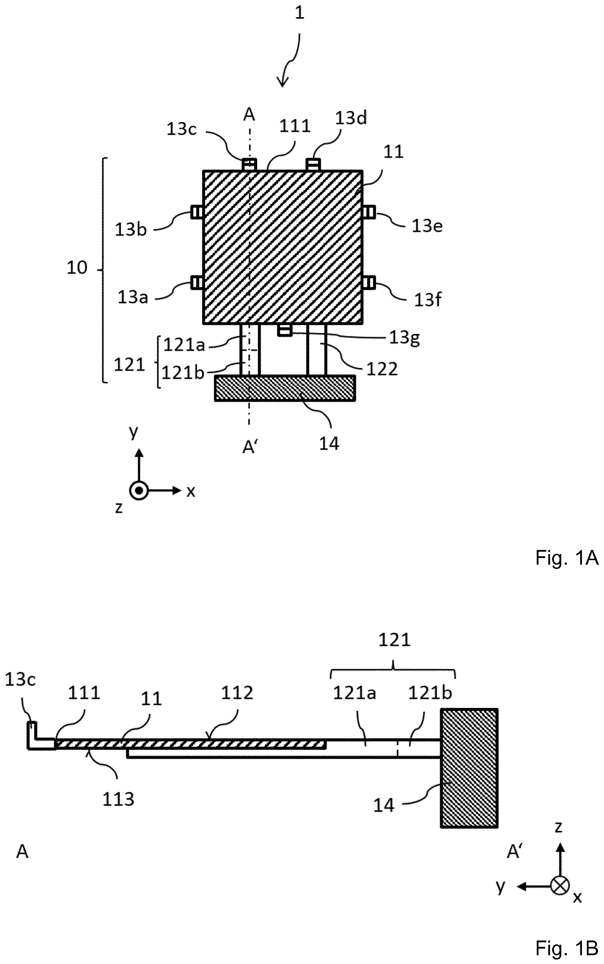

Figur 1A zeigt eine schematische Draufsicht auf eine erfindungsgemäße Vorrichtung 1 zum Transport eines Substrates in einer ersten Ausführungsform mit einem Substratträger 10 in einer ersten Ausführungsform. Die Vorrichtung 1 zum Transport eines Substrates umfasst den Substratträger 10 und eine Trägeranordnung 14. Der Substratträger 10 enthält eine Haltefläche 11, zwei Greifarme 121 und 122 sowie sieben Haltevorrichtungen 13a bis 13g.

Die Haltefläche 11 erstreckt sich in einer horizontalen Ebene, die durch eine erste horizontale Richtung entlang der x-Achse und eine zweite horizontale Richtung entlang der y-Achse aufgespannt wird, wobei die erste und die zweite horizontale Richtung senkrecht aufeinander stehen. Die Haltefläche 11 hat eine viereckige Form und ist als geschlossener Körper, d.h. ohne Vertiefungen, Löcher oder herausragende Teile, ausgebildet. Als Material für die Haltefläche 11 sich alle Materialien, die den notwendigen Anforderungen zum Tragen eines auf der Haltefläche 11 aufliegenden Substrates sowie ggf. zum elektrischen und thermischen Kontaktieren des Substrates und den Prozessbedingungen einer Behandlung des Substrates genügen, einsetzbar. Bspw. besteht die Haltefläche 11 aus Aluminium, Graphit, Kupfer, Silizium oder Siliziumcarbid oder aus Schichtfolgen von mehreren dieser Stoffe. Erreicht die Haltefläche 11 im Laufe eines Behandlungsprozesses eine Temperatur größer oder gleich 400°C, so besteht die Haltefläche 11 aus einem oder mehreren entsprechend temperaturstabilen Materialien, wie bspw. Keramik oder Quarzglas, oder aus Schichtfolgen daraus und anderen Materialien. Vorzugsweise ist die Haltefläche 11 in ihrer Gesamtheit aus nur einem Material geformt.

Die Greifarme 121 und 122 sind mit der Haltefläche 11 verbunden und bestehen vorzugsweise aus demselben Material wie die Haltefläche 11, können aber auch verschiedene Bereiche aufweisen, die unterschiedliche Materialien enthalten. Dies ist beispielhaft für den Greifarm 121 dargestellt. Dieser weist einen ersten Bereich 121a, der an die Haltefläche 11 angrenzt und aus demselben Material wie die Haltefläche 11 besteht, und einen zweiten Bereich 121b auf, der an einem seiner Enden an den ersten Bereich 121a und an seinem anderen Ende an die Trägeranordnung 14 angrenzt. Der zweite Bereich 121b besteht aus einem anderen Material als der erste Bereich 121a. Bspw. ist der erste Bereich 121a aus einem elektrisch leitenden Material, wie z.B. Aluminium, hergestellt, während der zweite Bereich 121b aus einem elektrisch isolierenden Material, wie z.B. Keramik, hergestellt ist. Damit isoliert der zweite Bereich 121b den ersten Bereich 121a und die Haltefläche 11 elektrisch von der Trägeranordnung 14. Die Greifarme 121, 122 ragen in der Draufsicht über die Haltefläche 11 hinaus und ermöglichen so die Verbindung der Haltefläche 11 zur Trägeranordnung 14, welche mit einem Manipulator zur Bewegung des Substratträgers 10 verbunden werden kann. Die Greifarme 121, 122 sind vorzugsweise gleichartig ausgebildet. Selbstverständlich ist auch bei der Wahl des Materials der einzelnen Bereiche der Greifarme 121, 122 die notwendige Temperaturbeständigkeit einzubeziehen, wie dies mit Bezug auf die Haltefläche 11 beschrieben ist.

Die Haltevorrichtungen 13a bis 13g dienen der Sicherung eines auf der Haltefläche 11 aufliegenden Substrates gegen das laterale Verschieben, z.B. ein Verrutschen oder Verdrehen, des Substrates auf der Haltefläche 11 während einer Bewegung des Substratträgers 10. Sie bestehen vorzugsweise zumindest zum Teil aus demselben Material wie die Haltefläche 11 und sind mit der Haltefläche 11 verbunden. Dabei erstrecken sie sich von einem Rand 111 der Haltefläche aus in einer horizontaler Richtung, d.h. in der gleichen Ebene wie die Haltefläche 11, und in vertikaler Richtung, was in Fig. 1B erkennbar ist. Vorzugsweise sind alle Haltevorrichtungen 13a bis 13g gleichartig ausgebildet.

Die Greifarme 121, 122 und/oder die Haltevorrichtungen 13a bis 13g können mit der Haltefläche 11 mittels einer lösbaren oder nicht lösbaren, stoff- oder kraftschlüssigen Verbindung verbunden sein. Sie können z.B. geklebt oder geschweißt sein. Jedoch können die Greifarme 121, 122 und/oder die Haltevorrichtungen 13a bis 13g auch einstückig mit der Haltefläche 11, bspw. mittels Fräsen oder Ätzen aus einem gemeinsamen Ausgangsmaterialblock, ausgebildet sein.

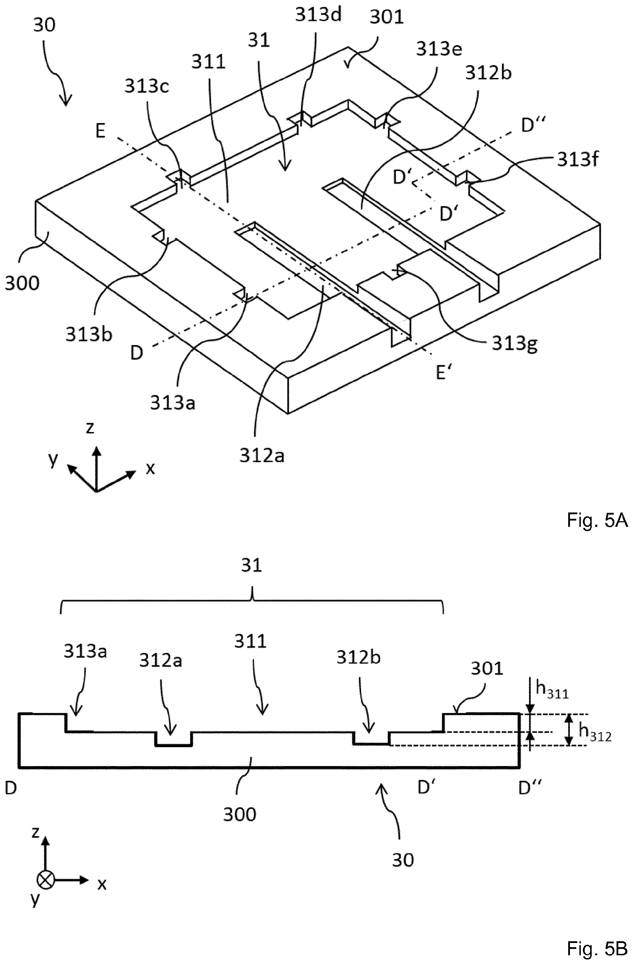

In Figur 1B ist ein schematischer Querschnitt durch die Vorrichtung 1 aus Fig. 1A entlang der Linie A-A', d.h. durch die Haltevorrichtung 13c, die Haltefläche 11, den Greifarm 121 und die Trägeranordnung 14, dargestellt. Die Haltefläche 11 hat eine erste Oberfläche 112, auf der ein zu behandelndes Substrat aufliegen kann, und eine zweite Oberfläche 113, die der ersten Oberfläche 112 gegenüberliegt. Die erste Oberfläche 112 und die zweite Oberfläche 113 verlaufen jeweils in einer horizontalen Ebene, die parallel zueinander sind. Vom vertikal verlaufenden Rand 111 aus erstreckt sich die Haltevorrichtung 13c zunächst in die zweite horizontale Richtung (y-Achse) von der Haltefläche 11 weg und danach in vertikale Richtung, d.h. entlang der z-Achse, so dass eine obere Oberfläche der Haltevorrichtung 13c in einer Ebene, die höher als die Ebene der ersten Oberfläche 112 angeordnet ist, liegt. Der Greifarm 121 ist teilweise auf der zweiten Oberfläche 113 der Haltefläche 11, also auf der Rückseite der Haltefläche 11, angeordnet und dort mit der Haltefläche 11 verbunden. Er erstreckt sich über die Haltefläche 11 hinaus und ragt damit in der zweiten horizontalen Richtung (y-Achse) über die Haltefläche 11 hinaus. Vorteilhafterweise umschließt der Greifarm 121 auch den Rand 111 der Haltefläche 11 in den lateralen Bereichen, in denen er über die Haltefläche 11 hinausragt. Weiterhin liegt die obere Oberfläche des Greifarms 121 in den Bereichen, in denen er über die Haltefläche 11 hinausragt, in der selben horizontalen Ebene wie die erste Oberfläche 112 der Haltefläche 11. Wie bereits mit Bezug auf Fig. 1A erwähnt, besteht der Greifarm 121 aus einem ersten Bereich 121a und einem zweiten Bereich 121b. Der erste Bereich 121a umfasst mindestens alle Bereiche des Greifarms, die in Kontakt mit der Haltefläche 11 stehen und erstreckt sich vorzugsweise noch bis in einigen Abstand vom Rand 111 der Haltefläche 11 in horizontaler Richtung, d.h. entlang der y-Achse. Dieser Abstand, der die Grenze zwischen dem ersten und dem zweiten Bereich 121a, 121b beschreibt, entspricht vorzugsweise genau dem Abstand zwischen einem Randbereich einer Vertiefung in einer Aufnahmeplatte einer Behandlungsvorrichtung, in der ein auf der Haltefläche 11 aufliegendes Substrat behandelt wird, wobei die Haltefläche 11 des Substratträgers 10 in die Vertiefung eingelegt wird, und dem äußeren Rand der Aufnahmeplatte. Dies wird später mit Bezug auf die Figuren 5A bis 5D und die erfindungsgemäße Behandlungsvorrichtung näher erläutert.

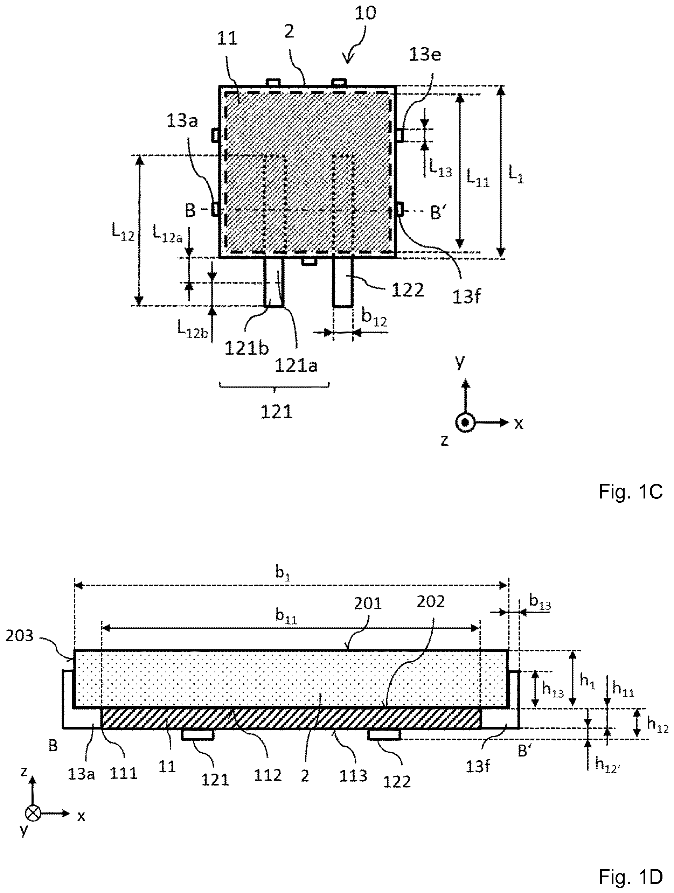

Mit Bezug auf die Figuren 1C und 1D wird die Ausgestaltung des Substratträgers 10 in Bezug auf ein darauf aufliegendes Substrat 2 näher erläutert. Figur 1C zeigt eine schematische Draufsicht auf den Substratträger 10 der Fig. 1A mit dem darauf aufliegenden Substrat 2. Wie zu erkennen ist, hat das Substrat 2 eine rechteckige Form, der die Form der Haltefläche 11 entspricht, wobei die Haltefläche 11 in ihrer lateralen Ausdehnung, d.h. in ihrer Fläche, minimal kleiner als das Substrat 2 ist. Das Substrat 2 weist eine Länge L₁ entlang der zweiten horizontalen Richtung (y-Achse) auf, während die Haltefläche 11 eine Länge L₁₁ entlang der zweiten horizontalen Richtung aufweist, die minimal kleiner als die Länge L₁ ist. Prinzipiell kann die Länge L₁₁ auch gleich der Länge L₁ oder minimal größer als diese sein. Die Greifarme 121, 122 weisen eine Breite b₁₂ entlang der ersten horizontalen Richtung (x-Achse) und eine gesamte Länge L₁₂ entlang der zweiten horizontalen Richtung (y-Achse) auf. Die Breite b₁₂ ist dabei über die gesamte Länge des Greifarms 121, 122 gleich, kann aber in anderen Ausführungsformen auch über die Länge des Greifarms variieren. Der erste Bereich 121a weist eine über die Haltefläche 11 hinausragende Länge L₁₂ₐ auf, die einer Länge eines Randbereiches einer Aufnahmeplatte, wie sie später mit Bezug auf die erfindungsgemäße Behandlungsvorrichtung beschrieben wird, entspricht. Der zweite Bereich 121b weist eine Länge L_{12b} auf. Die Haltevorrichtungen 13a bis 13g, von denen in Fig. 1C nur die Haltevorrichtungen 13a, 13e und 13f bezeichnet sind, weisen eine Länge L₁₃ auf, die wesentlich kleiner als die Länge L₁ des Substrates 2 ist. Die Länge L₁₃ wird dabei für jede Haltevorrichtung 13a bis 13g entlang derjenigen Kante des Substrates 2 gemessen, an die die jeweilige Haltevorrichtung 13a bis 13g angrenzt. Das heißt, die Länge L₁₃ einer Haltevorrichtung 13a bis 13g ist nicht immer als die Ausdehnung der jeweiligen Haltevorrichtung entlang der zweiten horizontalen Richtung (y-Achse) definiert, wie dies für die Haltevorrichtung 13e in Fig. 1C dargestellt ist, sondern ist als die Ausdehnung der Haltevorrichtung entlang der ersten horizontalen Richtung (x-Achse) definiert, wenn die entsprechende Haltevorrichtung eine Kante des Substrates 2, die entlang der ersten horizontalen Richtung verläuft, hält.

Fig. 1D zeigt einen schematischen Querschnitt durch den Substratträger 10 der Fig. 1C mit dem darauf aufliegendem Substrat 2 entlang der Linie B-B' aus Fig. 1C. Das Substrat 2 weist eine Breite b₁ entlang der ersten horizontalen Richtung (x-Achse) auf, während die Haltefläche 11 eine Breite b₁₁ entlang der ersten horizontalen Richtung aufweist, die minimal kleiner als die Breite b₁ ist. Prinzipiell kann die Breite b₁₁ auch gleich der Breite b₁ oder minimal größer als diese sein. Das Substrat 2 weist eine erste Oberfläche 201, welche die zu bearbeitende Substratoberfläche ist, und eine zweite Oberfläche 202, die der ersten Oberfläche 201 gegenüberliegt, sowie einen Rand 203 auf, der die erste Oberfläche 201 und die zweite Oberfläche 202 vertikal (entlang der z-Achse) verbindet. Das Substrat 2 liegt mindestens mit einem Teil seiner zweiten Oberfläche 202 auf der ersten Oberfläche 112 der Haltefläche 11 auf. Der Rand 203 des Substrates 2 hat eine Höhe h₁ entlang der vertikalen Richtung (z-Achse), wobei andere Bereiche des Substrates 2 andere Höhen aufweisen können. Die Haltefläche 11 hat eine Höhe h₁₁, die vorzugsweise über die gesamte laterale Ausdehnung der Haltefläche 11 gleich ist. Die Greifarme 121, 122 weisen in dem Bereich, in dem sie die zweite Oberfläche 113 der Haltefläche 11 kontaktieren, eine Höhe h_{12'} und in anderen Bereichen eine Höhe h₁₂ auf, die der Summe aus der Höhe h_{12'} und der Höhe h₁₁ der Haltefläche 11 entspricht. Die Höhe h_{12'} sowie die Höhe h₁₂ sind dabei über die gesamte Ausdehnung der entsprechenden Bereiche des Greifarms 121, 122 gleich, kann aber in anderen Ausführungsformen auch innerhalb des entsprechenden Bereichs variieren. Die Haltevorrichtungen 13a bis 13g, von denen in Fig. 1D nur die Haltevorrichtungen 13a und 13f zu sehen sind, weisen eine Höhe h₁₃ gemessen von der ersten Oberfläche 112 der Haltefläche 11 auf, die größer als Null und vorzugsweise kleiner als die Höhe h₁ des Substrates 2 ist. Wie im ersten Ausführungsbeispiel der Figuren 1A bis 1D dargestellt, können sich die Haltevorrichtungen 13a bis 13g vom Rand 111 der Haltefläche 11 aus erstrecken, so dass ihre Unterseite jeweils auf einer Höhe mit der zweiten Oberfläche 113 der Haltefläche 11 liegt. Jedoch können die Haltevorrichtungen 13a bis 13g auch an die zweite Oberfläche 113 der Haltefläche 11 angrenzen, so wie dies für die Greifarme 121, 122 beschrieben ist, oder können sich von der ersten Oberfläche 112 der Haltefläche 11 aus in vertikaler Richtung nach oben erstrecken, wenn die Länge L₁₁ und Breite b₁₁ der Haltefläche 11 größer als die Länge L₁ bzw. die Breite b₁ des Substrates 2 sind. Die Haltevorrichtungen 13a bis 13g weisen eine Breite b₁₃ auf, die wesentlich kleiner als die Breite b₁ des Substrates 2 ist. Dabei wird für jede Haltevorrichtung 13a bis 13g die Breite b₁₃ entlang einer Richtung, die orthogonal auf der Kante des Substrates 2, an die die jeweilige Haltevorrichtung 13a bis 13g angrenzt, steht, gemessen. Das heißt, die Breite b₁₃ einer Haltevorrichtung 13a bis 13g ist nicht immer als die Ausdehnung der jeweiligen Haltevorrichtung entlang der ersten horizontalen Richtung (x-Achse) definiert, wie dies für die Haltevorrichtung 13f in Fig. 1D dargestellt ist, sondern ist als die Ausdehnung der Haltevorrichtung entlang der zweiten horizontalen Richtung (y-Achse) definiert, wenn die entsprechende Haltevorrichtung eine Kante des Substrates 2, die entlang der ersten horizontalen Richtung verläuft, hält. Die Breite b₁₃, die Höhe h₁₃ sowie die Länge L₁₃ der Haltevorrichtung 13a bis 13g bestimmen eine Oberfläche der Haltevorrichtung 13a bis 13g, die während der Behandlung des Substrates 2 in einer Behandlungsvorrichtung ebenfalls einer Behandlung, insbesondere einer Umgebungsatmosphäre in der Behandlungsvorrichtung, ausgesetzt sind und damit ebenfalls beschichtet, dotiert oder anderweitig kontaminiert werden können. Daher sind diese Abmessungen vorzugsweise so klein, wie es zur Erfüllung ihrer Haltefunktion unbedingt notwendig ist, damit die kontaminierte Oberfläche so klein wie möglich gehalten wird.

Die Abmessungen der Haltefläche 11, der Greifarme 121, 122 und der Haltevorrichtungen 13a bis 13g sind so bemessen, dass eine sichere Handhabung des Substratträgers 10 und des Substrates 2 im Ganzen gewährleistet ist. Die Abmessungen der Greifarme 121, 122 und ihrer Bereiche sowie die Abmessungen der Haltevorrichtungen 13a bis 13g sind vorzugsweise gleich für alle Greifarme bzw. Haltevorrichtungen, können aber auch für einige oder jeden Greifarm bzw. einige oder alle Haltevorrichtungen verschieden sein.

Beispielhafte Abmessungen für die Bestandteile des Substratträgers 10 und ein Substrat 2 sind in der folgenden Tabelle 1 gegeben.

**Tabelle 1**

| Element | Länge | Breite | Höhe |
|---|---|---|---|
| Substrat 2 | L₁ = 156 mm | b₁ = 156 mm | h₁ = 0,2 mm |
| Haltefläche 11 | L₁₁ = 150 mm | b₁₁ = 150 mm | h₁₁ = 1 mm |
| Greifarm 121, 122 | L₁₂ = 70 mm | b₁₂ = 10 mm | h₁₂ = 3 mm |
| | L₁₂ₐ = 20 mm | | h_{12'} = 2 mm |
| | L_{12b} = 20 mm | | |
| Haltevorrichtung 13a bis 13g | L₁₃ = 10 mm | b₁₃ = 1mm | h₁₃ = 0,5 mm |

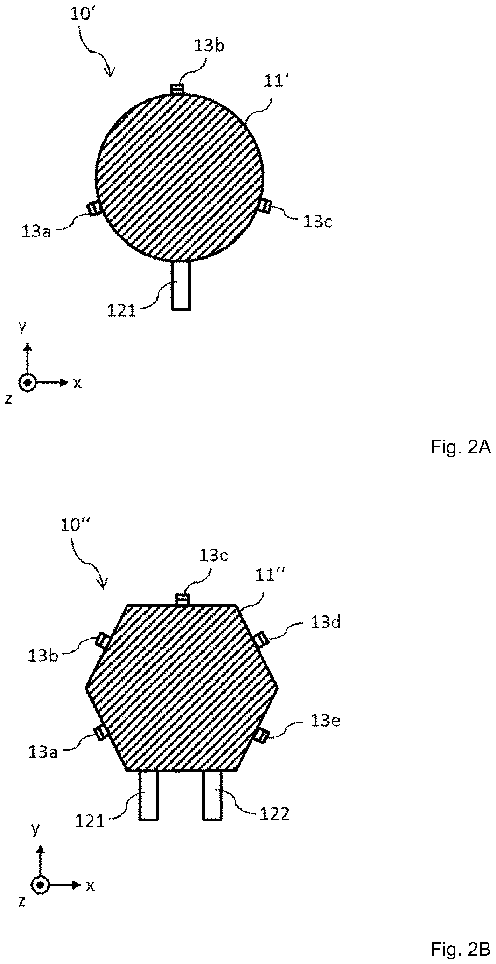

Die Figuren 2A und 2B zeigen eine schematische Draufsicht auf eine zweite bzw. eine dritte Ausführungsform des Substratträgers 10' bzw. 10", bei denen die Form der Haltefläche 11' bzw. 11" gegenüber der Form der Haltefläche 11 der ersten Ausführungsform des Substratträgers 10 aus den Figuren 1A bis 1D verschieden ist. So hat die Haltefläche 11' des Substratträgers 10' eine kreisrunde Form, die für den Transport eines runden Substrates optimiert ist, während die Haltefläche 11" des Substratträgers 10" eine regelmäßige sechseckige Form aufweist, die für ein Substrat mit einer entsprechenden Form optimiert ist. Es sind jedoch auch beliebige andere Formen der Haltefläche, wie bspw. ovale, dreieckige, achteckige oder unregelmäßige Formen, möglich, die jeweils an die Form des Substrates angepasst sind. Je nach Größe und Form eines Substrates, kann die Anzahl, die Abmessungen und die Anordnung der Greifarme angepasst werden. Beispielhaft sind in Fig. 2A ein Greifarm 121 und in Fig. 2B zwei Greifarme 121, 122 dargestellt. Die Anzahl, Form und Abmessungen der Haltevorrichtungen sind an die jeweilige Form der Haltefläche derart angepasst, dass ein laterales Verschieben, z.B. ein Verrutschen oder Verdrehen, eines Substrates auf der Haltefläche in eine beliebige horizontale Richtung vermieden wird. Beispielhaft sind in Fig. 2A drei Haltevorrichtungen 13a bis 13c und in Fig. 2B fünf Haltevorrichtungen 13a bis 13e dargestellt.

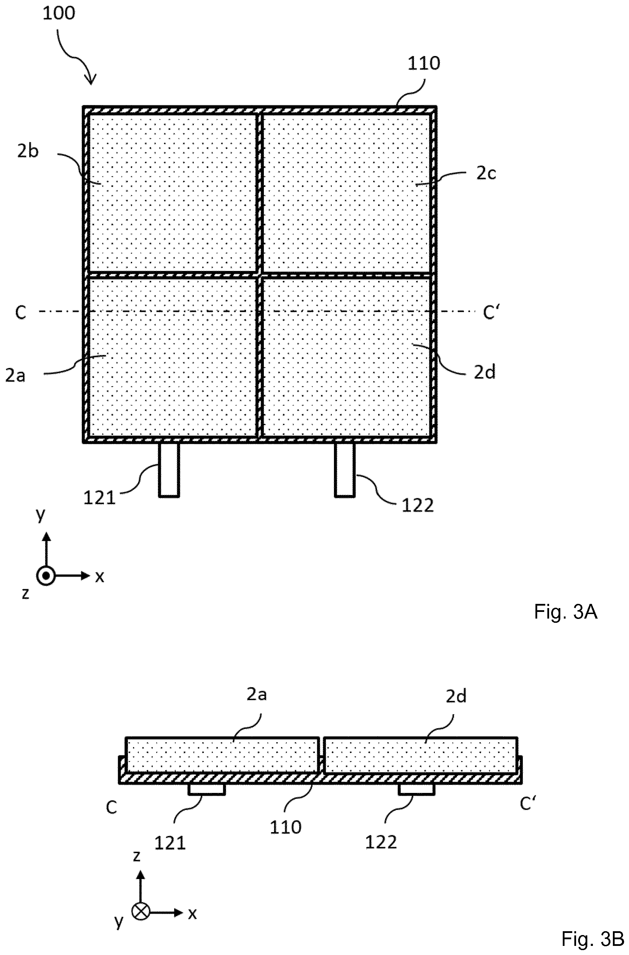

Während die bisher beschriebenen Ausführungsformen des Substratträgers nur zum Halten und Transportieren eines Substrates geeignet sind, kann der Substratträger auch mehrere Halteflächen aufweisen und damit zum gleichzeitigen Halten und Transportieren mehrerer Substrate geeignet sein. Dies wird mit Bezug auf die Figuren 3A bis 3C und eine vierte Ausführungsform des Substratträgers beschrieben. Fig. 3A zeigt eine schematische Draufsicht auf einen Substratträger 100 mit darauf aufliegenden Substraten 2a bis 2d, während Fig. 3B einen schematischen Querschnitt durch den Substratträger 100 entlang der Linie C-C' aus Fig. 3A zeigt. Die Substrate 2a bis 2d sind in einer Anordnung aus zwei Spalten und zwei Zeilen nebeneinander in einer horizontalen Ebene angeordnet, wobei jede beliebige laterale Anordnung von Substraten - optimiert auf die Form der Substrate - möglich ist, also bspw. auch eine Anordnung der Substrate in versetzter Form, in Wabenform oder in einer kreisförmigen Form. Jede Haltefläche hat eine Form und Größe entsprechend der Form des darauf gehaltenen Substrates, wobei die Halteflächen als Vertiefungen in einem Grundkörper 110 des Substratträgers 100 ausgebildet sind. Dabei sind die lateralen Abmessungen der Halteflächen so bemessen, dass das jeweilige Substrat vollständig auf der Haltefläche mit seiner Rückseite aufliegt. Die einzelnen Substrate 2a bis 2d sind von benachbarten Substraten 2a bis 2d sowie von einem Rand des Grundkörpers 100 durch sich vertikal erstreckende Bereiche des Grundkörpers 110 beabstandet. Der Substratträger 100 weist zwei Greifarme 121, 122 auf, die wie mit Bezug auf den Substratträger 10 der ersten Ausführungsform beschrieben angeordnet sind, wobei die Anzahl, Abmessungen und Anordnung der Greifarme an die Abmessungen des Grundkörpers 110 und das Gesamtgewicht des Substratträgers 100 mit aufliegenden Substraten 2a bis 2d angepasst ist.

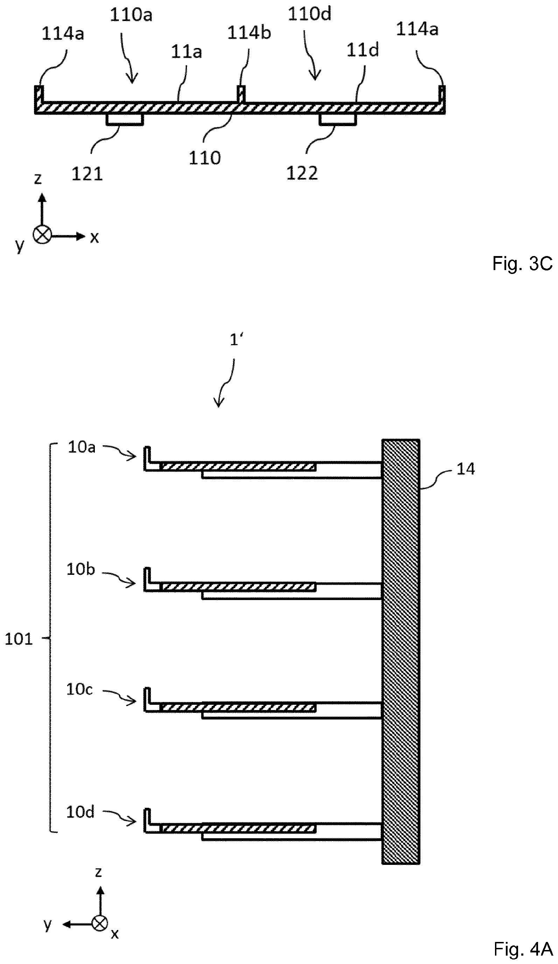

Figur 3C zeigt den in Fig. 3B dargestellten Querschnitt durch den Substratträger 100 ohne die aufliegenden Substrate. Im Grundkörper 110 sind Vertiefungen 110a und 110d ausgebildet, deren Grundfläche jeweils eine Haltefläche 11a bzw. 11d für die Aufnahme eines Substrates bildet. Die Vertiefungen werden durch seitlich Bereiche des Grundkörpers 110 begrenzt, die am äußeren Rand des Grundkörpers als seitlicher Rahmen 114a und zwischen den Vertiefungen 110a und 110d als Steg 114b ausgebildet ist. Der seitliche Rahmen 114a, der sich entlang des gesamten Randes des Grundkörpers 110 erstreckt, sowie der Steg 114b dienen als Haltevorrichtungen zur lateralen Sicherung des jeweiligen Substrates auf einer entsprechenden Haltefläche 11a bzw. 11d. Vorzugsweise sind der seitliche Rahmen sowie die zwischen verschiedenen Halteflächen ausgebildeten Stege durchgängig, d.h. ohne Unterbrechungen, ausgebildet. Jedoch ist es auch möglich, dass der seitliche Rahmen und die Stege nur als vereinzelte, voneinander lateral beabstandete Strukturen, die sich von dem Grundkörper 110 des Substratträgers in vertikale Richtung (z-Achse) nach oben erstrecken, ausgebildet sind.

Vorzugsweise ist die Höhe des seitlichen Rahmens 114a und der Stege 114b kleiner als die Höhe der Substrate, wobei die Höhen jeweils von der Haltefläche 11a, 11d aus in vertikale Richtung gemessen wird. Vorzugsweise sind alle Halteflächen 11a, 11d, alle Stege 114b und alle Bereiche des seitlichen Rahmens 114a gleichartig ausgebildet.

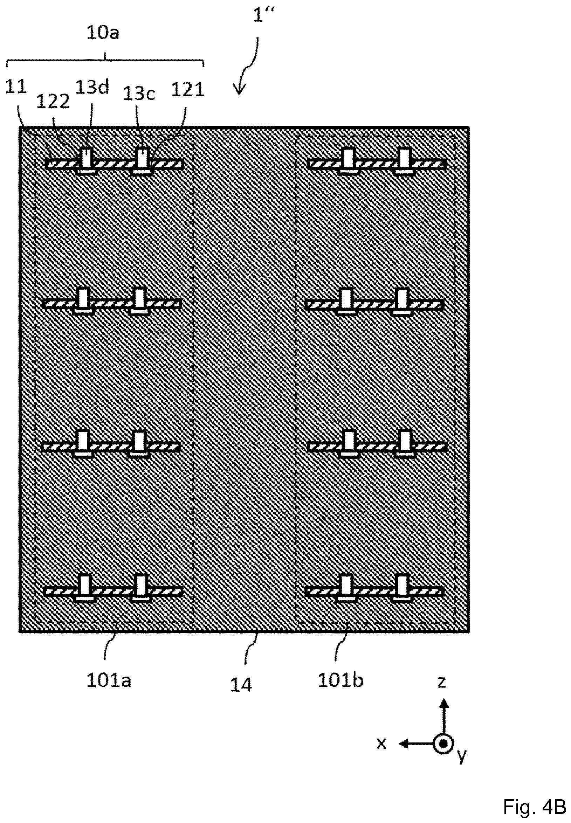

Mit Bezug auf die Figuren 4A und 4B werden weitere Ausführungsformen der erfindungsgemäßen Vorrichtung zum Transport eines Substrates erläutert. Dabei zeigt die Fig. 4A eine Seitenansicht einer erfindungsgemäßen Vorrichtung 1' zum Transport eines Substrates in einer zweiten Ausführungsform, die ebenfalls zum gleichzeitigen Halten und Transportieren mehrerer Substrate geeignet ist. Dabei weist die Vorrichtung 1' eine Einheit 101 von mehreren, übereinander angeordneten Substratträgern 10a bis 10d auf, wobei jeder Substratträger 10a bis 10d gemäß einer der mit Bezug auf die Figuren 1A bis 3C beschriebenen Ausführungsformen ausgestaltet sein kann. Vorzugsweise sind alle Substratträger 10a bis 10d gleichartig ausgestaltet und in vertikaler Richtung (entlang der z-Achse) deckungsgleich übereinander angeordnet, wobei jeder Substratträger 10a bis 10d zu einem benachbarten Substratträger 10a bis 10d denselben Abstand in vertikaler Richtung aufweist. Alle Substratträger 10a bis 10d sind an derselben Trägeranordnung 14 befestigt, die die gemeinsame Halterung und Bewegung der Substratträger 10a bis 10d realisiert.

Wird im Laufe eines Behandlungsprozesses eine Temperatur größer oder gleich 400°C, wie dies bspw. bei einem MOCVD-Prozess der Fall ist, erreicht, so besteht die Trägeranordnung 14 aus einem oder mehreren entsprechend temperaturstabilen Materialien, wie bspw. Keramik oder Quarzglas, oder aus Schichtfolgen daraus und anderen Materialien. Alternativ oder zusätzlich kann auch eine Anordnung zur Wärmeisolation auf der den Halteflächen der Substratträger 10a bis 10d zugewandten Oberfläche der Trägeranordnung 14 oder zwischen den Halteflächen der Substratträger 10a und 10d und der Trägeranordnung 14 angeordnet sein. Solch eine Anordnung zur Wärmeisolation kann bspw. ein oder mehrere Wärmeschutzbleche oder eine entsprechende Beschichtung aus Gold oder anderen wärmereflektierenden Schichten sein oder auch eine aktive Kühlung mittels Kühlfluiden enthalten.

Fig. 4B zeigt eine Vorderansicht einer erfindungsgemäßen Vorrichtung 1" zum Transport eines Substrates in einer dritten Ausführungsform. Die Vorrichtung 1" enthält zwei Einheiten 101a und 101b von übereinander angeordneten Substratträgern, wie sie mit Bezug auf Fig. 4A beschrieben sind. Jeder Substratträger ist bspw. als Substratträger, wie er mit Bezug auf die Figuren 1A bis 1D beschrieben wurde, ausgeführt und weist eine Haltefläche 11, einen oder mehrere Greifarme 121, 122 sowie Haltevorrichtungen, von denen hier die Haltevorrichtungen 13c und 13d aus Fig. 1A zu sehen sind, auf. Dies ist beispielhaft für einen Substratträger 10a dargestellt. Jedoch können auch andere Ausführungsformen des Substratträgers ausgebildet sein. Die Einheiten 101a, 101b sind entlang der ersten horizontalen Richtung (x-Achse) nebeneinander angeordnet und mit derselben Trägeranordnung 14 verbunden. Die Trägeranordnung 14 ist beispielsweise eine sich flächig parallel zur y-z-Ebene erstreckende viereckige, vorzugsweise rechteckige, Platte, an der die einzelnen Substratträger befestigt sind. Jedoch kann die Trägeranordnung 14 auch jede andere Form aufweisen, so lange die mechanische Stabilität aller Substratträger und die gemeinsame und gleichzeitige Bewegbarkeit aller Substratträger gewährleistet ist. So kann die Trägeranordnung bspw. auch eine unterbrochene Rahmenkonstruktion sein, die entsprechende Verstrebungen und Halterungen für die Substratträger aufweist. Die Anzahl von nebeneinander angeordneten und mit einer Trägeranordnung 14 verbundenen Einheiten 101 von vertikal übereinander angeordneten Substratträgern ist beliebig und nicht auf die hier dargestellten zwei Einheiten 101a und 101b begrenzt. Beispielsweise können bis zu zehn Einheiten 101 nebeneinander angeordnet sein.

Die vertikalen Abstände der einzelnen Substratträger 10a bis 10d in Fig. 4A zueinander entsprechen jeweils einem Abstand von einzelnen Aufnahmeplatten einer Behandlungsvorrichtung, wobei jeweils ein Substratträger auf einer der Aufnahmeplatten während einer Substratbehandlung positioniert ist. Der horizontale Abstand (entlang der x-Achse) der Einheiten 101a und 101b in Fig. 4B zueinander entspricht dem horizontalen Abstand von einzelnen Behandlungsvorrichtungen, die nebeneinander angeordnet sind, wobei Substrate, die auf Substratträgern der einen Einheit 101a aufliegen, in einer der Behandlungsvorrichtungen und Substrate, die auf Substratträgern der anderen Einheit 101b aufliegen, in der anderen Behandlungsvorrichtung zumindest teilweise gleichzeitig behandelt werden.

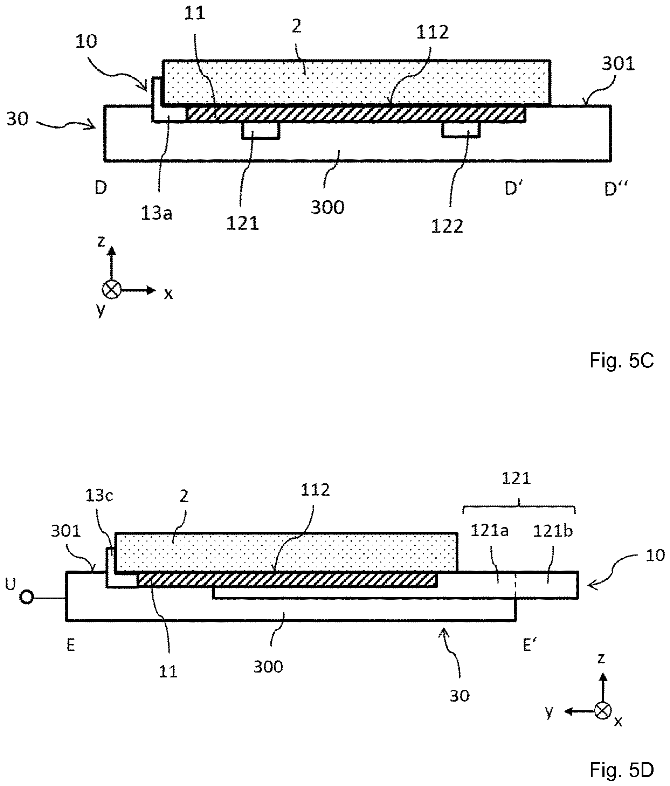

Mit Bezug auf die Figuren 5A bis 5D wird eine erste Ausführungsform einer Aufnahmeplatte einer erfindungsgemäßen Behandlungsvorrichtung erläutert. Dabei zeigen die Fig. 5A eine perspektivische Darstellung der Aufnahmeplatte 30, Fig. 5B einen schematischen Querschnitt durch die Aufnahmeplatte 30 entlang der Linie D-D'-D" aus Fig. 5A, Fig. 5C einen schematischen Querschnitt durch die Aufnahmeplatte 30 entlang der Linie D-D'-D" aus Fig. 5A und Fig. 5D einen schematischen Querschnitt durch die Aufnahmeplatte 30 entlang der Linie E-E' aus Fig. 5A, wobei in den Fig. 5C und 5D jeweils ein aufliegender Substratträger 10 und ein darauf angeordnetes Substrat 2 gezeigt sind.

Die Aufnahmeplatte 30 besteht aus einem Grundkörper 300 mit einer ersten Oberfläche 301, die sich in einer horizontalen Ebene (x-y-Ebene) erstreckt. In der ersten Oberfläche 301 ist eine Vertiefung 31 in der Aufnahmeplatte 30 ausgebildet, deren Form und Abmessungen geeignet sind, einen Substratträger der erfindungsgemäßen Vorrichtung zum Transport eines Substrates aufzunehmen. Damit weist die in den Fig. 5A bis 5D dargestellte Ausführungsform der Aufnahmeplatte 30, die an die in den Figuren 1A bis 1D dargestellte Ausführungsform des Substratträgers 10 angepasst ist, folgende Teilbereiche der Vertiefung 31 auf: eine Vertiefung 311 zur Aufnahme der Haltefläche des Substratträgers, Vertiefungen 312a und 312b zur Aufnahme der Greifarme des Substratträgers sowie Vertiefungen 313a bis 313g zur Aufnahme der Haltevorrichtungen des Substratträgers.

Wie in Fig. 5B zu sehen ist, erstrecken sich die Vertiefung 311 zur Aufnahme der Haltefläche und die Vertiefungen 313a bis 313g zur Aufnahme der Haltevorrichtungen, von denen in Fig. 5B nur die Vertiefung 313a zu sehen ist, bis zu einer Höhe h₃₁₁ von der ersten Oberfläche 301 in vertikaler Richtung, während sich die Vertiefungen 312a, 312b zur Aufnahme der Greifarme bis zu einer Höhe h₃₁₂ von der ersten Oberfläche 301 aus erstrecken. Die Differenz zwischen der Höhe h₃₁₂ und der Höhe h₃₁₁ entspricht dabei der Höhe h_{12'} der an die zweite Oberfläche der Haltefläche angrenzenden Bereiche der Greifarme, wie sie in Fig. 1D dargestellt ist. In dem in Fig. 5B dargestellten Querschnitt ist keine Abgrenzung zwischen der Vertiefung 313a zur Aufnahme einer Haltevorrichtung und der Vertiefung 311 zur Aufnahme der Haltefläche vorhanden, da beide Vertiefungen dieselbe Höhe h₃₁₁ aufweisen. Die gesamte Höhe der Aufnahmeplatte 300 beträgt bspw. 10 mm, während die Höhe h₃₁₁ bspw. 1 mm beträgt und der Höhe h₁₁ der Haltefläche des Substratträgers, wie in Fig. 1D dargestellt, entspricht. Da das aufliegende Substrat bspw. eine Höhe h₁ (dargestellt in Fig. 1D) von 0,2 mm, wie in Tabelle 1 angegeben, aufweist, ist eine schnelle Wärmeübertragung von der Aufnahmeplatte 300 auf den Substratträger und das Substrat gegeben, während sich die Temperatur der Aufnahmeplatte 300 selbst durch das Auflegen des Substratträgers kaum verändert.

Zu beachten ist, dass die lateralen Abmessungen sowie die Höhen der Vertiefungen 311, 312a, 312b und 313a bis 313g so bemessen sind, dass die Bestandteile des Substratträgers bei der gewünschten Temperatur der Aufnahmeplatte 30 während einer Substratbehandlung in die Vertiefungen der Aufnahmeplatte 30 ohne größeres Spiel aufgenommen werden können. Mit anderen Worten: Die Wärmeausdehnung der Aufnahmeplatte 30 und der Bestandteile des Substratträgers bei der gewünschten Temperatur der Aufnahmeplatte 30 während der Substratbehandlung, wobei der Substratträger in etwa die gleiche Temperatur aufweisen soll, ist bei der Definition der Abmessungen der Vertiefungen zu beachten. "Ohne größeres Spiel" bedeutet, dass zwischen einem bestimmten Bestandteil des Substratträgers und dem Rand einer entsprechenden Vertiefung in der Aufnahmeplatte 30 bei der Temperatur während der Substratbehandlung in lateraler Richtung, d.h. in einer horizontal verlaufenden Richtung, maximal ein Abstand von 0,5 mm vorliegt.

In Fig. 5C ist die Aufnahmeplatte 30 aus Fig. 5A mit einem darauf aufliegenden erfindungsgemäßen Substratträger 10 und einem darauf angeordneten Substrat 2 in demselben Querschnitt wie in Fig. 5B zu sehen. Wie zu sehen ist, füllen die Bestandteile des Substratträgers 10 die in Fig. 5B dargestellte Vertiefung 31 in der Aufnahmeplatte 30 vollständig auf, so dass im Wesentlichen kein Abstand zwischen dem Substratträger 10 und dem Grundkörper 300 der Aufnahmeplatte 30, auch nicht in einer horizontalen Richtung, vorliegt. Damit wird ein optimaler thermischer und elektrischer Kontakt zwischen der Aufnahmeplatte 30 und dem Substratträger 10 und damit auch zu dem Substrat 2 gewährleistet. Die Haltefläche 11 ist in der (in Fig. 5B dargestellten) Vertiefung 311, die Haltevorrichtungen 13a bis 13g, von denen in Fig. 5C nur die Haltevorrichtung 13a zu sehen ist, sind in den (in Fig. 5B dargestellten) Vertiefungen 313a bis 313g und die Greifarme 121 und 122 sind in den (in Fig. 5B dargestellten) Vertiefungen 312a und 312b vollständig aufgenommen, so dass die erste Oberfläche 112 der Haltefläche 11, die Auflageflächen der Haltevorrichtungen 13a bis 13g, auf denen das Substrat 2 aufliegt, und die erste Oberfläche 301 der Aufnahmeplatte 30 eine ebene, geschlossene Oberfläche bilden. Mit anderen Worten: Die Aufnahmeplatte 30 und der darin eingelegte Substratträger 10 bilden einen nahezu monolitischen Block, auf dem das Substrat 2 aufliegt und aus dem lediglich die Haltevorrichtungen 13a bis 13g in vertikaler Richtung herausragen. Damit liegt das Substrat 2 vollkommen eben und gleichförmig auf der ersten Oberfläche 112 der Haltefläche 11, den Haltevorrichtungen 13a bis 13g und der ersten Oberfläche 301 der Aufnahmeplatte 31 auf und kann homogen und ohne den Substratträger 10 großflächig zu kontaminieren behandelt werden.

Vorzugsweise besteht die Aufnahmeplatte 30 aus einem elektrisch leitfähigem Material, wie bspw. Aluminium oder Graphit, so dass der Substratträger 10 homogen mit einem definierten elektrischen Potential beaufschlagt werden kann. Jedoch kann die Aufnahmeplatte 30 auch nur in bestimmten Bereichen, bspw. in den Bereichen, die an den Substratträger 10 angrenzen, sowie im Bereich der ersten Oberfläche 301 aus einem elektrisch leitfähigen Material bestehen, während andere Bereiche aus einem elektrisch isolierendem Material bestehen können. Ebenfalls möglich ist auch die Verwendung eines oder mehrerer elektrisch isolierender Materialien für den gesamten Grundkörper 300 der Aufnahmeplatte 30, wenn keine Beaufschlagung des Substrats 2 mit einem definierten Potential erforderlich ist. Auch hier ist bei der Wahl der Materialien auf deren Temperaturstabilität in den während eines Behandlungsprozesses vorliegenden Temperaturen zu beachten.

Mit Bezug auf Fig. 5D soll noch einmal der Zusammenhang zwischen den verschiedenen Bereichen 121a und 121b der Greifarme 121 bzw. 122 des Substratträgers 10 und der Aufnahmeplatte 30 erläutert werden. Wie zu sehen ist, erstreckt sich der erste Bereich 121a des Greifarms 121 von der Haltefläche 11 bis genau zum Rand des Grundkörpers 300 entlang der zweiten horizontalen Richtung (y-Achse), in der sich der Greifarm 121 über die Haltefläche 11 und die Aufnahmeplatte 30 hinaus erstreckt. Im ersten Bereich 121a ist der Greifarm 121 vorzugsweise aus demselben Material wie der Grundkörper 300 der Aufnahmeplatte 30 geformt, so dass bspw. eine elektrische Spannung U, die von außen an den Grundkörper 300 der Aufnahmeplatte 30 angelegt wird, auch im ersten Bereich 121a des Greifarms anliegt. Damit sind auch in Bereichen, in denen nicht der Grundkörper 300 an derjenigen Oberfläche, die an einen Substratbehandlungsraum, bspw. einen Plasmaraum, angrenzt, vorliegt, die gleichen elektrischen Bedingungen gegeben, wie in Bereichen, in denen die erste Oberfläche 301 der Aufnahmeplatte diese Oberfläche bildet. Dies erhöht die Homogenität der Substratbehandlung. Im zweiten Bereich 121b, der sich über die Aufnahmeplatte 30 hinaus erstreckt, ist der Greifarm 121 vorzugsweise aus einem elektrisch isolierendem Material geformt, so dass die Aufnahmeplatte 30 und der Substratbehandlungsraum gegenüber anderen Elementen der Vorrichtung zum Transport eines Substrates, z.B. gegenüber der Trägeranordnung 14, die in Fig. 1A dargestellt ist, elektrisch isoliert ist.

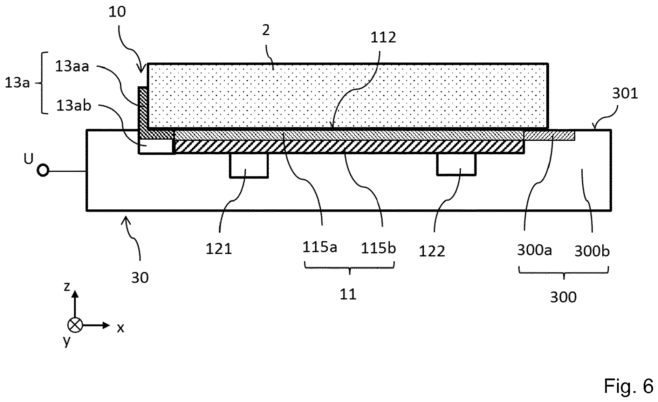

Die Ausgestaltungen der Aufnahmeplatte 30 und des Substratträgers 10, wie sie bisher beschrieben und dargestellt wurden, erlauben einen ohmschen Kontakt zwischen Aufnahmeplatte 30, Substratträger 10 und Substrat 2, wenn die einzelnen Komponenten selbst aus einem elektrisch leitfähigen Material bestehen. Mit Bezug auf die Fig. 6 wird eine Ausgestaltungsvariante der Komponenten beschrieben, die eine kapazitive Kopplung des Substrates 2 zu der Aufnahmeplatte 30 ermöglicht. Dabei kann der Grundkörper 300 wieder mit einer Spannung U von außen beaufschlagt werden. Jedoch ist der Substratträger 10 zumindest in Bereichen, die direkt an das Substrat 2 angrenzen, also in einem ersten Bereich 115a der Haltefläche 11 und in einem ersten Bereich 13aa der Haltevorrichtung 13a, die beispielhaft für alle Haltevorrichtungen 13a bis 13g dargestellt ist, sowie in ersten Bereichen der Greifarme 121, 122, die in direktem Kontakt mit dem Substrat 2 stehen, aus einem dielektrischen Material hergestellt. In anderen Bereichen, also in zweiten Bereichen 115b der Haltefläche 11 und in zweiten Bereichen 13ab der Haltevorrichtung 13a sowie in zweiten Bereichen der Greifarme 121, 122, ist der Substratträger 10 aus einem elektrisch leitenden Material hergestellt. Auch der Grundkörper 300 der Aufnahmeplatte 30 weist einen ersten Bereich 300a, in dem er an das Substrat 2 angrenzt, und einen zweiten Bereich 300b, in dem er nicht an das Substrat 2 angrenzt, auf, wobei sich der erste Bereich 300a auch noch über das Substrat 2 hinaus erstrecken kann, wie dies in Fig. 6 dargestellt ist. Der erste Bereich 300a besteht aus einem dielektrischen Material, vorzugsweise demselben dielektrischen Material wie die ersten Bereiche 115a der Haltefläche 11 und die ersten Bereiche 13aa der Haltevorrichtung 13a sowie die ersten Bereiche der Greifarme 121, 122, während der zweite Bereich 300b aus einem elektrisch leitenden Material, vorzugsweise demselben wie die zweiten Bereiche 115b der Haltefläche und die zweiten Bereiche 13ab der Haltevorrichtung 13a sowie die ersten Bereiche der Greifarme 121, 122, gebildet ist. Damit grenzt das Substrat 2 immer an ein dielektrisches Material an, so dass eine kapazitive Kopplung zwischen der Aufnahmeplatte 30 und dem Substrat 2 erreicht wird. Als dielektrisches Material kommt bspw. Aluminiumoxid, Siliziumoxid, Siliziumnitrid oder andere geeignete Materialien sowie Verbindungen oder Schichtaufbauten aus diesen Materialen zum Einsatz.

Neben der mechanischen Halterung des Substratträgers und des Substrates während der Substratbehandlung und ggf. der Beaufschlagung des Substrates mit einer definierten Spannung, wie sie in den Figuren 5D und 6 dargestellt ist, kann die Aufnahmeplatte auch weitere Funktionen erfüllen und dementsprechend ausgestaltet sein.

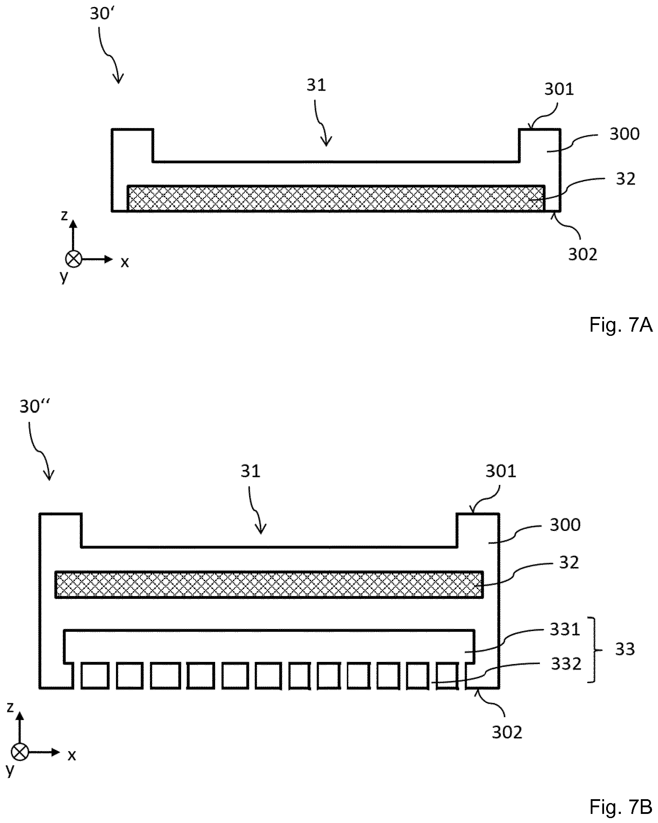

So ist die Aufnahmeplatte 30' in einer zweiten Ausführungsform mit einer Einrichtung 32 zum Temperieren der Aufnahmeplatte versehen, wie dies in Fig. 7A dargestellt ist. Die Einrichtung 32 kann eine Heiz- und/oder eine Kühleinrichtung sein und bspw. aus einem resistiven Heizer oder einem Fluidleitsystem, durch das Heiz- oder Kühlfluide strömen können, bestehen. Dabei kann die Einrichtung 32 im Grundkörper 300 der Aufnahmeplatte 30' angeordnet sein und an eine zweite Oberfläche 302 der Aufnahmeplatte 30' angrenzen, wie dies in Fig. 7A dargestellt ist, oder vollständig vom Grundkörper 300 umschlossen sein, wie dies in Fig. 7B dargestellt ist. Darüber hinaus ist es auch möglich, dass die Einrichtung nicht im Grundkörper 300, sondern nur angrenzend an die zweite Oberfläche 302 angeordnet ist. Die zweite Oberfläche 302 ist diejenige Oberfläche der Aufnahmeplatte 30', die der ersten Oberfläche 301, in der die Vertiefung 31 ausgebildet ist, gegenüberliegt. Werden beim Temperieren der Aufnahmeplatte 30' hohe Temperaturen, d.h. Temperaturen größer oder gleich 400°C, erreicht, so ist bei der Wahl der Materialien der Aufnahmeplatte 30' auf deren Temperaturbeständigkeit zu achten. Bspw. kann die Aufnahmeplatte 30' dann aus Keramik oder Quarzglas bestehen.

In einer dritten Ausführungsform ist die Aufnahmeplatte 30" nicht nur zum Temperieren der Aufnahmeplatte geeignet (wie mit Bezug auf Fig. 7A beschrieben), sondern weist darüber hinaus eine Einrichtung zum Zuführen eines oder mehrerer Gase auf. Dies ist vor allem für Behandlungsvorrichtungen, bei denen mehrere Aufnahmeplatten 30" vertikal übereinander angeordnet sind und bei denen die Substrate einer Behandlung unterzogen werden, bei der eine definierte Gaszusammensetzung in einem Behandlungsraum erforderlich ist, vorteilhaft. Die Einrichtung zum Zuführen eines oder mehrerer Prozessgase ist bspw. ein Gasverteiler 33, wie er in Fig. 7B dargestellt ist. Der Gasverteiler 33 weist dabei einen Gasvorratsraum 331, der bspw. von außen über eine Gasleitung mit Gas befüllt wird, und eine Vielzahl von Gaskanälen 332 auf, die eine Verbindung zwischen dem Gasvorratsraum 331 und der zweiten Oberfläche 302 der Aufnahmeplatte 30" bereitstellen. Damit kann ein Gas aus dem Gasvorratsraum 331 durch die Gaskanäle 332 in einen Substratbehandlungsraum, der in vertikaler Richtung unterhalb der Aufnahmeplatte 30" angeordnet und einem Substrat zugeordnet ist, welches auf einer anderen, in vertikaler Richtung unterhalb der Aufnahmeplatte 30" angeordneten Aufnahmeplatte positioniert ist, eingeführt werden.

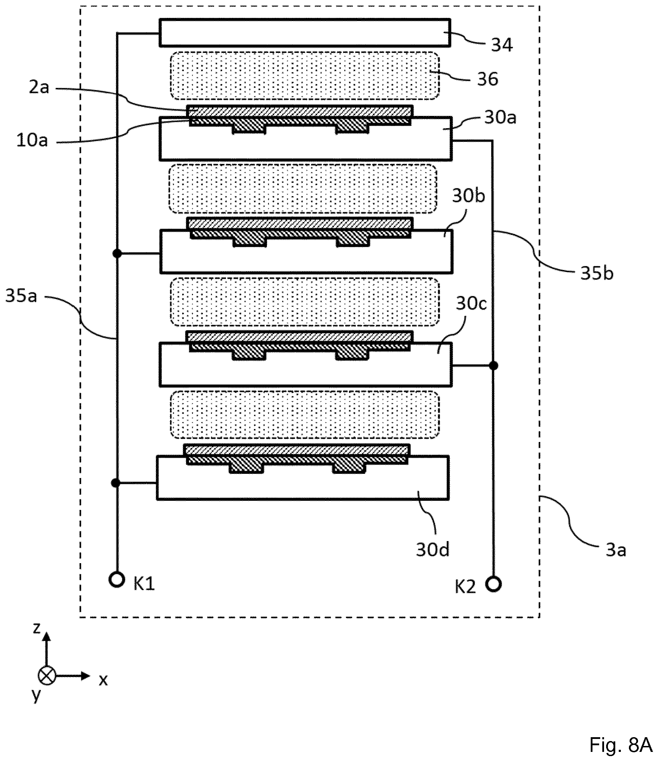

Figur 8A zeigt eine schematische Darstellung einer erfindungsgemäßen Behandlungsvorrichtung 3a mit mehreren als Plasmaelektroden ausgebildeten Aufnahmeplatten 30a bis 30d, die bspw. gemäß der mit Bezug auf die Fig. 5A bis 5D beschriebenen ersten Ausführungsform ausgestaltet sind. Dabei sind in die Aufnahmeplatten 30a bis 30d jeweils ein Substratträger mit einem darauf angeordneten Substrat eingelegt. Beispielhaft sind ein Substratträger 10a und ein Substrat 2a, die in die Aufnahmeplatte 30a eingelegt sind, bezeichnet. Jede Aufnahmeplatte 30a bis 30d ist eine Plasmaelektrode eines Plasmaelektrodenpaares. Die Behandlungsvorrichtung 3a enthält als oberste Plasmaelektrode, d.h. in vertikaler Richtung über allen anderen Plasmaelektroden angeordnete Plasmaelektrode, eine Topelektrode 34, die keine Vertiefung wie die anderen Plasmaelektroden, d.h. die Aufnahmeplatten 30a bis 30d, aufweist und nicht zur Aufnahme eines Substrates während der Substratbehandlung vorgesehen und geeignet ist. In einer solchen Anordnung von Plasmaelektroden, auch Elektrodeneinheit genannt, werden bis zu 200 Elektroden, die jeweils in einem typischen Abstand von 3 mm bis 30 mm parallel zueinander angeordnet sind, abwechselnd mit einer von mindestens zwei Spannungszuführungen 35a, 35b verbunden, von denen mindestens eine mit einem Generator einer Spannungsversorgung, die außerhalb der Plasmabehandlungsvorrichtung installiert ist, verbunden ist. Eine der mindestens zwei Spannungszuführungen kann auch auf Masse liegen. Die Verbindung der Spannungszuführungen 35a, 35b zu der Spannungsversorgung wird über Anschlussklemmen K1 und K2 hergestellt. Bei Anliegen einer entsprechenden Spannung zwischen den Plasmaelektroden eines Plasmaelektrodenpaares kann somit kapazitiv ein Plasma in einem Plasmaraum 36, der sich zwischen diesen Plasmaelektroden befindet, erzeugt werden. Mit Hilfe von in dem Plasma erzeugten oder befindlichen Komponenten kann das auf der jeweiligen Aufnahmeplatte 30a bis 30d, die die in vertikaler Richtung untere Plasmaelektrode des Plasmaelektrodenpaares bildet, aufliegende Substrat behandelt werden.

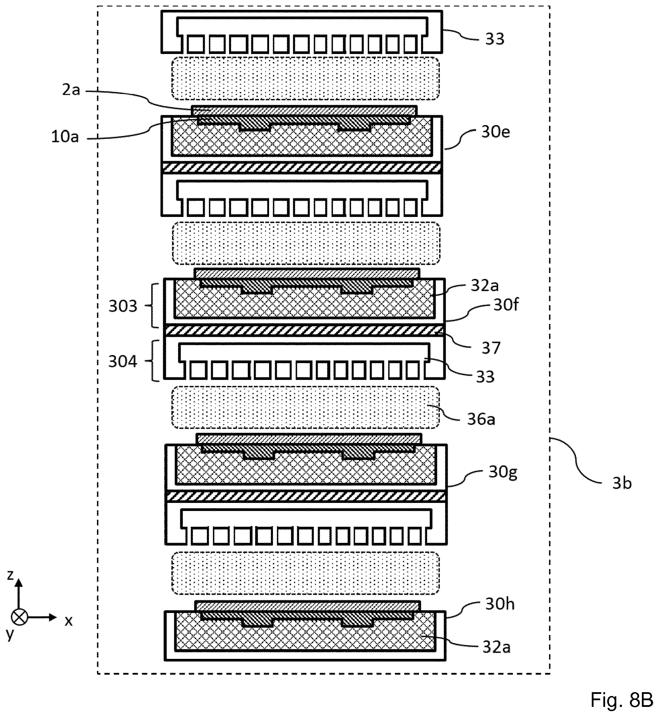

Fig 8B zeigt eine schematische Darstellung einer erfindungsgemäßen Behandlungsvorrichtung 3b mit mehreren Aufnahmeplatten 30e bis 30h, die die Ausführung von CVD-Prozessen in einer gestapelten Anordnung für Prozesstemperaturen bis 1000°C erlauben. Dabei sind in die Aufnahmeplatten 30e bis 30h jeweils ein Substratträger mit einem darauf angeordneten Substrat eingelegt. Beispielhaft sind ein Substratträger 10a und ein Substrat 2a, die in die Aufnahmeplatte 30e eingelegt sind, bezeichnet. Die Aufnahmeplatten 30e bis 30g sind, ähnlich wie die in Fig. 7B dargestellte Aufnahmeplatte 30", zweigeteilt ausgeführt und bestehen in einer oberen Hälfte 303 aus einem geeigneten Heizer 32a (z.B. einem elektrischen Widerstandsheizer), in den der Substratträger mit gutem Wärmekontakt eingelegt werden kann. Eine untere Hälfte 304 jeder Aufnahmeplatte 30e bis 30g stellt einen Gasverteiler 33 (ähnlich zu Fig. 7b) dar, der einen Prozessraum 36a darunter mit Prozessgas versorgt. Zwischen dem Heizer 32a und dem Gasverteiler 33 befindet sich noch eine Anordnung 37 zur Wärmeisolation, die den Wärmeabfluss vom Heizer 32a zum Gasverteiler 33 verhindert oder zumindest stark reduziert. Die Anordnung 37 zur Wärmeisolation kann z.B. aus mehreren Wärmeschutzblechen bestehen. Der obere Bereich 303 wird auf eine erste Temperatur aufgeheizt, die der gewünschten Temperatur des Substrats und des Substratträgers entspricht, z.B. 400°C bis 1000°C. Der untere Bereich 304 mit dem Gasverteiler 33 wird auf einer deutlich niedrigeren zweiten Temperatur als das Substrat und der Substratträger gehalten, was z.B. durch interne Kühlung mit Kühlwasser erfolgen kann. Der CVD-Prozess kann bei Atmosphärendruck oder im Vakuum bei typischen Drücken zwischen 1 mbar (100 Pa) bis 300 mbar (30 kPa) erfolgen. Durch die aus dem Gasverteiler 33 in Richtung des darunter angeordneten Substrats strömenden Prozessgase wird aufgrund deren thermischer Zersetzung an der heißen Substratoberfläche ein CVD-Schichtbildung auf dem Substrat erreicht. Der Gasverteiler 33 wird dagegen wenig oder nicht beschichtet.

Selbstverständlich können auch separate, d.h. von der Aufnahmeplatte getrennt ausgebildete, Gasverteiler und entsprechende Aufnahmeplatten alternierend angeordnet sein. Wie in Fig. 8B dargestellt, kann eine in vertikaler Richtung oberste Aufnahmeplatte durch einen separaten Gasverteiler 33 ersetzt sein. Die in vertikaler Richtung unterste Aufnahmeplatte 33h kann demgegenüber nur den Heizer 32a, wie in Fig. 8B dargestellt, oder nur den Heizer 32a und die Anordnung 37 zur Wärmeisolation aufweisen, nicht jedoch den Gasverteiler 33. Jedoch können auch alle Aufnahmeplatten gleichartig ausgestaltet sein.

Des Weiteren kann eine erfindungsgemäße Behandlungsvorrichtung jede Behandlungsvorrichtung, die eine erfindungsgemäße Aufnahmeplatte enthält und zur Behandlung eines Substrates geeignet ist, sein. Beispielsweise kann eine solche Behandlungsvorrichtung eine Temperiereinrichtung sein, in der ein Substrat für eine definierte Zeit einer definierten Umgebungsatmosphäre bei einer definierten Temperatur ausgesetzt wird.

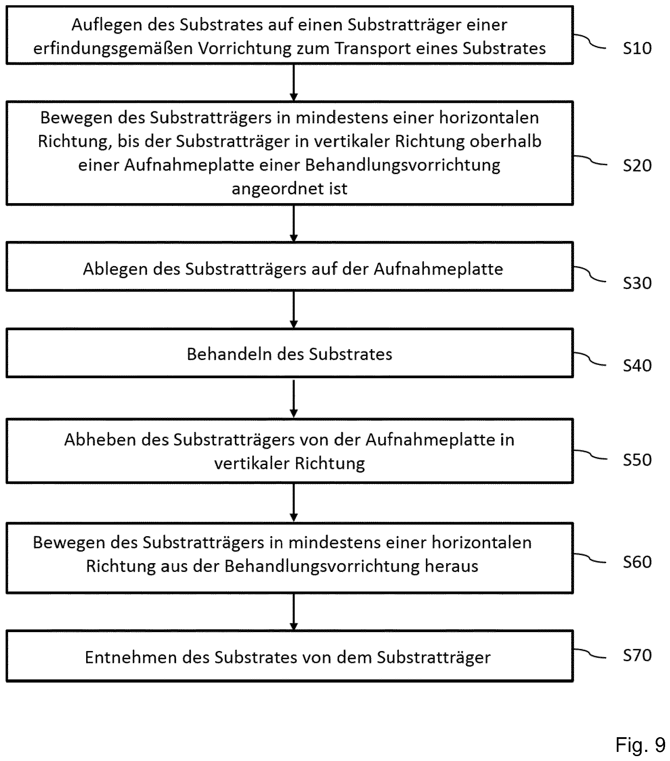

Mit Bezug auf die Figur 9 wird das erfindungsgemäße Verfahren zum Prozessieren eines Substrates erläutert. Zunächst wird in einem ersten Schritt S10 ein Substrat mit aus dem Stand der Technik bekannten Mitteln auf einen Substratträger einer erfindungsgemäßen Vorrichtung zum Transport eines Substrates aufgelegt. Nachfolgend wird der Substratträger in mindestens einer horizontalen Richtung in eine Behandlungsvorrichtung, die eine Aufnahmeplatte, auf der das Substrat während der Behandlung gehaltert wird, aufweist, hinein bewegt, bis sich der Substratträger in vertikaler Richtung genau oberhalb einer Aufnahmeplatte der Behandlungsvorrichtung befindet (Schritt S20). Anschließend wird der Substratträger auf der Aufnahmeplatte abgelegt, wozu der Substratträger in vertikaler Richtung nach unten bewegt wird, bis der Substratträger aufliegt (Schritt S30). In einem nächsten Schritt S40 wird das Substrat, welches mit dem Substratträger auf der Aufnahmeplatte aufliegt, wie gewünscht behandelt. Nach Beendigung der Substratbehandlung wird der Substratträger durch eine in vertikaler Richtung nach oben gerichtete Bewegung des Substratträgers von der Aufnahmeplatte abgehoben (Schritt S50) und anschließend in mindestens einer horizontalen Richtung aus der Behandlungsvorrichtung heraus bewegt (Schritt S60). Zuletzt wird das Substrat mit aus dem Stand der Technik bekannten Mitteln von dem Substratträger entnommen (Schritt S70) und kann einer weiteren Prozessierung zugeführt werden.

Die Schritte S20 und S30 sowie die Schritte S50 und S60 können sich zeitlich zum Teil überlagern, bspw. wenn eine kombinierte vertikale und horizontale Bewegung des Substratträgers ausgeführt wird, z.B. eine schraubenförmige Bewegung. Dies ist jedoch nur dann möglich, wenn die Abmessungen der Behandlungsvorrichtung, insbesondere der vertikale Abstand zwischen der Aufnahmeplatte und einem in vertikaler Richtung darüber angeordneten Element der Behandlungsvorrichtung oder einer Behandlungsanlage, von der die Behandlungsvorrichtung ein Teil ist und innerhalb der die Behandlungsvorrichtung angeordnet ist, dies gestatten.

Darüber hinaus ist es möglich die Schritte S20 bis S60 mehrmals zu wiederholen, wobei der Substratträger jeweils in eine andere Behandlungsvorrichtung hinein- bzw. aus dieser heraus bewegt und das Substrat entsprechend behandelt wird. So kann beispielsweise in einer ersten Behandlungsvorrichtung eine Behandlung zur plasmachemischen Reinigung einer Substratoberfläche ausgeführt werden, während in einer zweiten Behandlungsvorrichtung eine Behandlung zur Abscheidung einer Schicht auf der Substratoberfläche ausgeführt wird. Dabei ist es möglich, das Substrat ohne eine Unterbrechung eines Vakuums, welches für die entsprechenden Behandlungen ggf. notwendig ist, von einer Behandlungsvorrichtung zur nächsten Behandlungsvorrichtung zu transportieren.

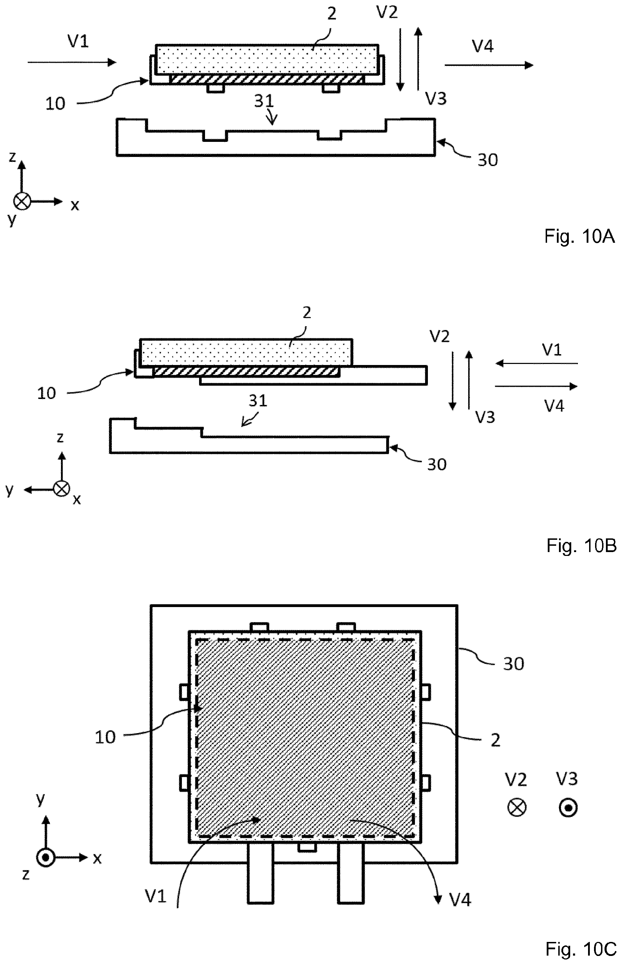

Anhand der Figuren 10A bis 10D werden Beispiele für die Bewegungen des Substratträgers in horizontaler und vertikaler Richtung dargestellt. Dabei zeigen die Fig. 10A und 10B jeweils schematische Querschnitte durch eine Aufnahmeplatte 30 einer erfindungsgemäßen Behandlungsvorrichtung und durch einen erfindungsgemäßen Substratträger 10 mit einem darauf angeordneten Substrat 2, während Fig. 10C eine Draufsicht auf eine Aufnahmeplatte 30 einer erfindungsgemäßen Behandlungsvorrichtung und einen erfindungsgemäßen Substratträger 10 mit einem darauf angeordneten Substrat 2 zeigt. Gleichartige Bewegungen des Substratträgers sind jedoch auch für Aufnahmeplatten, die eine planare Oberfläche und keine dem Substratträger entsprechende Vertiefung aufweisen, möglich.

Bei dem in Fig. 10A dargestellten Bewegungsablauf wird der Substratträger 10 zunächst entlang der ersten horizontalen Richtung (x-Achse) in die Behandlungsvorrichtung hinein bewegt, was durch den Pfeil V1 dargestellt ist, bis sich der Substratträger 10 oberhalb der Aufnahmeplatte 30, und insbesondere oberhalb der in der Aufnahmeplatte 30 ausgebildeten Vertiefung 31, befindet. Anschließend wird der Substratträger 10 in vertikaler Richtung (z-Achse) nach unten bewegt (Pfeil V2), bis er in der Vertiefung 31 der Aufnahmeplatte 30 aufliegt. Anschließend wird das Substrat 2 behandelt. Nach Abschluss der Behandlung wird der Substratträger 10 in vertikaler Richtung nach oben bewegt (Pfeil V3) bis der Substratträger 10 von der Aufnahmeplatte 30 abgehoben ist und sich in vertikaler Richtung oberhalb der Aufnahmeplatte 30 in einem Abstand zu dieser befindet, der eine Bewegung des Substratträgers 10 in horizontaler Richtung ohne Beschädigung der Aufnahmeplatte 30 oder des Substratträgers 10 oder des Substrates 2 ermöglicht. Anschließend wird der Substratträger 10 entlang der ersten horizontalen Richtung aus der Behandlungsvorrichtung heraus bewegt (Pfeil V4). Dieser Bewegungsablauf entspricht einem Durchlaufverfahren, bei dem der Substratträger 10 in ein und derselben Richtung in die Behandlungsvorrichtung hinein- und aus dieser herausbewegt wird. Er eignet sich insbesondere für Behandlungsvorrichtungen, bei denen nur an maximal einer der beiden Seiten der Aufnahmeplatte 30, die sich entlang der ersten horizontalen Richtung (x-Achse) erstrecken und in der zweiten horizontalen Richtung (y-Achse) einander gegenüberliegen, Komponenten der Behandlungsvorrichtungen, wie bspw. Spannungs- und/oder Gaszuführungen, angeordnet sind. Zwar können diese Komponenten auch zu einem kleinen Teil entlang der beiden Seiten der Aufnahmeplatte 30, die sich entlang der zweiten horizontalen Richtung (y-Achse) erstrecken und in der ersten horizontalen Richtung (x-Achse) einander gegenüberliegen, angeordnet sein, jedoch nur soweit, wie sie die Bewegungen V1 und V4 des Substratträgers 10 nicht behindern oder beeinträchtigen.

Der in Fig. 10B dargestellte Bewegungsablauf unterscheidet sich von dem in Fig. 10A dargestellten Bewegungsablauf dadurch, dass die horizontalen Bewegungen V1 und V4 des Substratträgers entlang der zweiten horizontalen Richtung (y-Achse) erfolgen, in der sich auch die Greifarme des Substratträgers 10 erstrecken. Da die Greifarme des Substratträgers 10 mit einem Manipulator verbunden sind, der sich in der Fig. 10B bspw. rechts von dem Substratträger 10 befindet, jedoch hier nicht dargestellt ist, wird der Substratträger 10 entlang einer positiven zweiten horizontalen Richtung in die Behandlungsvorrichtung hineinbewegt (Pfeil V1) und entlang einer negativen zweiten horizontalen Richtung aus der Behandlungsvorrichtung wieder herausbewegt (Pfeil V4). Die positive zweite horizontale Richtung und die negative zweite horizontale Richtung sind einander entgegengesetzt. Dieser Bewegungsablauf ist insbesondere für Behandlungsvorrichtungen geeignet, bei denen an mindestens einer der beiden Seiten der Aufnahmeplatte 30, die sich entlang der zweiten horizontalen Richtung (y-Achse) erstrecken und in der ersten horizontalen Richtung (x-Achse) einander gegenüberliegen, Komponenten der Behandlungsvorrichtungen, wie bspw. Spannungs- und/oder Gaszuführungen, angeordnet sind, die eine Bewegung des Substratträgers 10 entlang der ersten horizontalen Richtung (x-Achse) behindern oder beeinträchtigen.

Die bisher beschriebenen Bewegungsabläufe enthielten nur geradlinige Bewegungen des Substratträgers 10. Mit Bezug auf Fig. 10C wird ein weiterer Bewegungsablauf beschrieben, der im Gegensatz dazu nichtgeradlinige Bewegungen des Substratträgers 10 enthält. So wird der Substratträger 10 durch eine rotierende Bewegung (Pfeil V1), die in einer horizontalen Ebene oberhalb der Aufnahmeplatte 30 ausgeführt wird, in die Behandlungsvorrichtung hinein bewegt und oberhalb der Aufnahmeplatte 30 positioniert. Anschließend wird der Substratträger 10 durch eine in vertikaler Richtung (z-Achse) nach unten gerichtete Bewegung (V2) auf der Aufnahmeplatte 30 aufgelegt, das Substrat 2 behandelt und der Substratträger 10 durch eine in vertikaler Richtung nach oben gerichtete Bewegung (V3) wieder von der Aufnahmeplatte 30 abgehoben. Anschließend wird der Substratträger 10 durch eine rotierende Bewegung (Pfeil V4) in einer horizontalen Ebene oberhalb der Aufnahmeplatte 30 aus der Behandlungsvorrichtung heraus bewegt. Auch hier müssen weitere Komponenten der Behandlungsvorrichtung so angeordnet sein, dass sie die Bewegungen des Substratträgers 10, insbesondere die Bewegungen V1 und V4, nicht behindern.

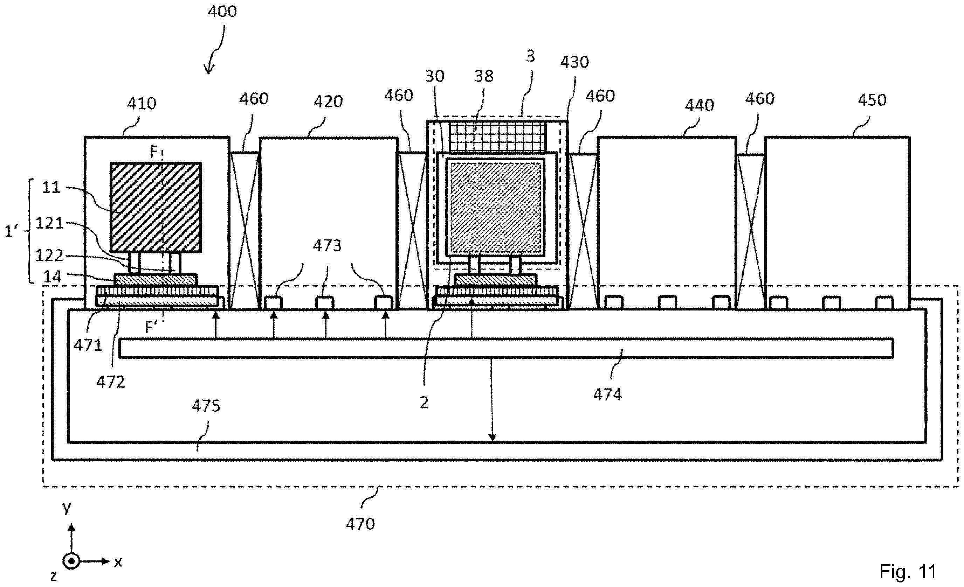

Figur 11 zeigt eine schematische Draufsicht auf eine Ausführungsform der erfindungsgemäßen Behandlungsanlage 400. Die Behandlungsanlage 400 weist mehrere Kammern auf, die hintereinander entlang der ersten horizontalen Richtung (x-Achse) angeordnet sind, und ist eine Durchlaufanlage (Inline-Anlage), bei der ein zu prozessierendes Substrat entlang der ersten horizontalen Richtung von einer Kammer zur nächsten Kammer transportiert wird. Vorzugsweise sind die Kammern auch alle in ein und derselben horizontalen Ebene angeordnet, so dass das Substrat nur in die erste horizontale Richtung bewegt werden muss, um von einer Kammer in eine benachbarte Kammer zu gelangen.

Die Behandlungsanlage 400 enthält eine Beladekammer 410, eine Einschleuskammer 420, eine Behandlungskammer 430, eine Ausschleuskammer 440 und eine Entladekammer 450. Die Beladekammer 410 und die Entladekammer 450 können geschlossene Kammern sein, die auf allen Seiten durch Kammerwände, Schieberventile oder Türen gegenüber ihrer Umgebung abgegrenzt ist, wie dies in Fig. 11 zu sehen ist. Jedoch können die Beladekammer 410 und die Entladekammer 450 auch offene Kammern oder Stationen sein, die an mindestens einer Seite gegenüber ihrer Umgebung ständig offen und nicht abgegrenzt sind. Die Beladekammer 410 ist geeignet, das Auflegen eines Substrates 2 auf einen Substratträger einer erfindungsgemäßen Vorrichtung zum Transport eines Substrates zu ermöglichen. Zu diesem Zweck ist die Beladekammer 410 geeignet, eine derartige Vorrichtung zum Transport eines Substrates aufzunehmen und zu halten. In Fig. 11 ist beispielhaft eine Vorrichtung 1' zum Transport mehrerer Substrate, wie sie mit Bezug auf die Fig. 4A beschrieben wurde, dargestellt, wobei die Vorrichtung 1' mehrere Substratträger, und somit mehrere Halteflächen 11 und Greifarme 121 und 122, enthält, die mit einer gemeinsamen Trägeranordnung 14 verbunden sind. Die Beladekammer selbst kann Mittel zum Auflegen des Substrates auf die Vorrichtung zum Transport des Substrates enthalten. Alternativ können solche Mittel zum Auflegen des Substrates auch außerhalb der Beladekammer 410 angeordnet und damit nicht Teil der Behandlungsanlage 400 sein, wie dies in Fig. 11 dargestellt ist. In gleicher Weise ist die Entladekammer 450 geeignet, das Entnehmen des Substrates 2 von dem Substratträger der Vorrichtung 1' zum Transport des Substrates zu ermöglichen und die Vorrichtung 1' aufzunehmen und zu halten. Bezüglich Mitteln zum Entnehmen des Substrates von der Vorrichtung zum Transport des Substrates gilt Ähnliches wie mit Bezug auf die Mittel zum Auflegen des Substrates auf die Vorrichtung zum Transport des Substrates gesagt.

Die Einschleuskammer 420 und die Ausschleuskammer 440 sind dazu geeignet, eine Atmosphäre zu erzeugen, die der der nachfolgenden Kammer, also der Behandlungskammer 430 bzw. der Entladekammer 450, zumindest in einigen Parametern (z.B. Druck) entspricht. Damit können Evakuierungs- und Belüftungsprozesse der Behandlungskammer 430 und/oder der Be- und Entladekammern 410, 450 minimiert werden. Jedoch kann die Funktionalität der Ein- und/oder der Ausschleuskammern 420, 440 auch durch die Be- bzw. Entladekammer 410, 450 oder in der Behandlungskammer 430 realisiert werden, so dass die Ein- und/oder die Aussschleuskammern 420, 440 auch entfallen können.

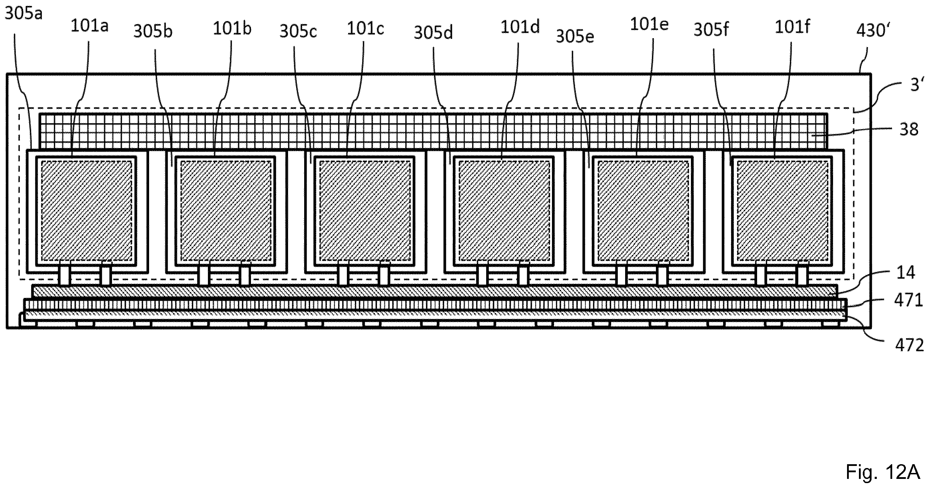

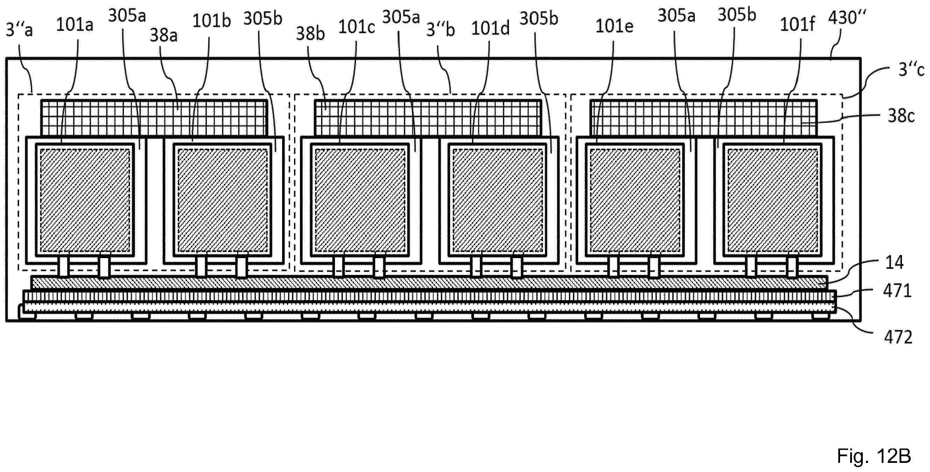

Die Behandlungskammer 430 dient der eigentlichen Behandlung des Substrates 2 und enthält mindestens eine Behandlungsvorrichtung mit einer Aufnahmeplatte, auf der das Substrat während der Behandlung gehaltert wird. In den Figuren 11 sowie 12A und 12B ist jeweils eine erfindungsgemäße Behandlungsvorrichtung 3 dargestellt. Jedoch kann die Behandlungskammer auch eine Behandlungsvorrichtung enthalten, deren Aufnahmeplatte eben ausgebildet ist und keine dem Substratträger der erfindungsgemäßen Vorrichtung zum Transport eines Substrates entsprechende Vertiefung aufweist. Die Behandlungsvorrichtung 3 enthält genau so viele Aufnahmeplatten 30, wie die Vorrichtung 1' Halteflächen 11 enthält. Darüber hinaus enthält die Behandlungsvorrichtung 3 eine Versorgungseinrichtung 38, die zur Bereitstellung und Zuführung von für die Behandlung des Substrates 2 notwendigen Medien, wie Gasen oder Temperierfluiden, oder Spannungen geeignet ist. Die Versorgungseinrichtung 38 ist innerhalb der Behandlungskammer 430 in der dargestellten Ausführungsform so angeordnet, dass die Haltefläche 11 der Vorrichtung 1' durch eine Bewegung entlang der ersten horizontalen Richtung (x-Achse) in die Behandlungsvorrichtung 3 hinein- oder aus dieser heraus bewegt und über der Aufnahmeplatte 30 positioniert werden kann, ohne zusätzlich entlang der zweiten horizontalen Richtung (y-Achse) bewegt werden zu müssen.

Mindestens die Einschleuskammer 420, die Behandlungskammer 430 und die Ausschleuskammer 440 sind in der dargestellten Ausführungsform Vakuumkammern, in denen eine von den anderen Kammern unabhängige, definierte Atmosphäre, die durch einen bestimmten Druck und eine bestimmte Gaszusammensetzung charakterisiert ist, eingestellt werden kann. Alle Kammern 410 bis 450 sind mittels gasdichter Schieberventile 460 mit der oder den jeweils angrenzenden Kammern verbunden. Damit ist es möglich, die Vorrichtung 1' bspw. von der Einschleuskammer 420 in die Behandlungskammer 430 oder aus der Behandlungskammer 430 in die Ausschleuskammer 440 zu transportieren, ohne ein Vakuum zu unterbrechen.

Die Behandlungsanlage 400 kann auch mehrere Behandlungskammern (oder mehrere Behandlungsvorrichtungen in einer Behandlungskammer) und/oder mehrere Ein- und Ausschleuskammern aufweisen, die entsprechend der gewünschten Gesamtprozessierung des Substrates angeordnet und ausgestaltet sind. Dabei kann ein Substrat ohne ein zwischengeschaltetes Umlagern von einem Substratträger auf einen anderen Substratträger in mehreren Behandlungsvorrichtungen prozessiert werden, wobei die Crosskontamination zwischen den verschiedenen Behandlungsvorrichtungen reduziert ist.

Wie in Fig. 11 dargestellt, können mehrere erfindungsgemäße Vorrichtungen zum Transport eines Substrates gleichzeitig in der Behandlungsanlage vorhanden sein. So kann sich bspw. eine erste Vorrichtung 1' in der Beladekammer 410 befinden und mit Substraten bestückt werden, während sich eine zweite Vorrichtung 1' in der Behandlungskammer 430 befindet und die darauf befindlichen Substrate 2 behandelt werden. Je nach Ausgestaltung der Behandlungsanlage 400 können verschiedene Anzahlen von Vorrichtungen zum Transport eines Substrates in der Behandlungsanlage gleichzeitig vorhanden sein. Nach Entnahme der Substrate aus der Vorrichtung 1' zum Transport eines Substrates in der Entladekammer 450 kann die leere Vorrichtung 1' zum Transport eines Substrates außerhalb der Behandlungsanlage 400 oder in einem weiteren Bereich der Behandlungsanlage 400 wieder zur Beladekammer 410 zurückgeführt werden, so dass sie erneut für eine Prozessierung eines Substrates zur Verfügung steht. Dies wird später näher erläutert.

Wie bereits mit Bezug auf Fig. 4B erläutert, kann die erfindungsgemäße Vorrichtung zum Transport eines Substrates auch mehrere, lateral nebeneinander angeordnete Einheiten von übereinander angeordneten Substratträgern aufweisen. So können beispielsweise 120 Substrate, die in 6 Einheiten aus jeweils 20 Substraten jeweils einzeln auf einem der Substratträger angeordnet sind, gleichzeitig durch die Behandlungsanlage transportiert und in ihr prozessiert werden. Dabei kann eine Behandlungsvorrichtung so viele lateral nebeneinander angeordnete Einheiten von übereinander angeordneten Aufnahmeplatten enthalten, dass alle Substrate in ein und derselben Behandlungsvorrichtung behandelt werden können. Alternativ können auch mehrere Behandlungsvorrichtungen, die vorzugsweise gleichartig ausgebildet sind, in einer Behandlungskammer vorhanden sein, wobei jeweils nur Aufnahmeplatten zur Aufnahme der Substratträger einer Einheit oder mehrerer, jedoch nicht aller, Einheiten von Substratträgern mit den darauf aufliegenden Substraten in eine der Behandlungsvorrichtungen angeordnet sind. Beispiele für derartige Behandlungskammern sind in den Figuren 12A und 12B schematisch dargestellt.

Fig. 12A zeigt eine schematische Draufsicht auf eine Behandlungskammer 430' mit einer Behandlungsvorrichtung 3' und einer Vorrichtung zum Transport eines Substrates mit sechs Einheiten 101a bis 101f von Substratträgern, wobei in jeder Einheit 101a bis 101f mehrere Substratträger vertikal übereinander angeordnet sind. Die Substratträger aller Einheiten 101a bis 101f sind mit ein und derselben Trägeranordnung 14 und über diese mit der Trägereinheit 471 und dem Führungssystem 472 der Bewegungsanordnung verbunden. Die Behandlungsvorrichtung 3' weist sechs Einheiten 305a bis 305f von Aufnahmeplatten auf, wobei die Aufnahmeplatten einer Einheit 305a bis 305f jeweils vertikal übereinander angeordnet sind. Darüber hinaus enthält die Behandlungsvorrichtung 3' eine gemeinsame Versorgungseinrichtung 38, die zur Bereitstellung und Zuführung von für die Behandlung der Substrate notwendigen Medien, wie Gasen oder Temperierfluiden, oder Spannungen für alle Einheiten 305a bis 305f geeignet ist, auf. Im Ergebnis werden alle Substrate in ein und derselben Behandlungsvorrichtung 3' behandelt.

Fig. 12B zeigt eine schematische Draufsicht auf eine Behandlungskammer 430" mit drei Behandlungsvorrichtung 3"a bis 3"c und einer Vorrichtung zum Transport eines Substrates mit sechs Einheiten 101a bis 101f von Substratträgern, wobei in jeder Einheit 101a bis 101f mehrere Substratträger vertikal übereinander angeordnet sind. Die Substratträger aller Einheiten 101a bis 101f sind mit ein und derselben Trägeranordnung 14 und über diese mit der Trägereinheit 471 und dem Führungssystem 472 der Bewegungsanordnung verbunden. Die Substrate von jeweils zwei der Einheiten 101a bis 101f werden in einer der Behandlungsvorrichtung 3"a bis 3"c behandelt. Das heißt, die Substrate der Einheiten 101a und 101b werden in der Behandlungsvorrichtung 3"a, die Substrate der Einheiten 101c und 101d werden in der Behandlungsvorrichtung 3"b und die Substrate der Einheiten 101e und 101f werden in der Behandlungsvorrichtung 3"c behandelt. Dazu weist jede der Behandlungsvorrichtungen 3"a bis 3"c jeweils zwei Einheiten 305a und 305b von Aufnahmeplatten auf, wobei die Aufnahmeplatten einer Einheit 305a und 305b jeweils vertikal übereinander angeordnet sind. Darüber hinaus enthält jede der Behandlungsvorrichtung 3"a bis 3"c eine Versorgungseinrichtung 38a bis 38c, die zur Bereitstellung und Zuführung von für die Behandlung der Substrate notwendigen Medien, wie Gasen oder Temperierfluiden, oder Spannungen für jede der Einheiten 305a und 305b einer der Behandlungsvorrichtungen 3"a bis 3"c geeignet ist, auf. Vorzugsweise sind alle Behandlungsvorrichtungen 3"a bis 3"c gleichartig ausgeführt.

Selbstverständlich können beliebige Anzahlen von Behandlungsvorrichtungen, die zur Aufnahme beliebiger Anzahlen von Einheiten von Substratträgern geeignet sind, in einer Behandlungskammer angeordnet werden.

Zurückkehrend zu Fig. 11, weist die Behandlungsanlage 400 darüber hinaus eine Bewegungsanordnung 470 auf, die der Bewegung der Vorrichtung 1' innerhalb der Behandlungsanlage 400 dient und sich über die gesamte Behandlungsanlage 400 durch alle Kammern 410 bis 450 erstreckt. Die Bewegungsanordnung 470 enthält mindestens eine Trägereinheit 471, mindestens ein Führungssystem 472, sowie Führungselemente 473, eine Steuereinheit 474 und ein Rückführsystem 475 in einem Bereich der Behandlungsanlage 400, der außerhalb mindestens der Behandlungskammer 430 verläuft. Mit Hilfe des Rückführsystems 475 kann die Trägereinheit 471 und das damit verbundene Führungssystem 472 sowie ggf. eine damit verbundene leere Vorrichtung 1' zum Transport eines Substrats wieder von der Entladekammer 450 zur Beladekammer 410 zurückgeführt werden, so dass sie erneut für eine Prozessierung eines Substrates zur Verfügung stehen. Das Rückführsystem 457 bildet somit mit den anderen Komponenten der Bewegungsanordnung 470 ein geschlossenes System zum Bewegen der Vorrichtung 1' zum Transport eines Substrats.

Das Rückführsystem 475 kann gleichartig zu den Elementen der Bewegungsanordnung 470 innerhalb der Kammern 410 bis 450 ausgebildet sein und bspw. auch Führungselemente 473 aufweisen. Jedoch kann das Rückführsystem 475 auch anderweitig ausgebildet sein und kann zusätzliche Einrichtungen, wie bspw. eine Reinigungseinrichtung, aufweisen. Das Rückführsystem 475 kann beliebig in Bezug auf die Kammern 410 bis 450 der Behandlungsanlage 400, bspw. oberhalb oder unterhalb der Kammern 410 bis 450 oder seitlich davon, jedoch vorzugsweise stets außerhalb der Kammern 410 bis 450 angeordnet sein.

Vorzugsweise werden Transporteinrichtungen, die jeweils eine Trägereinheit 471 und ein Führungssystem 472 mit der oder den daran befestigten Vorrichtungen 1'zum Transport eines Substrates enthalten, nach dem Entladen der Substrate in der Entladekammer 450 mittels des Rückführsystems 475 wieder zurück zur Beladekammer 410 gefahren. Das Rückführsystem 475 für die Transporteinrichtungen kann damit gleichzeitig als Puffer für die Transporteinrichtungen dienen. D.h. wenn genügend viele Transporteinrichtungen (typisch zwischen 5 und 15 Stück) in der Behandlungsanlage auf diese Art und Weise rotieren, kann im Rückführsystem 475 vor der Beladekammer 410 eine Warteschlange für Transporteinrichtungen installiert werden. Dadurch sind immer Transporteinrichtungen zum Beladen mit Substraten aus dem Rückführsystem 475 abrufbar und die Behandlungsanlage 400 kann ununterbrochen arbeiten.

Die Steuereinheit 474 dient der Steuerung der Trägereinheit 471 und der Führungselemente 473 sowie des Rückführsystems 475, so dass die Vorrichtung 1' in eine gewünschte Richtung innerhalb der Behandlungsanlage 400 bewegt werden kann. Die Steuerung sowie die dazu notwendigen Mittel, wie Signalleitungen oder mechanische, hydraulische oder pneumatische Steuerungselemente, sind durch die Pfeile, die beispielhaft ausgehend von der Steuereinheit 474 zu einigen Führungselementen 473, zur Trägereinheit 471 und zum Rückführsystem 475 führen, schematisch dargestellt. Die Führungselemente 473 sind in den jeweiligen Kammern 410 bis 450 angeordnet, während die Trägereinheit 471 und das Führungssystem 472 mit der Vorrichtung 1' verbunden sind und sich gemeinsam mit dieser durch die Behandlungsanlage 400 bewegen. Das Führungssystem 472 wirkt mit den Führungselementen 473 derart zusammen, dass die Vorrichtung 1' gehalten wird und definiert entlang der ersten horizontalen Richtung (x-Achse) bewegt werden kann. Dabei weisen die einzelnen Führungselemente 473 einen Abstand entlang der ersten horizontalen Richtung (x-Achse) zueinander auf, der so bemessen ist, dass die Trägereinheit 471 an jedem Ort innerhalb der Behandlungsanlage 400 immer von mindestens zwei Führungselementen 473 gehalten wird.

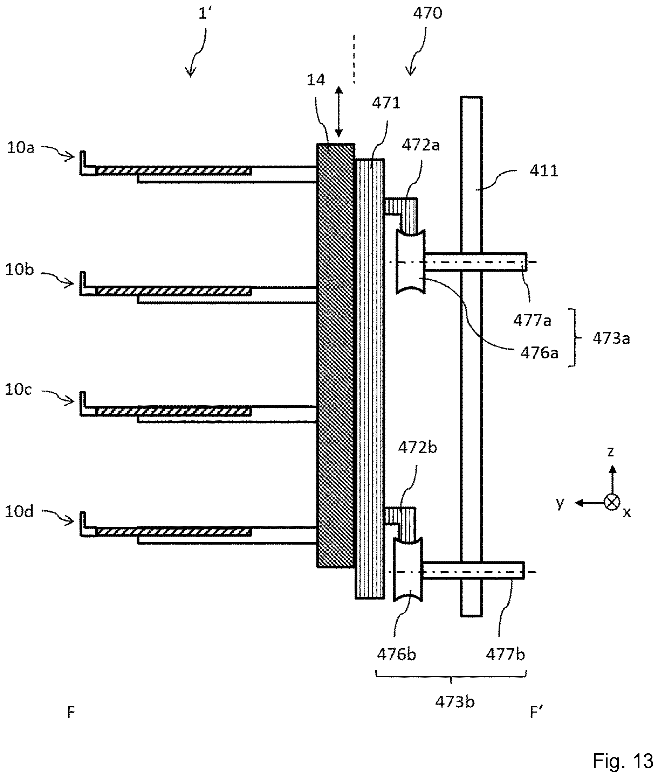

Die Figur 13 zeigt einen Querschnitt durch die Behandlungsanlage 400 entlang der Linie F-F' aus Fig. 11 und dient der Erläuterung einer beispielhaften Ausführungsform der Bewegungsanordnung 470, insbesondere der Trägereinheit 471, des Führungssystems 472 und der Führungselemente 473. Zu sehen sind die Vorrichtung 1' zum Transport eines Substrates, die mehrere Substratträger 10a bis 10d und die Trägeranordnung 14 enthält, sowie die Bewegungsanordnung 470, wobei die Steuereinheit nicht dargestellt ist, und eine seitliche Kammerwand 411 der Beladekammer 410. Weitere Wände der Beladekammer 410 sind im Hinblick auf eine bessere Übersichtlichkeit der Darstellung hier nicht gezeigt. Die Trägereinheit 471 ist eine sich vertikal erstreckende Platte, die auf ihrer der Kammerwand 411 abgewandten Seite mit der Trägeranordnung 14 fest bezüglich einer Bewegung in die erste horizontale Richtung (entlang der x-Achse) und beweglich in vertikaler Richtung (z-Achse) verbunden ist. Die Verbindung kann dabei jeweils lösbar oder unlösbar ausgeführt sein. Die Trägereinheit 471 ist geeignet, die Trägeranordnung 14 entlang der vertikalen Richtung definiert zu bewegen, und weist die dafür notwendigen Mittel auf. Diese Mittel können elektrisch, mechanisch, hydraulisch oder pneumatisch eine vertikale Bewegung der Trägeranordnung 14 realisieren und sind aus dem Stand der Technik bekannt. Zusätzlich kann die Trägereinheit 471 auch Mittel aufweisen, die eine definierte Bewegung der Trägeranordnung 14 entlang der zweiten horizontalen Richtung (y-Achse) ermöglichen. An der der Kammerwand 411 zugewandten Seite der Trägereinheit 471 sind eine obere Schiene 472a und eine untere Schiene 472b fest angeordnet, wobei die obere und die untere Schiene 472a, 472b gemeinsam das Führungssystem 472 aus Fig. 11 bilden. Die obere und die untere Schiene 472a, 472b sind jeweils auf einer Rolle 476a, 476b gelagert, die jeweils wiederum auf einer Welle 477a, 477b angeordnet sind. Vorzugsweise ist mindestens eine der Rollen 476a, 476b fest mit der ihr zugeordneten Welle 477a, 477b verbunden. "Fest" bedeutet hier, dass die jeweiligen Komponenten so miteinander verbunden sind, dass sie sich nicht gegeneinander oder unabhängig voneinander bewegen können, wobei die Verbindung an sich lösbar, z.B. durch Schrauben, oder unlösbar, z.B. durch Schweißen, ausgeführt sein kann. Die Wellen 477a, 477b führen durch die Kammerwand 411 hindurch und können somit von außen gedreht werden, wodurch die Rollen 476a, 476b rotieren und die Trägereinheit 471 mit der damit verbundenen Vorrichtung 1' entlang der ersten horizontalen Richtung (x-Achse) bewegen. Die Rollen 476a, 476b können auch drehbar auf den Wellen 477a, 477b angeordnet sein, so dass sie eine Bewegung der Trägereinheit 471 entlang der ersten horizontalen Richtung nur passiv unterstützen. Die Bewegung der Trägereinheit 471 entlang der ersten horizontalen Richtung selbst kann dann über andere Mittel angeregt und gesteuert werden. Die Rolle 476a und die Welle 477b, die zusammenwirken, bilden zusammen ein oberes Führungselement 473a, während die Rolle 476b und die Welle 477b ein unteres Führungselement 473b bilden. Die Schienen 472a, 472b erstrecken sich im Wesentlichen geradlinig entlang der ersten horizontalen Richtung (x-Achse), wobei zumindest vordere Enden der Schienen 472a, 472b, d.h. die Endbereiche der Schienen 472a, 472b, die in Bewegungsrichtung der Trägereinheit 471 als erste in Kontakt mit einer Rolle 476a, 476b treten, abgerundet oder in vertikaler Richtung nach oben gebogen sein können, um einen stoßfreien Übergang der jeweiligen Schiene 472a, 472b auf die jeweilige Rolle 476a, 476b zu erreichen.

Selbstverständlich sind auch andere Ausführungsformen der einzelnen Komponenten der Bewegungsanordnung 470, insbesondere der Trägereinheit 471, des Führungssystems 472 und/oder der Führungselemente 473, möglich, solange eine sichere Halterung und eine definierte Bewegung der Vorrichtung 1' gewährleistet sind.

Bei hohen, in mindestens einer der Kammern der Behandlungsanlage auftretenden Temperaturen, wie dies bspw. in einer Behandlungskammer, die für eine MOCVD-Abscheidung (metallorganic chemical vapor deposition, metallorganische Gasphasenabscheidung) genutzt wird, der Fall ist, können ggf. Anordnungen zur Wärmeisolation der Bewegungsanordnung 470 oder anderer Bestandteile der betreffenden Kammer notwendig und vorhanden sein, die jedoch zur Wahrung der Anschaulichkeit in den Figuren 11 bis 13 nicht dargestellt sind. MOCVD-Prozesse werden bspw. bei Substrattemperaturen zwischen 600°C und 1000°C ausgeführt, während plasmaunterstützte Prozesse meist bei Substrattemperaturen zwischen 20°C und 400°C ausgeführt werden. Solche Anordnungen zur Wärmeisolation sind bspw. Wärmeschutzbleche oder Beschichtungen und sind aus dem Stand der Technik bekannt.

In anderen Ausführungsformen der erfindungsgemäßen Behandlungsanlage können die Beladekammer und die Entladekammer auch durch ein und dieselbe Kammer realisiert sein, wobei die dann vorhandenen Kammern zwar linear angeordnet sein können, jedoch eine Bewegung des Substrates entlang der ersten horizontalen Richtung in positive und negative Richtung notwendig ist.

Darüber hinaus sind auch vertikale Anordnungen der Kammern übereinander oder eine kreisförmige Anordnung der Kammern oder einiger Kammern um eine zentrale Be- und Entladekammer herum möglich.

Die genaue Ausgestaltung des Substratträgers und der gesamten Vorrichtung zum Transport eines Substrates sowie die genaue Ausgestaltung der Aufnahmeplatte und der gesamten Behandlungsvorrichtung können optimal an die Bedingungen einer Substratbehandlung und einer Bewegung des Substratträgers angepasst werden. Insbesondere kann die Form und Anzahl der Halteflächen, der Greifarme und der Haltevorrichtungen sowie die Form und Anzahl der Vertiefungen in der Aufnahmeplatte und der Aufnahmeplatten selbst unabhängig von den dargestellten Ausführungsformen gewählt werden und sind nicht auf die dargestellten Formen und Anzahlen begrenzt. Auch Kombinationen verschiedener Komponenten der dargestellten Ausführungsformen sind möglich, solange diese sich nicht gegenseitig ausschließen

In gleicher Weise können verschiedene Komponenten der Behandlungsanlage miteinander kombiniert werden, solange diese sich nicht gegenseitig ausschließen.

### Bezugszeichen

- 1, 1', 1": Vorrichtung zum Transport eines Substrates
- 10, 10', 10", 10a-10d, 100: Substratträger
- 101, 101a-: Einheit aus vertikal übereinander angeordneten Substratträgern
- 101f 11, 11a, 11d: Haltefläche
- 110: Grundkörper des Substratträgers
- 110a, 110d: Vertiefung im Grundkörper
- 111: Rand der Haltefläche
- 112: Erste Oberfläche der Haltefläche
- 113: Zweite Oberfläche der Haltefläche
- 114a: Seitlicher Rahmen der Haltefläche
- 114b: Steg zwischen den Vertiefungen der Haltefläche
- 115a: Erster Bereich der Haltefläche
- 115b: Zweiter Bereich der Haltefläche
- 121,122: Greifarm
- 121a: Erster Bereich des Greifarms
- 121b: Zweiter Bereich des Greifarms
- 13a-13g: Haltevorrichtung
- 14: Trägeranordnung
- 2, 2a-2d: Substrat
- 201: Erste Oberfläche des Substrats
- 202: Zweite Oberfläche des Substrats
- 203: Rand des Substrats
- 3, 3a, 3b, 3', 3"a-3"c: Behandlungsvorrichtung
- 30, 30', 30", 30a-30h: Aufnahmeplatte
- 300: Grundkörper der Aufnahmeplatte
- 300a: Erster Bereich des Grundkörpers
- 300b: Zweiter Bereich des Grundkörpers
- 301: Erste Oberfläche der Aufnahmeplatte
- 302: Zweite Oberfläche der Aufnahmeplatte
- 303: Oberer Bereich der Aufnahmeplatte
- 304: Unterer Bereich der Aufnahmeplatte
- 305a-305f: Einheit aus Aufnahmeplatten
- 31: Vertiefung in der Aufnahmeplatte
- 311: Vertiefung zur Aufnahme der Haltefläche
- 312a, 312b: Vertiefung zur Aufnahme eines Greifarms
- 313a-313g: Vertiefung zur Aufnahme einer Haltevorrichtung
- 32: Einrichtung zum Temperieren der Aufnahmeplatte
- 32a: Heizer
- 33: Gasverteiler
- 331: Gasvorratsraum
- 332: Gaskanal
- 34: Topelektrode
- 35a, 35b: Spannungszuführung
- 36: Plasmaraum
- 36a: Prozessraum
- 37: Anordnung zur Wärmeisolation
- 38, 38a-38c: Versorgungseinrichtung
- 400: Behandlungsanlage
- 410: Beladekammer
- 411: Kammerwand
- 420: Einschleuskammer
- 430, 430',: Behandlungskammer
- 430" 440: Ausschleuskammer
- 450: Entladekammer
- 460: Schieberventil
- 470: Bewegungsanordnung zum Bewegen der Vorrichtung zum Transport eines Substrates
- 471: Trägereinheit
- 472: Führungssystem
- 472a: Obere Schiene
- 472b: Untere Schiene
- 473: Führungselement
- 473a: Oberes Führungselement
- 473b: Unteres Führungselement
- 474: Steuereinheit
- 475: Rückführsystem
- 476a, 476b: Rolle
- 477a, 477b: Welle

- K1, K2: Anschlussklemme
- V1-V4: Erste bis vierte Bewegung des Substratträgers

- b₁: Breite des Substrats
- b₁₁: Breite der Haltefläche
- b₁₂: Breite des Greifarms
- b₁₃: Breite des überstehenden Bereiches der Haltevorrichtung
- h₁: Höhe des Substrats
- h₁₁: Höhe der Haltefläche
- h₁₂: Höhe des Greifarms in Bereichen, in denen er nicht an die zweite Oberfläche der Haltefläche angrenzt
- h_{12'}: Höhe des Greifarms in Bereichen, in denen er an die zweite Oberfläche der Haltefläche angrenzt
- h₁₃: Höhe der Haltevorrichtung über der ersten Oberfläche der Haltefläche
- h₃₁₁: Höhe der Vertiefung zur Aufnahme der Haltefläche
- h₃₁₂: Höhe der Vertiefung zur Aufnahme eines Greifarms
- L₁: Länge des Substrats
- L₁₁: Länge der Haltefläche
- L₁₂: Länge des Greifarms
- L₁₂ₐ: Länge des überstehenden Bereiches des ersten Bereiches des Greifarms
- L_{12b}: Länge des zweiten Bereiches des Greifarms
- L₁₃: Länge der Haltevorrichtung

## Patentansprüche

1. Vorrichtung (1, 1', 1") zum Transport eines Substrates (2, 2a-2d) in eine Behandlungsvorrichtung (3, 3a, 3b, 3', 3"a-3"c) hinein oder aus dieser heraus, wobei die Behandlungsvorrichtung (3, 3a, 3b, 3', 3"a-3"c) eine sich horizontal erstreckende Aufnahmeplatte (30, 30', 30", 30a-30h) und die Vorrichtung einen Substratträger (10, 10', 10", 10a-10d, 100) aufweisen und der Substratträger (10, 10', 10", 10a-10d, 100) geeignet ist, das Substrat (2, 2a-2d) auf einer ersten Oberfläche (301) der Aufnahmeplatte (30, 30', 30", 30a-30h) zu positionieren, und der Substratträger (10, 10', 10", 10a-10d, 100) weiterhin geeignet ist, das Substrat (2, 2a-2d) auf der Aufnahmeplatte (30, 30', 30", 30a-30h) während der Behandlung des Substrates (2, 2a-2d) in der Behandlungsvorrichtung (3, 3a, 3b, 3', 3"a-3"c) zu halten, und der Substratträger (10, 10', 10", 10a-10d, 100) aufweist:
- eine sich horizontal erstreckende Haltefläche (11, 11', 11", 11a, 11d), die auf einer dem Substrat (2, 2a-2d) zugewandten ersten Oberfläche (112) eben und gleichförmig ausgebildet ist, deren Form im Wesentlichen der Form des Substrates (2, 2a-2d) entspricht und deren Fläche im Wesentlichen gleich der Fläche des Substrates (2, 2a-2d) ist, wobei das Substrat (2, 2a-2d) nur durch seine Gewichtskraft mit seiner Rückseite auf der Haltefläche (11, 11', 11", 11a, 11d) gehalten wird, und
- einen oder mehrere Greifarme (121, 122),
**dadurch gekennzeichnet, dass** jeder der Greifarme (121, 122) mit der Haltefläche (11, 11', 11", 11a, 11d) verbunden ist und sich über diese in einer horizontalen Richtung hinaus erstreckt.

2. Vorrichtung (1; 1', 1") nach Anspruch 1, **dadurch gekennzeichnet, dass** sich vom Rand (111) und/oder von der ersten Oberfläche (112) der Haltefläche (11, 11', 11", 11a, 11d) aus mindestens zwei Haltevorrichtungen (13a-13g) mindestens in vertikale Richtung erstrecken, die geeignet sind, das Substrat (2, 2a-2d) gegen ein laterales Verschieben auf der Haltefläche (11, 11', 11", 11a, 11d) zu sichern.

3. Vorrichtung (1; 1', 1") nach Anspruch 2, **dadurch gekennzeichnet, dass** die Haltevorrichtungen (13a-13g) sich bis zu einer Höhe gemessen von der ersten Oberfläche (112) der Haltefläche (11, 11', 11", 11a, 11d) über die erste Oberfläche (112) der Haltefläche (11, 11', 11", 11a, 11d) erstrecken, wobei die Höhe größer Null und kleiner als oder gleich der Höhe des Substrates (2, 2a-2d) ist.

4. Vorrichtung (1; 1', 1") nach einem der vorhergehenden Ansprüche, **dadurch gekennzeichnet, dass** der Substratträger (100) mehrere Halteflächen (11a, 11d) aufweist, die in einer gemeinsamen horizontalen Ebene nebeneinander in einer lateralen Anordnung angeordnet und untereinander physisch verbunden sind.

5. Vorrichtung (1; 1', 1") nach Anspruch 4, **dadurch gekennzeichnet, dass** der Substratträger (100) einen geschlossenen Grundkörper (110) aufweist, wobei jede Haltefläche (11a, 11d) als Grundfläche einer Vertiefung (110a, 110d), die in einer horizontalen Oberfläche des Grundkörpers (110) ausgebildet ist, und Haltevorrichtungen, die geeignet sind, die Substrate (2a, 2d), von denen jedes auf einer der Halteflächen (11a, 11d) aufliegt, gegen ein laterales Verschieben auf der jeweiligen Haltefläche (11a, 11d) zu sichern, als seitlicher Rahmen (114a) oder als Steg (114b) zwischen den Halteflächen (11a, 11d) ausgebildet sind.

6. Vorrichtung (1, 1', 1") nach einem der vorhergehenden Ansprüche, **dadurch gekennzeichnet, dass** die Bestandteile des Substratträgers (10, 10', 10", 10a-10d, 100) zumindest in den Bereichen, die während der Substratbehandlung mit dem Substrat (2, 2a-2d) und/oder der Aufnahmeplatte (30, 30', 30", 30a-30h) in Kontakt stehen, aus demselben Material wie die erste Oberfläche (301) der Aufnahmeplatte (30, 30', 30", 30a-30h) bestehen.

7. Vorrichtung (1, 1', 1") nach einem der vorhergehenden Ansprüche, **dadurch gekennzeichnet, dass** die Bestandteile des Substratträgers (10, 10', 10", 10a-10d, 100) in den Bereichen, die während der Substratbehandlung mit dem Substrat (2, 2a-2d) und/oder der Aufnahmeplatte (30, 30', 30", 30a-30h) in Kontakt stehen, aus einem elektrisch leitenden Material bestehen und der oder die Greifarme (121, 122) in Bereichen, die während der Substratbehandlung nicht mit der Aufnahmeplatte (30, 30', 30", 30a-30h) in Kontakt stehen, aus einem dielektrischen Material bestehen.

8. Vorrichtung (1, 1', 1") nach einem der vorhergehenden Ansprüche, **dadurch gekennzeichnet, dass** die Bereiche des Substratträgers (10, 10', 10", 10a-10d, 100), die während der Substratbehandlung mit dem oder den Substraten (2, 2a-2d) und/oder der Aufnahmeplatte (30, 30', 30", 30a-30h) in Kontakt stehen, eine Wärmekapazität aufweisen, die kleiner als die Wärmekapazität der Aufnahmeplatte (30, 30', 30", 30a-30h) ist.

9. Vorrichtung (1, 1', 1") nach einem der vorhergehenden Ansprüche, **dadurch gekennzeichnet, dass** die Vorrichtung eine Trägeranordnung (14) aufweist, an der der Substratträger (10, 10', 10", 10a-10d, 100) mit dem einen oder mehreren Greifarmen (121, 122) befestigt ist.

10. Vorrichtung (1', 1") nach Anspruch 9, **dadurch gekennzeichnet, dass** die Vorrichtung (1', 1") eine Einheit (101, 101a, 101b) von mehreren Substratträgern (10a-10d), die vertikal übereinander angeordnet und mit der Trägeranordnung (14) verbunden sind, aufweist.

11. Vorrichtung (1") nach Anspruch 10, **dadurch gekennzeichnet, dass** die Vorrichtung (1") mehrere Einheiten (101a, 101b) von vertikal übereinander angeordneten Substratträgern (10a-10d) aufweist, wobei die Einheiten (101a, 101b) in horizontaler Richtung nebeneinander angeordnet und mit derselben Trägeranordnung (14) verbunden sind.

12. Behandlungsvorrichtung (3, 3a, 3b, 3', 3"a-3"c) zur Behandlung eines Substrates (2, 2a-2d), aufweisend eine Aufnahmeplatte (30, 30', 30", 30a-30h), auf der das Substrat (2, 2a-2d) während der Behandlung gehaltert wird,
wobei die Aufnahmeplatte (30, 30', 30", 30a-30h) in einer ersten Oberfläche (301), die dem Substrat (2, 2a-2d) während der Substratbehandlung zugewandt ist, eine Vertiefung (31) aufweist,
**dadurch gekennzeichnet, dass** die Vertiefung (31) geeignet ist, einen Substratträger (10, 10', 10", 10a-10d, 100) einer Vorrichtung (1, 1', 1") nach einem der Ansprüche 1 bis 11 während der Behandlung des Substrates (2, 2a-2d) aufzunehmen.

13. Behandlungsvorrichtung (3, 3a, 3b, 3', 3"a-3"c) nach Anspruch 12, **dadurch gekennzeichnet, dass** die Vertiefung (31) in der ersten Oberfläche (301) der Aufnahmeplatte (30, 30', 30", 30a-30h) eine Tiefe (h₃₁₁, h₃₁₂) gemessen von der ersten Oberfläche (301) der Aufnahmeplatte (30, 30', 30", 30a-30h) aus aufweist, die so bemessen ist, dass die erste Oberfläche (112) der Haltefläche (11, 11', 11", 11a, 11d) des Substratträgers (10, 10', 10", 10a-10d, 100) und die erste Oberfläche (301) der Aufnahmeplatte (30, 30', 30", 30a-30h) während der Substratbehandlung eine ebene Oberfläche bilden.

14. Behandlungsvorrichtung (3, 3a, 3b, 3', 3"a-3"c) nach Anspruch 12 oder 13, **dadurch gekennzeichnet, dass** die Behandlungsvorrichtung (3, 3a, 3b, 3', 3"a-3"c) eine Plasmabehandlungsvorrichtung ist und weiterhin eine Vorrichtung zum Anlegen einer ersten Spannung an die Aufnahmeplatte (30, 30', 30", 30a-30h) und einer zweiten Spannung an eine erste Elektrode, die in vertikaler Richtung über der Aufnahmeplatte und parallel zu dieser angeordnet und von der Aufnahmeplatte (30, 30', 30", 30a-30h) elektrisch isoliert ist, aufweist und die Aufnahmeplatte (30, 30', 30", 30a-30h) eine zweite Elektrode in einem aus der ersten Elektrode und der Aufnahmeplatte (30, 30', 30", 30a-30h) bestehenden Parallelplattenreaktor ist.

15. Behandlungsvorrichtung (3, 3a, 3b, 3', 3"a-3"c) nach Anspruch 14, **dadurch gekennzeichnet, dass** die Aufnahmeplatte (30, 30', 30", 30a-30h) vollständig aus einem elektrisch leitfähigen Material besteht.

16. Behandlungsvorrichtung (3, 3a, 3b, 3', 3"a-3"c) nach Anspruch 14, **dadurch gekennzeichnet, dass** die Aufnahmeplatte (30, 30', 30", 30a-30h) zumindest in einem Bereich, der an die erste Oberfläche (301) angrenzt, aus einem Schichtaufbau aus einem elektrisch leitfähigen Material und einem dielektrischen Material besteht, wobei das dielektrische Material an die erste Oberfläche (301) der Aufnahmeplatte (30, 30', 30", 30a-30h) angrenzt.

17. Behandlungsvorrichtung (3, 3a, 3b, 3', 3"a-3"c) nach einem der Ansprüche 12 bis 16, **dadurch gekennzeichnet, dass** die Aufnahmeplatte (30', 30") eine Einrichtung (32) zum Temperieren der Aufnahmeplatte (30', 30") enthält.

18. Behandlungsvorrichtung (3, 3a, 3b, 3', 3"a-3"c) nach Anspruch 17, **dadurch gekennzeichnet, dass** die Behandlungsvorrichtung (3, 3a, 3b, 3', 3"a-3"c) eine CVD-Beschichtungsanlage ist und die Aufnahmeplatte (30", 30e-30g) in einem in vertikaler Richtung oberen Bereich einen Flächenheizer (32a), der geeignet ist, den oberen Bereich (303) auf eine erste Temperatur aufzuheizen, einen Gasverteiler (33) in einem in vertikaler Richtung unteren Bereich (304), der Mittel zur Temperierung des unteren Bereiches (304) auf eine zweite Temperatur aufweist, und eine Anordnung (37) zur Wärmeisolation, die zwischen dem oberen und dem unteren Bereich (303, 304) angeordnet und geeignet ist, einen Wärmefluss von dem oberen Bereich (303) zum unteren Bereich (304) zu verringern, enthält, wobei die zweite Temperatur kleiner als die erste Temperatur ist.

19. Behandlungsvorrichtung (3, 3a, 3b, 3', 3"a-3"c) nach einem der Ansprüche 12 bis 18, **dadurch gekennzeichnet, dass** die Vertiefung (31) in der ersten Oberfläche (301) der Aufnahmeplatte (30, 30', 30", 30a-30h) eine Form aufweist, die eine Selbstjustage des Substratträgers (10, 10', 10", 10a-10d, 100) in der Vertiefung (31) ermöglicht.

20. Behandlungsvorrichtung (3a, 3b) nach einem der Ansprüche 12 bis 19, **dadurch gekennzeichnet, dass** die Behandlungsvorrichtung (3a, 3b) mehrere, übereinander angeordnete Aufnahmeplatten (30a-30h) aufweist, von denen jede geeignet ist, einen Substratträger (10a-10d) der Vorrichtung nach Anspruch 10 aufzunehmen.

21. Verfahren zum Prozessieren eines Substrates (2, 2a-2d) in einer Behandlungsanlage (400), wobei die Behandlungsanlage (400) eine Behandlungsvorrichtung (3, 3a, 3b, 3', 3"a-3"b) mit einer Aufnahmeplatte (30, 30', 30", 30a-30h), auf der das Substrat (2, 2a-2d) während der Behandlung gehaltert wird, nach einem der Ansprüche 12 bis 20 enthält, mit den Schritten:
a) Auflegen des Substrates (2, 2a-2d) auf einen Substratträger (10, 10', 10", 10a-10d, 100) einer Vorrichtung (1, 1', 1") zum Transport eines Substrates (2, 2a-2d) nach einem der Ansprüche 1 bis 11,
b) Bewegen des Substratträgers (10, 10', 10", 10a-10d, 100) in mindestens einer horizontalen Richtung, bis der Substratträger (10, 10', 10", 10a-10d, 100) in vertikaler Richtung oberhalb einer Aufnahmeplatte (30, 30', 30", 30a-30h) der Behandlungsvorrichtung (3, 3a, 3b, 3', 3"a-3"b) angeordnet ist,
c) Ablegen des Substratträgers (10, 10', 10", 10a-10d, 100) auf der Aufnahmeplatte (30, 30', 30", 30a-30h),
d) Behandeln des Substrates (2, 2a-2d) in der Behandlungsvorrichtung (3, 3a, 3b, 3', 3"a-3"b),
e) Abheben des Substratträgers (10, 10', 10", 10a-10d, 100) von der Aufnahmeplatte (30, 30', 30", 30a-30h) in vertikaler Richtung,
f) Bewegen des Substratträgers (10, 10', 10", 10a-10d, 100) in mindestens einer horizontalen Richtung aus der Behandlungsvorrichtung (3, 3a, 3b, 3', 3"a-3"b) heraus,
g) Entnehmen des Substrates (2, 2a-2d) von dem Substratträger (10, 10', 10", 10a-10d, 100),
wobei die Schritte in der angegebenen Reihenfolge ausgeführt werden.

22. Verfahren nach Anspruch 21, **dadurch gekennzeichnet, dass** die Behandlungsanlage (400) mehrere Behandlungsvorrichtungen (3, 3a, 3b, 3', 3"a-3"b) nach einem der Ansprüche 12 bis 19 aufweist und die Schritte b) bis f) mehrmals hintereinander ausgeführt werden, wobei das Substrat (2, 2a-2d) nacheinander in verschiedene Behandlungsvorrichtungen (3, 3a, 3b, 3', 3"a-3"b) ein- und ausgebracht und in diesen behandelt wird.

23. Verfahren nach Anspruch 22, **dadurch gekennzeichnet, dass** die mehrmals hintereinander ausgeführten Schritte b) bis f) ohne Unterbrechung eines Vakuums in der Behandlungsanlage (400) ausgeführt werden.

24. Verfahren nach einem der Ansprüche 21 bis 23, **dadurch gekennzeichnet, dass** die Behandlungsanlage (400) eine Behandlungsvorrichtung (3, 3a, 3b, 3', 3"a-3"b) nach einem der Ansprüche 12 bis 20 enthält und der Substratträger in Schritt c) in der Vertiefung (31) der Aufnahmeplatte (30, 30', 30", 30a-30h) abgelegt wird.

25. Behandlungsanlage (400) zum Prozessieren eines oder mehrerer Substrate (2, 2a-2d), aufweisend eine Beladekammer (410), mindestens eine Behandlungskammer (430, 430', 430") mit mindestens einer Behandlungsvorrichtung (3, 3a, 3b, 3', 3"a-3"b) mit einer Aufnahmeplatte (30, 30', 30", 30a-30h), auf der das Substrat während der Behandlung gehaltert wird, und eine Entladekammer (450), **dadurch gekennzeichnet, dass**
- die Behandlungsanlage (400) eine Bewegungsanordnung (470) aufweist, die geeignet ist, eine Vorrichtung (1, 1', 1") zum Transport eines Substrates (2, 2a-2d) nach einem der Ansprüche 1 bis 11 aufzunehmen und in die mindestens eine Behandlungskammer (430, 430', 430") hinein und aus dieser heraus sowie den Substratträger (10, 10', 10", 10a-10d, 100) der Vorrichtung (1, 1', 1") zum Transport eines Substrates (2, 2a-2d) in der Behandlungskammer (430, 430', 430") in mindestens eine horizontal verlaufende Richtung und in vertikale Richtung zu bewegen, und dass
- die Beladekammer (410) für das Positionieren des oder der Substrate (2, 2a-2d) auf dem Substratträger (10, 10', 10", 10a-10d, 100) der Vorrichtung (1, 1', 1") zum Transport des Substrates (2, 2a-2d) und die Entladekammer (450) für das Entnehmen des oder der Substrate (2, 2a-2d) von dem Substratträger (10, 10', 10", 10a-10d, 100) geeignet sind.

26. Behandlungsanlage (400) nach Anspruch 25, **dadurch gekennzeichnet, dass** mindestens eine Behandlungsvorrichtung (3, 3a, 3b, 3', 3"a-3"b) eine Behandlungsvorrichtung (3, 3a, 3b, 3', 3"a-3"b) nach einem der Ansprüche 12 bis 20 ist.

27. Behandlungsanlage (400) nach Anspruch 25 oder 26, **dadurch gekennzeichnet, dass** mindestens eine der mindestens einen Behandlungskammer (430, 430', 430") eine Vakuumkammer ist, die von einer angrenzenden Kammer durch gasdichte Schieberventile (460) getrennt ist.

28. Behandlungsanlage (400) nach Anspruch 25 oder 26, **dadurch gekennzeichnet, dass** die Behandlungsanlage (400) mehrere Behandlungskammern (430, 430', 430") aufweist, die jeweils Vakuumkammern sind und die untereinander mittels gasdichter Schieberventile (460) verbunden sind, und dass die Bewegungsanordnung (470) geeignet ist, die Vorrichtung (1, 1', 1") zum Transport eines Substrates (2, 2a-2d) durch alle Behandlungskammern (430, 430', 430") ohne Unterbrechung des Vakuums zu bewegen.

29. Behandlungsanlage (400) nach einem der Ansprüche 25 bis 28, **dadurch gekennzeichnet, dass** mindestens die Behandlungskammer (430, 430', 430") eine Kammer mit einer geraden, vertikalen Seitenwand (411), die senkrecht zu einer Wand, welche an die angrenzende Kammer angrenzt, verläuft, ist und die Bewegungsanordnung (470) eine Trägereinheit (471), mindestens ein, in horizontaler oder vertikaler Richtung sich erstreckendes Führungssystem (472) und eine Mehrzahl von Führungselementen (473) enthält, wobei
- die Führungselemente (473) an der vertikalen Seitenwand (411) der Behandlungskammer (430, 430', 430") angeordnet und geeignet sind, mit dem an der Trägereinheit (471) auf der der Seitenwand (470) zugewandten Seite angeordneten Führungssystem (472) so zusammenzuwirken, dass die Trägereinheit (471) über die Führungselemente (473) in horizontaler oder vertikaler Richtung entlang der Seitenwand (411) geführt und gehalten wird, und
- die Trägereinheit (471) mit der Vorrichtung (1, 1', 1") zum Transport eines Substrates (2, 2a-2d) auf der der Seitenwand (411) der Behandlungskammer (430, 430', 430") abgewandten Seite der Trägereinheit (471) mechanisch verbunden und geeignet ist, den Substratträger (10, 10', 10", 10a-10d, 100) mindestens in eine Richtung orthogonal zur Richtung, in die sich das Führungssystem (472) erstreckt, zu bewegen.

30. Behandlungsanlage (400) nach Anspruch 29, **dadurch gekennzeichnet, dass** die Trägereinheit (471) geeignet ist, den Substratträger (10, 10', 10", 10a-10d, 100) entlang einer horizontalen Richtung, die orthogonal zu der der Vorrichtung (1, 1', 1") zum Transport eines Substrates (2, 2a-2d) zugewandten Seite der Trägereinheit (471) verläuft, zu bewegen.

31. Behandlungsanlage (400) nach einem der Ansprüche 29 oder 30, **dadurch gekennzeichnet, dass**
- das Führungssystem (472) eine Schiene (472a, 472b) enthält, die in horizontaler Richtung an der Trägereinheit (471) angeordnet ist, und
- die Führungselemente (473) Rollen (476a, 476b) enthalten, die drehbar und in horizontaler Richtung hintereinander an der Seitenwand (411) angeordnet sind, wobei die Rollen (476a, 476b) jeweils mit einem Abstand zueinander angeordnet sind, der so klein ist, dass die Schiene (472a, 472b) an jedem Ort innerhalb der Behandlungsanlage (400) mit mindestens zwei Rollen (476a, 476b) in Kontakt steht.

32. Behandlungsanlage (400) nach einem der Ansprüche 25 bis 31, **dadurch gekennzeichnet, dass**
- die Behandlungsanlage (400) eine lineare Abfolge der Beladekammer (410), der mindestens einen Behandlungskammer (430, 430' ,430") und der Entladekammer (450) aufweist, wobei die Bewegungsanordnung (470) geeignet ist, die Vorrichtung (1, 1', 1") zum Transport eines Substrates (2, 2a-2d) unidirektional von der Beladekammer (410) durch die mindestens eine Behandlungskammer (430, 430', 430") in die Entladekammer (450) zu bewegen, und
- die Bewegungsanordnung (470) weiterhin ein Rückführsystem (475) enthält, welches zum Transport der Vorrichtung (1, 1', 1") zum Transport eines Substrates (2, 2a-2d) von der Entladekammer (450) zur Beladekammer (410) außerhalb der mindestens einen Behandlungskammer (430, 430', 430") geeignet ist.

## Claims

1. Apparatus (1, 1', 1") for transporting a substrate (2, 2a-2d) into or out of a treatment apparatus (3, 3a, 3b, 3', 3"a-3"c), the treatment apparatus (3, 3a, 3b, 3', 3"a-3"c) having a horizontally extending receiving plate (30, 30', 30", 30a-30h) and the apparatus having a substrate carrier (10, 10', 10", 10a-10d, 100) and the substrate carrier (10, 10', 10", 10a-10d, 100) being suitable for positioning the substrate (2, 2a-2d) on a first surface (301) of the receiving plate (30, 30', 30", 30a-30h) and the substrate carrier (10, 10', 10", 10a-10d, 100) being also suitable for holding the substrate (2, 2a-2d) on the receiving plate (30, 30', 30", 30a-30h) during the treatment of the substrate (2, 2a-2d) in the treatment apparatus (3, 3a, 3b, 3', 3"a-3"c), and the substrate carrier (10, 10', 10", 10a-10d, 100) comprising:
- a horizontally extending holding area (11, 11', 11", 11a, 11d) that is even and uniform on a first surface (112) facing the substrate (2, 2a-2d), the shape of said holding area (11, 11', 11", 11a, 11d) substantially corresponding to the shape of the substrate (2, 2a-2d) and the area size of said holding area (11, 11', 11", 11a, 11d) being substantially the same as the area size of the substrate (2, 2a-2d), the substrate (2, 2a-2d) being held with its rear side on the holding area (11, 11', 11", 11a, 11d) merely by its weight, and
- one or a plurality of gripping arms (121, 122),
**characterised in that** each of the gripping arms (121, 122) is connected to the holding area (11, 11', 11", 11a, 11d) and extending beyond said holding area (11, 11', 11", 11a, 11d) in a horizontal direction.

2. Apparatus (1, 1', 1") according to claim 1, **characterised in that** at least two holding devices (13a-13g) extend at least in the vertical direction from the edge (111) and/or from the first surface (112) of the holding area (11, 11', 11", 11a, 11d), which holding devices (13a-13g) are suitable for securing the substrate (2, 2a-2d) against lateral displacement on the holding area (11, 11', 11", 11a, 11d).

3. Apparatus (1, 1', 1") according to claim 2, **characterised in that** the holding devices (13a-13g) extend across the first surface (112) of the holding area (11, 11', 11", 11a, 11d) up to a height measured from the first surface (112) of the holding area (11, 11', 11", 11a, 11d), the height being greater than zero and less than or equal to the height of the substrate (2, 2a-2d).

4. Apparatus (1, 1', 1") according to any of the preceding claims, **characterised in that** the substrate carrier (100) has a plurality of holding areas (11a, 11d) that are arranged next to each other in a lateral arrangement in a common horizontal plane and are physically connected to each other.

5. Apparatus (1, 1', 1") according to claim 4, **characterised in that** the substrate carrier (100) has a closed base body (110), each holding area (11a, 11d) being designed as a base surface of a recess (110a, 110d) formed in a horizontal surface of the base body (110), and holding devices that are suitable for securing the substrates (2a, 2d), each of which rests on one of the holding areas (11a, 11d), against lateral displacement on the respective holding area (11a, 11d) and are formed as a side frame (114a) or as a web (114b) between the holding areas (11a, 11d).

6. Apparatus (1, 1', 1") according to any of the preceding claims, **characterised in that** the components of the substrate carrier (10, 10', 10", 10a-10d, 100) comprise the same material as the first surface (301) of the receiving plate (30, 30', 30", 30a-30h) at least in the regions that are in contact with the substrate (2, 2a-2d) and/or the receiving plate (30, 30', 30", 30a-30h) during the substrate treatment.

7. Apparatus (1, 1', 1") according to any of the preceding claims, **characterised in that** the components of the substrate carrier (10, 10', 10", 10a-10d, 100) comprise an electrically conductive material in the regions that are in contact with the substrate (2, 2a-2d) and/or the receiving plate (30, 30', 30", 30a-30h) during the substrate treatment, and the gripping arm or the plurality of gripping arms (121, 122) comprises a dielectric material in regions that are not in contact with the receiving plate (30, 30', 30", 30a-30h) during the substrate treatment.

8. Apparatus (1, 1', 1") according to any of the preceding claims, **characterised in that** the regions of the substrate carrier (10, 10', 10", 10a-10d, 100) that are in contact with the substrate(s) (2, 2a-2d) and/or the receiving plate (30, 30', 30", 30a-30h) during the substrate treatment have a heat capacity that is smaller than the heat capacity of the receiving plate (30, 30', 30", 30a-30h).

9. Apparatus (1, 1', 1") according to any of the preceding claims, **characterised in that** the apparatus comprises a carrier arrangement (14) on which the substrate carrier (10, 10', 10", 10a-10d, 100) is fastened to the one or more gripping arms (121, 122).

10. Apparatus (1', 1") according to claim 9, **characterised in that** the apparatus (1', 1") comprises a unit (101, 101a, 101b) of a plurality of substrate carriers (10a-10d) that are vertically stacked and connected to the carrier arrangement (14).

11. Apparatus (1") according to claim 10, **characterised in that** the apparatus (1") comprises a plurality of units (101a, 101b) of vertically stacked substrate carriers (10a-10d), the units (101a, 101b) being arranged next to each other in the horizontal direction and connected to the same carrier arrangement (14).

12. Treatment apparatus (3, 3a, 3b, 3', 3"a-3"c) for treating a substrate (2, 2a-2d), comprising a receiving plate (30, 30', 30", 30a-30h) on which the substrate (2, 2a-2d) is held during the treatment,
wherein the receiving plate (30, 30', 30", 30a-30h) has a recess (31) in a first surface (301) that faces the substrate (2, 2a-2d) during the treatment of the substrate,
**characterised in that** the recess (31) is suitable for receiving a substrate carrier (10, 10', 10", 10a-10d, 100) of an apparatus (1, 1', 1") according to any of claims 1 to 11 during the treatment of the substrate (2, 2a-2d).

13. Treatment apparatus (3, 3a, 3b, 3', 3"a-3"c) according to claim 12, **characterised in that** the recess (31) in the first surface (301) of the receiving plate (30, 30', 30", 30a-30h) has a depth (h₃₁₁, h₃₁₂) measured from the first surface (301) of the receiving plate (30, 30', 30", 30a-30h), the depth (h₃₁₁, h₃₁₂) being dimensioned such that the first surface (112) of the holding area (11, 11', 11", 11a, 11d) of the substrate carrier (10, 10', 10", 10a-10d, 100) and the first surface (301) of the receiving plate (30, 30', 30", 30a-30h) form an even surface during the substrate treatment.

14. Treatment apparatus (3, 3a, 3b, 3', 3"a-3"c) according to either claim 12 or claim 13, **characterised in that** the treatment apparatus (3, 3a, 3b, 3', 3"a-3"c) is a plasma treatment apparatus and further comprises an apparatus for applying a first voltage to the receiving plate (30, 30', 30", 30a-30h) and a second voltage to a first electrode that is arranged above the receiving plate (30, 30', 30", 30a-30h) in the vertical direction and parallel thereto and is electrically insulated from the receiving plate (30, 30', 30", 30a-30h), and the receiving plate (30, 30', 30", 30a-30h) is a second electrode in a parallel plate reactor comprising the first electrode and the receiving plate (30, 30', 30", 30a-30h).

15. Treatment apparatus (3, 3a, 3b, 3', 3"a-3"c) according to claim 14, **characterised in that** the receiving plate (30, 30', 30", 30a-30h) consists entirely of an electrically conductive material.

16. Treatment apparatus (3, 3a, 3b, 3', 3"a-3"c) according to claim 14, **characterised in that** the receiving plate (30, 30', 30", 30a-30h) consists of a layer structure of an electrically conductive material and a dielectric material at least in a region adjacent to the first surface (301), the dielectric material being adjacent to the first surface (301) of the receiving plate (30, 30', 30", 30a-30h).

17. Treatment apparatus (3, 3a, 3b, 3', 3"a-3"c) according to any of claims 12 to 16, **characterised in that** the receiving plate (30', 30") includes a device (32) for controlling the temperature of the receiving plate (30', 30").

18. Treatment apparatus (3, 3a, 3b, 3', 3"a-3"c) according to claim 17, **characterised in that** the treatment apparatus (3, 3a, 3b, 3', 3"a-3"c) is a CVD coating system and the receiving plate (30", 30e-30g) includes an area heater (32a) in a vertically upper region, which area heater (32a) is suitable for heating the upper region (303) to a first temperature, a gas distributor (33) in a vertically lower region (304), which gas distributor (33) has means for bringing the temperature of the lower region (304) to a second temperature, and an arrangement (37) for thermal insulation that is arranged between the upper region (303) and the lower region (304) and is suitable for reducing heat flow from the upper region (303) to the lower region (304), the second temperature being lower than the first temperature.

19. Treatment apparatus (3, 3a, 3b, 3', 3"a-3"c) according to any of claims 12 to 18, **characterised in that** the recess (31) in the first surface (301) of the receiving plate (30, 30', 30", 30a-30h) has a shape that allows self-adjustment of the substrate carrier (10, 10', 10", 10a-10d, 100) in the recess (31).

20. Treatment apparatus (3a, 3b) according to any of claims 12 to 19, **characterised in that** the treatment apparatus (3a, 3b) comprises a plurality of superposed receiving plates (30a-30h), each of which is suitable for receiving a substrate carrier (10a-10d) of the apparatus according to claim 10.

21. Method of processing a substrate (2, 2a-2d) in a treatment system (400), the treatment system (400) including a treatment apparatus (3, 3a, 3b, 3', 3"a-3"b) having a receiving plate (30, 30', 30", 30a-30h) on which the substrate (2, 2a-2d) is held during treatment according to any of claims 12 to 20, comprising the following steps:
a) placing the substrate (2, 2a-2d) onto a substrate carrier (10, 10', 10", 10a-10d, 100) of an apparatus (1, 1', 1") for transporting a substrate (2, 2a-2d) according to any of claims 1 to 11,
b) moving the substrate carrier (10, 10', 10", 10a-10d, 100) in at least one horizontal direction until the substrate carrier (10, 10', 10", 10a-10d, 100) is arranged above a receiving plate (30, 30', 30", 30a-30h) of the treatment apparatus (3, 3a, 3b, 3', 3"a-3"b) in a vertical direction,
c) placing the substrate carrier (10, 10', 10", 10a-10d, 100) on the receiving plate (30, 30', 30", 30a-30h),
d) treating the substrate (2, 2a-2d) in the treatment apparatus (3, 3a, 3b, 3', 3"a-3"b),
e) lifting the substrate carrier (10, 10', 10", 10a-10d, 100) off the receiving plate (30, 30', 30", 30a-30h) in the vertical direction,
f) moving the substrate carrier (10, 10', 10", 10a-10d, 100) out of the treatment apparatus (3, 3a, 3b, 3', 3"a-3"b) in at least one horizontal direction,
g) removing the substrate (2, 2a-2d) from the substrate carrier(10, 10', 10", 10a-10d, 100), the steps being performed in the order specified.

22. Method according to claim 21, **characterised in that** the treatment system (400) comprises a plurality of treatment apparatuses (3, 3a, 3b, 3', 3"a-3"b) according to any of claims 12 to 19 and steps b) to f) are carried out a plurality of times in succession, the substrate (2, 2a-2d) being successively introduced into and removed from various treatment apparatuses (3, 3a, 3b, 3', 3"a-3"b) and treated therein.

23. Method according to claim 22, **characterised in that** steps b) to f), which are performed a plurality of times in succession, are performed without interrupting a vacuum in the treatment system (400).

24. Method according to any of claims 21 to 23, **characterised in that** the treatment system (400) includes a treatment apparatus (3, 3a, 3b, 3', 3"a-3"b) according to any of claims 12 to 20 and the substrate carrier is placed in the recess (31) of the receiving plate (30, 30', 30", 30a-30h) in step c).

25. Treatment system (400) for processing one or a plurality of substrates (2, 2a-2d) comprising a loading chamber (401), at least one treatment chamber (430, 430', 430") having at least one treatment apparatus (3, 3a, 3b, 3', 3"a-3"b) having a receiving plate (30, 30', 30", 30a-30h) on which the substrate is held during the treatment, and an unloading chamber (450), **characterised in that**
- the treatment system (400) has a movement arrangement (470) that is suitable for receiving an apparatus (1, 1', 1") for transporting a substrate (2, 2a-2d) according to any of claims 1 to 11 and for moving the apparatus (1, 1', 1") for transporting a substrate into and out of the at least one treatment chamber (430 ,430', 430") as well as for moving the substrate carrier (10, 10', 10", 10a-10d, 100) of the apparatus (1, 1', 1") for transporting a substrate (2, 2a-2d) in at least one horizontally extending direction and in vertical direction within the treatment chamber (430, 430', 430"), and **in that**
- the loading chamber (410) is suitable for positioning the substrate(s) (2, 2a-2d) on the substrate carrier (10, 10', 10", 10a-10d, 100) of the apparatus (1, 1', 1") for transporting the substrate (2, 2a-2d) and the unloading chamber (450) is suitable for removing the substrate(s) (2, 2a-2d) from the substrate carrier (10, 10', 10", 10a-10d, 100).

26. Treatment system (400) according to claim 25, **characterised in that** at least one treatment apparatus (3, 3a, 3b, 3', 3"a-3"b) is a treatment apparatus (3, 3a, 3b, 3', 3"a-3"b) according to any of claims 12 to 20.

27. Treatment system (400) according to either claim 25 or claim 26, **characterised in that** at least one of the at least one treatment chamber (430, 430', 430") is a vacuum chamber that is separated from an adjacent chamber by gastight slide valves (460).

28. Treatment system (400) according to either claim 25 or claim 26, **characterised in that** the treatment system (400) comprises a plurality of treatment chambers (430, 430', 430") that are each vacuum chambers and are interconnected by means of gastight slide valves (460) and **in that** the movement arrangement (470) is suitable for moving the apparatus (1, 1', 1") for transporting a substrate (2, 2a-2d) through all the treatment chambers (430, 430', 430") without interrupting the vacuum.

29. Treatment system (400) according to any of claims 25 to 28, **characterised in that** at least the treatment chamber (430, 430', 430") is a chamber having a straight, vertical side wall (411) that is perpendicular to a wall adjacent to the adjacent chamber and the movement assembly (470) includes a carrier unit (471), at least one guidance system (472) extending in a horizontal or vertical direction and a plurality of guide elements (473),
- the guide elements (473) being arranged on the vertical side wall (411) of the treatment chamber (430, 430', 430") and being suitable for cooperating with the guidance system (472) arranged on the carrier unit (471) on the side facing the side wall (470) such that the carrier unit (471) is guided and held along the side wall (411) in the horizontal or vertical direction by means of the guide elements (473), and
- the carrier unit (471) being mechanically connected to the apparatus (1, 1', 1") for transporting a substrate (2, 2a-2d) on the side of the carrier unit (471) facing away from the side wall (411) of the treatment chamber (430, 430', 430") and being suitable for moving the substrate carrier (10, 10', 10", 10a-10d, 100) at least in a direction orthogonal to the direction in which the guidance system (472) extends.

30. Treatment system (400) according to claim 29, **characterised in that** the carrier unit (471) is suitable for moving the substrate carrier (10, 10', 10", 10a-10d, 100) along a horizontal direction that is orthogonal to the side of the carrier unit (471) facing the apparatus (1, 1', 1") for transporting a substrate (2, 2a-2d).

31. Treatment system (400) according to either claim 29 or claim 30, **characterised in that**
- the guidance system (472) includes a rail (472a, 472b) that is arranged on the carrier unit (471) in the horizontal direction, and
- the guide elements (473) include rollers (476a, 476b) that are arranged on the side wall (411) rotatably and one behind the other in the horizontal direction, the rollers (476a, 476b) each being spaced apart from each other at a distance that is so small that the rail (472a, 472b) is in contact with at least two rollers (476a, 476b) at any location within the treatment system (400).

32. Treatment system (400) according to any of claims 25 to 31, **characterised in that**
- the treatment system (400) comprises a linear sequence of the loading chamber (410), the at least one treatment chamber (430, 430', 430") and the unloading chamber (450), the movement arrangement (470) being suitable for moving the apparatus (1, 1', 1") for transporting a substrate (2, 2a-2d) unidirectionally from the loading chamber (410) to the unloading chamber (450) through the at least one treatment chamber (430, 430', 430"), and
- the movement arrangement (470) further includes a return system (475) that is suitable for transporting the apparatus (1, 1', 1") for transporting a substrate (2, 2a-2d) from the unloading chamber (450) to the loading chamber (410) outside the at least one treatment chamber (430, 430', 430").

## Revendications

1. Dispositif (1, 1', 1") permettant de transporter un substrat (2, 2a-2d) dans ou hors d'un dispositif de traitement (3, 3a, 3b, 3', 3"a-3"c), le dispositif de traitement (3, 3a, 3b, 3', 3"a-3"c) présentant une plaque de réception (30, 30', 30", 30a-30h) s'étendant horizontalement et le dispositif présentant un support de substrat (10, 10', 10", 10a-10d, 100) et le support de substrat (10, 10', 10", 10a-10d, 100) étant adapté pour positionner le substrat (2, 2a-2d) sur une première surface (301) de la plaque de réception (30, 30', 30", 30a-30h), et le support de substrat (10, 10', 10", 10a-10d, 100) étant en outre adapté pour maintenir le substrat (2, 2a-2d) sur la plaque de réception (30, 30', 30", 30a-30h) pendant le traitement du substrat (2, 2a-2d) dans le dispositif de traitement (3, 3a, 3b, 3', 3"a-3"c), et le support de substrat (10, 10', 10", 10a-10d, 100) présentant :
- une surface de maintien (11, 11', 11", 11a, 11d) s'étendant horizontalement qui est formée de manière plane et uniforme sur une première surface (112) faisant face au substrat (2, 2a-2d), dont la forme correspond sensiblement à la forme du substrat (2, 2a-2d) et dont la surface est sensiblement identique à la surface du substrat (2, 2a-2d), le substrat (2, 2a-2d) étant maintenu avec sa face arrière sur la surface de maintien (11, 11', 11", 11a, 11d) uniquement grâce à son poids, et
- un ou plusieurs bras de préhension (121, 122),
**caractérisé en ce que** chacun des bras de préhension (121, 122) est relié à la surface de maintien (11, 11', 11", 11a, 11d) et s'étend au-delà de celle-ci dans une direction horizontale.

2. Dispositif (1, 1', 1") selon la revendication 1, **caractérisé en ce qu'**au moins deux dispositifs de maintien (13a-13g) s'étendent au moins dans la direction verticale à partir du bord (111) et/ou de la première surface (112) de la surface de maintien (11, 11', 11", 11a, 11d), lesquels dispositifs de maintien sont adaptés pour fixer le substrat (2, 2a-2d) contre un déplacement latéral sur la surface de maintien (11, 11', 11", 11a, 11d).

3. Dispositif (1, 1', 1") selon la revendication 2, **caractérisé en ce que** les dispositifs de maintien (13a-13g) s'étendent sur la première surface (112) de la surface de maintien (11, 11', 11", 11a, 11d) jusqu'à une hauteur mesurée à partir de la première surface (112) de la surface de maintien (11, 11', 11", 11a, 11d), la hauteur étant supérieure à zéro et inférieure ou égale à la hauteur du substrat (2, 2a-2d).

4. Dispositif (1, 1', 1") selon l'une des revendications précédentes, **caractérisé en ce que** le support de substrat (100) présente plusieurs surfaces de maintien (11a, 11d) disposées les unes à côté des autres dans un plan horizontal commun dans une disposition latérale et physiquement reliées les unes aux autres.

5. Dispositif (1, 1', 1") selon la revendication 4, **caractérisé en ce que** le support de substrat (100) présente un corps de base (110) fermé, chaque surface de maintien (11a, 11d) étant conçue en tant que surface de base d'un évidement (110a, 110d) qui est formé dans une surface horizontale du corps de base (110), et des dispositifs de maintien qui sont adaptés pour fixer les substrats (2a, 2d), dont chacun repose sur l'une des surfaces de maintien (11a, 11d), contre un déplacement latéral sur la surface de maintien (11a, 11d) respective, les dispositifs de maintien étant formés en tant que cadre latéral (114a) ou en tant qu'entretoise (114b) entre les surfaces de maintien (11a, 11d).

6. Dispositif (1, 1', 1") selon l'une des revendications précédentes, **caractérisé en ce que** les composants du support de substrat (10, 10', 10", 10a-10d, 100) sont réalisés à partir du même matériau que la première surface (301) de la plaque de réception (30, 30', 30", 30a-30h), au moins dans les zones qui sont en contact avec le substrat (2, 2a-2d) et/ou avec la plaque de réception (30, 30', 30", 30a-30h) pendant le traitement de substrat.

7. Dispositif (1, 1', 1") selon l'une des revendications précédentes, **caractérisé en ce que** les composants du support de substrat (10, 10', 10", 10a-10d, 100) sont réalisés à partir d'un matériau électriquement conducteur dans les zones qui sont en contact avec le substrat (2, 2a-2d) et/ou avec la plaque de réception (30, 30', 30", 30a-30h) pendant le traitement de substrat, et le ou les bras de préhension (121, 122) sont réalisés à partir d'un matériau diélectrique dans les zones qui ne sont pas en contact avec la plaque de réception (30, 30', 30", 30a-30h) pendant le traitement de substrat.

8. Dispositif (1, 1', 1") selon l'une des revendications précédentes, **caractérisé en ce que** les zones du support de substrat (10, 10', 10", 10a-10d, 100) qui sont en contact avec le ou les substrats (2, 2a-2d) et/ou avec la plaque de réception (30, 30', 30", 30a-30h) pendant le traitement de substrat présentent une capacité thermique qui est inférieure à la capacité thermique de la plaque de réception (30, 30', 30", 30a-30h).

9. Dispositif (1, 1', 1") selon l'une des revendications précédentes, **caractérisé en ce que** le dispositif présente un agencement de support (14) sur lequel le support de substrat (10, 10', 10", 10a-10d, 100) est fixé avec le ou les bras de préhension (121, 122).

10. Dispositif (1', 1") selon la revendication 9, **caractérisé en ce que** le dispositif (1', 1") présente une unité (101, 101a, 101b) de plusieurs supports de substrat (10a-10d) qui sont disposés verticalement les uns au-dessus des autres et sont reliés à l'agencement de support (14).

11. Dispositif (1") selon la revendication 10, **caractérisé en ce que** le dispositif (1") présente plusieurs unités (101a, 101b) de supports de substrat (10a-10d) disposés verticalement les uns au-dessus des autres, les unités (101a, 101b) étant disposées les unes à côté des autres dans la direction horizontale et étant reliées au même agencement de support (14).

12. Dispositif de traitement (3, 3a, 3b, 3', 3"a-3"c) permettant de traiter un substrat (2, 2a-2d), présentant une plaque de réception (30, 30', 30", 30a-30h) sur laquelle le substrat (2, 2a-2d) est maintenu pendant le traitement, la plaque de réception (30, 30', 30", 30a-30h) présentant un évidement (31) dans une première surface (301) qui fait face au substrat (2, 2a-2d) pendant le traitement de substrat, **caractérisé en ce que** l'évidement (31) est adapté pour recevoir un support de substrat (10, 10', 10", 10a-10d, 100) d'un dispositif (1, 1', 1") selon l'une des revendications 1 à 11 pendant le traitement du substrat (2, 2a-2d).

13. Dispositif de traitement (3, 3a, 3b, 3', 3"a-3"c) selon la revendication 12, **caractérisé en ce que** l'évidement (31) présente une profondeur (h₃₁₁, h₃₁₂) mesurée à partir de la première surface (301) de la plaque de réception (30, 30', 30", 30a-30h) dans la première surface (301) de la plaque de réception (30, 30', 30", 30a-30h), laquelle profondeur est dimensionnée de telle sorte que la première surface (112) de la surface de maintien (11, 11', 11", 11a, 11d) du support de substrat (10, 10', 10", 10a-10d, 100) et la première surface (301) de la plaque de réception (30, 30', 30", 30a-30h) forment une surface plane pendant le traitement de substrat.

14. Dispositif de traitement (3, 3a, 3b, 3', 3"a-3"c) selon la revendication 12 ou 13, **caractérisé en ce que** le dispositif de traitement (3, 3a, 3b, 3', 3"a-3"c) est un dispositif de traitement plasma et présente en outre un dispositif permettant d'appliquer une première tension à la plaque de réception (30, 30', 30", 30a-30h) et une seconde tension à une première électrode, qui est disposée dans la direction verticale sur la plaque de réception et parallèlement à celle-ci et est électriquement isolée de la plaque de réception (30, 30', 30", 30a-30h), et la plaque de réception (30, 30', 30", 30a-30h) est une seconde électrode dans un réacteur à plaques parallèles se situant parmi la première électrode et la plaque de réception (30, 30', 30", 30a-30h).

15. Dispositif de traitement (3, 3a, 3b, 3', 3"a-3"c) selon la revendication 14, **caractérisé en ce que** la plaque de réception (30, 30', 30", 30a-30h) est entièrement constituée d'un matériau électriquement conducteur.

16. Dispositif de traitement (3, 3a, 3b, 3', 3"a-3"c) selon la revendication 14, **caractérisé en ce que** la plaque de réception (30, 30', 30", 30a-30h) est constituée d'une structure de couche en un matériau électriquement conducteur et en un matériau diélectrique, au moins dans une zone adjacente à la première surface (301), le matériau diélectrique étant adjacent à la première surface (301) de la plaque de réception (30, 30', 30", 30a-30h).

17. Dispositif de traitement (3, 3a, 3b, 3', 3"a-3"c) selon l'une des revendications 12 à 16, **caractérisé en ce que** la plaque de réception (30', 30") contient un appareil (32) permettant de tempérer la plaque de réception (30', 30").

18. Dispositif de traitement (3, 3a, 3b, 3', 3"a-3"c) selon la revendication 17, **caractérisé en ce que** le dispositif de traitement (3, 3a, 3b, 3', 3"a-3"c) est un système de revêtement CVD et la plaque de réception (30", 30e-30g) contient un chauffage de surface (32a) dans une zone supérieure dans la direction verticale, lequel est adapté pour chauffer la zone supérieure (303) à une première température, un distributeur de gaz (33) dans une zone inférieure (304) dans la direction verticale, lequel présente des moyens permettant de tempérer la zone inférieure (304) à une seconde température, et un agencement (37) d'isolation thermique, lequel est disposé entre la zone supérieure et la zone inférieure (303, 304) et est adapté pour réduire un flux thermique de la zone supérieure (303) à la zone inférieure (304), la seconde température étant inférieure à la première température.

19. Dispositif de traitement (3, 3a, 3b, 3', 3"a-3"c) selon l'une des revendications 12 à 18, **caractérisé en ce que** l'évidement (31) présente une forme dans la première surface (301) de la plaque de réception (30, 30', 30", 30a-30h) qui permet un auto-ajustement du support de substrat (10, 10', 10", 10a-10d, 100) dans l'évidement (31).

20. Dispositif de traitement (3a, 3b) selon l'une des revendications 12 à 19, **caractérisé en ce que** le dispositif de traitement (3a, 3b) présente plusieurs plaques de réception (30a-30h) disposées les unes au-dessus des autres et dont chacune étant adapté pour recevoir un support de substrat (10a-10d) du dispositif selon la revendication 10.

21. Procédé de traitement d'un substrat (2, 2a-2d) dans un système de traitement (400), le système de traitement (400) contenant un dispositif de traitement (3, 3a, 3b, 3', 3"a-3"b) comportant une plaque de réception (30, 30', 30", 30a-30h) selon l'une des revendications 12 à 20, sur laquelle le substrat (2, 2a-2d) est maintenu pendant le traitement, comportant les étapes de :
a) dépôt du substrat (2, 2a-2d) sur un support de substrat (10, 10', 10", 10a-10d, 100) d'un dispositif (1, 1', 1") permettant de transporter un substrat (2, 2a-2d) selon l'une des revendications 1 à 11,
b) déplacement du support de substrat (10, 10', 10", 10a-10d, 100) dans au moins une direction horizontale jusqu'à ce que le support de substrat (10, 10', 10", 10a-10d, 100) soit disposé dans la direction verticale au-dessus d'une plaque de réception (30, 30', 30", 30a-30h) du dispositif de traitement (3, 3a, 3b, 3', 3"a-3"b),
c) placement du support de substrat (10, 10', 10", 10a-10d, 100) sur la plaque de réception (30, 30', 30", 30a-30h),
d) traitement du substrat (2, 2a-2d) dans le dispositif de traitement (3, 3a, 3b, 3', 3"a-3"b),
e) soulèvement du support de substrat (10, 10', 10", 10a-10d, 100) depuis la plaque de réception (30, 30', 30", 30a-30h) dans la direction verticale,
f) déplacement du support de substrat (10, 10', 10", 10a-10d, 100) hors du dispositif de traitement (3, 3a, 3b, 3', 3"a-3"b) dans au moins une direction horizontale,
g) retrait du substrat (2, 2a-2d) hors du support de substrat (10, 10', 10", 10a-10d, 100), les étapes étant effectuées dans l'ordre indiqué.

22. Procédé selon la revendication 21, **caractérisé en ce que** le système de traitement (400) présente plusieurs dispositifs de traitement (3, 3a, 3b, 3', 3"a-3"b) selon l'une des revendications 12 à 19 et les étapes b) à f) sont effectuées plusieurs fois de suite, le substrat (2, 2a-2d) étant successivement amené dans et sorti de différents dispositifs de traitement (3, 3a, 3b, 3', 3"a-3"b) et traité dans ceux-ci.

23. Procédé selon la revendication 22, **caractérisé en ce que** les étapes b) à f), effectuées plusieurs fois de suite, sont effectuées sans interruption de vide dans le système de traitement (400).

24. Procédé selon l'une des revendications 21 à 23, **caractérisé en ce que** le système de traitement (400) contient un dispositif de traitement (3, 3a, 3b, 3', 3"a-3"b) selon l'une des revendications 12 à 20 et le support de substrat est placé dans l'évidement (31) de la plaque de réception (30, 30', 30", 30a-30h) à l'étape c).

25. Système de traitement (400) permettant de traiter un ou plusieurs substrats (2, 2a-2d), présentant une chambre de chargement (410), au moins une chambre de traitement (430, 430', 430") comportant au moins un dispositif de traitement (3, 3a, 3b, 3', 3"a-3"b) comportant une plaque de réception (30, 30', 30", 30a-30h) sur laquelle le substrat est maintenu pendant le traitement, et une chambre de déchargement (450), **caractérisé en ce que**
- le système de traitement (400) présente un agencement de déplacement (470) qui est adapté pour recevoir un dispositif (1, 1', 1") permettant de transporter un substrat (2, 2a-2d) selon l'une des revendications 1 à 11 et de le déplacer dans et hors de l'au moins une chambre de traitement (430, 430', 430") ainsi que pour déplacer le support de substrat (10, 10', 10", 10a-10d, 100) du dispositif (1, 1', 1") permettant de transporter un substrat (2, 2a-2d) dans la chambre de traitement (430, 430', 430") dans au moins une direction s'étendant horizontalement et dans une direction verticale, et **en ce que**
- la chambre de chargement (410) est adaptée pour le positionnement du ou des substrats (2, 2a-2d) sur le support de substrat (10, 10', 10", 10a-10d, 100) du dispositif (1, 1', 1") permettant de transporter le substrat (2, 2a-2d) et la chambre de déchargement (450) est adaptée pour le retrait du ou des substrats (2, 2a-2d) hors du support de substrat (10, 10', 10", 10a-10d, 100).

26. Système de traitement (400) selon la revendication 25, **caractérisé en ce qu'**au moins un dispositif de traitement (3, 3a, 3b, 3', 3"a-3"b) est un dispositif de traitement (3, 3a, 3b, 3', 3"a-3"b) selon l'une des revendications 12 à 20.

27. Système de traitement (400) selon la revendication 25 ou 26, **caractérisé en ce qu'**au moins une des au moins une chambre de traitement (430, 430', 430") est une chambre à vide qui est séparée d'une chambre adjacente par une vanne à passage direct étanche au gaz (460).

28. Système de traitement (400) selon la revendication 25 ou 26, **caractérisé en ce que** le système de traitement (400) présente plusieurs chambres de traitement (430, 430', 430") qui sont respectivement des chambres à vide et qui sont reliées entre elles au moyen de vannes à passage direct étanches au gaz (460), et **en ce que** l'agencement de déplacement (470) est adapté pour déplacer le dispositif (1, 1', 1") permettant de transporter un substrat (2, 2a-2d) à travers toutes les chambres de traitement (430, 430', 430") sans interrompre le vide.

29. Système de traitement (400) selon l'une des revendications 25 à 28, **caractérisé en ce qu'**au moins la chambre de traitement (430, 430', 430") est une chambre comportant une paroi latérale (411) droite et verticale perpendiculaire à une paroi adjacente à la chambre adjacente, et l'agencement de déplacement (470) contient une unité de support (471), au moins un système de guidage (472) s'étendant dans la direction horizontale ou verticale et une pluralité d'éléments de guidage (473),
- les éléments de guidage (473) étant disposés sur la paroi latérale (411) verticale de la chambre de traitement (430, 430', 430") et étant adaptés pour coopérer avec le système de guidage (472) disposé sur l'unité de support (471) sur le côté faisant face à la paroi latérale (470) de telle sorte que l'unité de support (471) est guidée et est maintenue par l'intermédiaire des éléments de guidage (473) dans la direction horizontale ou verticale le long de la paroi latérale (411), et
- l'unité de support (471) étant reliée de manière mécanique au dispositif (1, 1', 1") permettant de transporter un substrat (2, 2a-2d) sur le côté de l'unité de support (471) opposé à la paroi latérale (411) de la chambre de traitement (430, 430', 430") et étant adaptée pour déplacer le support de substrat (10, 10', 10", 10a-10d, 100) au moins dans une direction orthogonale à la direction dans laquelle s'étend le système de guidage (472).

30. Système de traitement (400) selon la revendication 29, **caractérisé en ce que** l'unité de support (471) est adaptée pour déplacer le support de substrat (10, 10', 10", 10a-10d, 100) le long d'une direction horizontale orthogonale au côté de l'unité de support (471) faisant face au dispositif (1, 1', 1") permettant de transporter un substrat (2, 2a-2d).

31. Système de traitement (400) selon l'une des revendications 29 ou 30, **caractérisé en ce que**
- le système de guidage (472) contient un rail (472a, 472b) qui est disposé dans la direction horizontale sur l'unité de support (471), et
- les éléments de guidage (473) contiennent des rouleaux (476a, 476b) qui sont disposés en rotation et dans la direction horizontale les uns derrière les autres sur la paroi latérale (411), les rouleaux (476a, 476b) étant respectivement disposés à une distance les uns des autres qui est assez petite pour que le rail (472a, 472b) soit en contact avec au moins deux rouleaux (476a, 476b) à chaque emplacement à l'intérieur du système de traitement (400).

32. Système de traitement (400) selon l'une des revendications 25 à 31, **caractérisé en ce que**
- le système de traitement (400) présente une séquence linéaire de la chambre de chargement (410) qui présente au moins une chambre de traitement (430, 430', 430") et la chambre de déchargement (450), l'agencement de déplacement (470) étant adapté pour déplacer le dispositif (1, 1', 1") permettant de transporter un substrat (2, 2a-2d) de façon unidirectionnelle depuis la chambre de chargement (410) à travers l'au moins une chambre de traitement (430, 430', 430") jusque dans la chambre de déchargement (450), et
- le dispositif de déplacement (470) contient en outre un système de retour (475) qui est adapté pour permettre de transporter le dispositif (1, 1', 1") permettant de transporter un substrat (2, 2a-2d) depuis la chambre de déchargement (450) jusqu'à la chambre de chargement (410) à l'extérieur de l'au moins une chambre de traitement (430, 430', 430").
